# FASCICULE DE BREVET EUROPEEN

(11) **EP 4 064 475 B1**
(45) Date de publication et mention de la délivrance du brevet: **02.07.2025**
(21) Numéro de dépôt: 22164291.1
(22) Date de dépôt: 25.03.2022
(51) Int. Cl.: H02B 1/36, H02B 11/10, H02J 13/00, H02B 1/20

(54) **ARMOIRE ÉLECTRIQUE DE RACCORDEMENT**
ANSCHLUSSSCHRANK
ELECTRICAL CONNECTION CABINET

(30) Priorité: 26.03.2021 FR 2103089
(43) Date de publication de la demande: 28.09.2022
(73) Titulaire: Schneider Electric Industries SAS, 92500 Rueil-Malmaison (FR)
(72) Inventeur: LINARES, Louis, 38660 LA TERRASSE (FR); GAILLA, Charles, 38240 MEYLAN (FR); DE VOS, Gilles, 38320 BRIE ET ANGONNES (FR)
(74) Mandataire: Lavoix

(56) Documents cités:
- WO-A1-2012/080587
- WO-A1-2017/174994
- WO-A2-2006/063993
- US-A1- 2002 048 161
- US-B2- 8 810 998

## Description

La présente invention concerne une armoire électrique de raccordement.

Dans le domaine des armoires électriques industrielles, il est connu d'installer dans une armoire électrique de raccordement une ou plusieurs unités de contrôle-commande. Ces unités de contrôle-commande permettent de raccorder électriquement l'armoire électrique à des charges électriques. Il est également connu de connecter une telle armoire électrique de raccordement à un ordinateur industriel, cet ordinateur permettant de configurer cette armoire. Cette connexion est effectuée à l'aide de câbles de communication, qui relient individuellement chaque unité de contrôle-commande à l'ordinateur industriel. Cette connexion individuelle de chaque unité de contrôle-commande à l'ordinateur industriel implique l'utilisation d'un grand nombre de câbles de communication, ce qui rend l'assemblage de l'armoire électrique long et complexe et génère des coûts matériels et de main d'œuvre importants.

Le document WO-A-2006/063993 décrit une armoire électrique comprenant plusieurs unités fonctionnelles, chaque unité fonctionnelle comprenant un appareil de communication. Tous les appareils de communication communiquent avec un module de bus, qui permet l'échange de données entre les unités fonctionnelles et l'extérieur de l'armoire électrique. Cependant, ce module de bus ne permet que de mutualiser l'échange de données entre les unités fonctionnelles et l'extérieur de l'armoire électrique. WO 2017/174994 A1, WO 2012/080587 A1, US 2002/048161 A1 et US 8 810 998 B2 décrivent d'autres armoires électriques avec unités fonctionnelles configurées pour échanger des données.

C'est à ces inconvénients qu'entend plus particulièrement remédier l'invention en proposant une armoire électrique de raccordement permettant de regrouper les échanges de données entre l'ordinateur industriel et les unités de contrôle-commande ainsi qu'une alimentation en tension électrique auxiliaire des unités de contrôle-commande.

À cet effet, l'invention concerne une armoire électrique de raccordement, l'armoire électrique étant alimentée en énergie électrique par des câbles d'alimentation et étant configurée pour alimenter au moins une charge électrique, l'armoire électrique comprenant une colonne d'alimentation et au moins une colonne de raccordement, les câbles d'alimentation étant raccordés à l'armoire électrique dans la colonne d'alimentation, chaque colonne de raccordement comprenant au moins une unité de contrôle-commande configurée pour permettre le raccordement électrique à une charge électrique, chaque unité de contrôle-commande étant électriquement protégée par une unité de protection appartenant à la colonne de raccordement de cette unité de contrôle-commande, chaque unité de contrôle-commande étant configurée pour permettre le raccordement et éventuellement le pilotage et/ou la surveillance d'une charge électrique, l'armoire électrique étant configurée pour être commandée par un ordinateur industriel. Selon l'invention, chaque colonne de raccordement comprend un module de communication qui centralise des informations de fonctionnement provenant des unités de contrôle-commande de cette colonne de raccordement ; est configuré pour transmettre ces informations de fonctionnement à l'ordinateur industriel ; est configuré pour recevoir des commandes provenant de l'ordinateur industriel ; et transmet ces commandes aux unités de contrôle-commande de cette colonne de raccordement. En outre, au moins un module de communication comporte un bloc d'alimentation délivrant au moins une tension électrique auxiliaire à chaque colonne de raccordement.

Grâce à l'invention, l'armoire électrique de raccordement comprend un module de communication qui relie chaque unité de contrôle-commande à l'ordinateur industriel et qui alimente chaque unité de contrôle-commande en tension électrique auxiliaire.

Selon des aspects avantageux, mais non obligatoire de l'invention, l'armoire électrique de raccordement incorpore une ou plusieurs des caractéristiques suivantes, prises isolément ou selon toutes combinaisons techniquement admissibles :
- Chaque colonne de raccordement comprend un bus informatique qui relie le module de communication de cette colonne de raccordement à chaque unité de contrôle-commande de cette colonne de raccordement et qui permet l'échange d'informations et de commandes entre le module de communication et chaque unité de contrôle-commande de cette colonne de raccordement.
- L'échange d'informations et de commandes entre le module de communication d'une colonne de raccordement et chaque unité de contrôle-commande de cette colonne transitent par des circuits électroniques du bus informatique et s'effectue de préférence selon le protocole Ethernet.
- Le bus informatique de chaque colonne de raccordement comporte des pistes d'alimentation électrique configurées pour alimenter chaque unité de contrôle-commande de cette colonne de raccordement et/ou au moins une charge électrique raccordée à cette colonne de raccordement avec au moins une tension électrique auxiliaire.
- Le bloc d'alimentation délivre une première tension électrique auxiliaire à chaque unité de contrôle-commande de chaque colonne de raccordement et est configurée pour délivrer une deuxième tension électrique auxiliaire à au moins une charge électrique raccordée à une unité de contrôle-commande.
- La première tension électrique auxiliaire est une tension continue de 48V et la deuxième tension électrique auxiliaire est une tension alternative de 230V.
- La colonne d'alimentation comprend un commutateur central ; et le commutateur central est raccordé entre l'ordinateur industriel et le module de communication de chaque colonne de raccordement, en ce sens que : le commutateur central est configuré pour recevoir les commandes provenant de l'ordinateur industriel et répartir ces commandes entre les modules de communication de chaque colonne de raccordement ; et le commutateur central est configuré pour agréger les informations de fonctionnement provenant des modules de communication de chaque colonne de raccordement et transmettre ces informations à l'ordinateur industriel.
- L'armoire comprend au moins deux colonnes de raccordement, le module de communication de chaque colonne de raccordement comprend un switch managé, les switch managés des modules de communication sont reliés entre eux par des câbles de communication interne, et chaque switch managé est configuré pour être relié à l'ordinateur industriel indépendamment des autres switch managés.
- L'ensemble des raccordements de câbles aux connecteurs de l'armoire électrique nécessaires pour la mise en service de l'armoire électrique sont réalisés dans une unique zone de raccordement.

L'invention sera mieux comprise et d'autres avantages de celle-ci apparaitront plus clairement à la lumière de la description qui va suivre d'un mode de réalisation d'une armoire électrique de raccordement conforme à son principe, donnée uniquement à titre d'exemple et faite en référence aux dessins annexés dans lesquels :
[Fig. 1] La figure 1 est une vue en perspective d'une armoire électrique conforme à l'invention ;
[Fig. 2] La figure 2 est une coupe longitudinale de l'armoire électrique de la figure 1 selon le plan II ;
[Fig. 3] La figure 3 est une coupe horizontale d'une partie de l'armoire électrique de la figure 1 selon le plan III;
[Fig. 4] La figure 4 est une coupe horizontale, analogue à la figure 3, d'une deuxième armoire électrique conforme à l'invention ;
[Fig. 5] La figure 5 est une coupe horizontale, analogue à la figure 3, d'une troisième armoire électrique conforme à l'invention ;
[Fig. 6] La figure 6 est une vue en perspective d'un module de communication appartenant à une armoire selon l'une des figures 1 à 5 ;
[Fig. 7] La figure 7 est une vue de dessus du module de communication de la figure 6 ;
[Fig. 8] La figure 8 est une vue en perspective d'un module de démarrage moteur appartenant à une armoire selon l'une des figures 1 à 5 ;
[Fig. 9] La figure 9 est une vue en perspective d'un autre module de démarrage moteur, vu sous un autre angle ;
[Fig. 10] La figure 10 est une vue en perspective d'une structure de support du module de démarrage moteur des figure 8 et 9 ;
[Fig. 11] La figure 11 est une vue en perspective d'une unité de protection du module de démarrage moteur des figure 8 et 9 ;
[Fig. 12] La figure 12 est une vue en perspective de l'unité de protection de la figure 11, vue sous un autre angle ;
[Fig. 13] La figure 13 est une vue en perspective d'une unité de contrôle-commande appartenant à une armoire selon l'une des figures 1 à 5 ;
[Fig. 14] La figure 14 est une vue en perspective de l'unité de contrôle-commande de la figure 13, vue sous un autre angle ;
[Fig. 15] La figure 15 est une vue en perspective d'une deuxième unité de contrôle-commande appartenant à une armoire selon l'une des figures 1 à 5 ;
[Fig. 16] La figure 16 est une vue en perspective de la deuxième unité de contrôle-commande de la figure 15, vue sous un autre angle ;
[Fig. 17] La figure 17 est une vue de dessus de la deuxième unité de contrôle-commande de la figure 15, en coupe selon le plan XVII à la figure 15 ;
[Fig. 18] La figure 18 est une vue en perspective d'un contact latéral mobile appartenant à une armoire selon l'une des figures 1 à 5 ;
[Fig. 19] La figure 19 est une vue en perspective du contact latéral mobile de la figure 18 vu selon un autre angle ;
[Fig. 20] La figure 20 est une vue en perspective éclatée du contact latéral mobile des figures 18 et 19 ;
[Fig. 21] La figure 21 est une vue de dessus du contact latéral mobile des figures 18 et 19 dans une première position ;
[Fig. 22] La figure 22 est une vue de dessus du contact latéral mobile des figures 18 et 19 dans une deuxième position ;
[Fig. 23] La figure 23 est une vue de dessus du contact latéral mobile des figures 18 et 19 dans une troisième position ;
[Fig. 24] La figure 24 est une vue en perspective d'un module entrées-sorties appartenant à une armoire selon l'une des figures 1 à 5 ;
[Fig. 25] La figure 25 est une vue en perspective d'un tronçon de bus informatique appartenant à une armoire selon l'une des figures 1 à 5 ;
[Fig. 26] La figure 26 est une vue selon le détail XXV de la figure 25 ;
[Fig. 27] La figure 27 est une vue en perspective d'un raccord de bus informatique ;
[Fig. 28] La figure 28 est une vue en perspective d'un premier module de raccordement externe appartenant à une armoire selon l'une des figures 1 à 5 ;
[Fig. 29] La figure 29 est une vue en perspective éclatée du premier module de raccordement externe de la figure 28 ;
[Fig. 30] La figure 30 est une vue en perspective d'un deuxième module de raccordement externe appartenant à une armoire selon l'une des figures 1 à 5 ;
[Fig. 31] La figure 31 est une vue en perspective éclatée du deuxième module de raccordement externe de la figure 30 ;
[Fig. 32] La figure 32 est une vue en perspective d'un troisième module de raccordement externe appartenant à une armoire selon l'une des figures 1 à 5 ;
[Fig. 33] La figure 33 est une vue en perspective éclatée du troisième module de raccordement externe de la figure 32 ;
[Fig. 34] La figure 34 est une vue en perspective du tronçon de bus informatique des figures 25 et 26 équipé de trois cavaliers ;
[Fig. 35] La figure 35 est une vue en perspective des cavaliers de la figure 34 ;
[Fig. 36] La figure 36 est une vue de détail du système de verrouillage du tiroir de contrôle-commande des figures 15 à 17, dans une première position ;
[Fig. 37] La figure 37 est une vue de détail du système de verrouillage du tiroir de contrôle-commande des figures 15 à 17, dans une deuxième position ;
[Fig. 38] La figure 38 est une vue en perspective du système de verrouillage de la figure 36, sur laquelle une partie du tiroir est masquée et un rail appartenant à une armoire selon l'une des figures 1 à 5 est également représenté;
[Fig. 39] La figure 39 est une vue en perspective du système de verrouillage de la figure 37, sur laquelle une partie du tiroir est masquée et un rail appartenant à une armoire selon l'une des figures 1 à 5 est également représenté ;
[Fig. 40] La figure 40 est une vue en perspective du système de verrouillage de la figure 37, sur laquelle une partie du tiroir est masquée ;
[Fig. 41] La figure 41 est une vue en perspective d'un troisième tiroir de contrôle-commande appartenant à une armoire selon l'une des figures 1 à 5, ce troisième tiroir étant conforme à l'invention ;
[Fig. 42] La figure 42 est une vue en perspective du tiroir de contrôle-commande de la figure 41, vu sous un autre angle ; et
[Fig. 43] La figure 43 est une vue en perspective d'un module de détection de position appartenant au tiroir de contrôle-commande des figures 41 et 42.

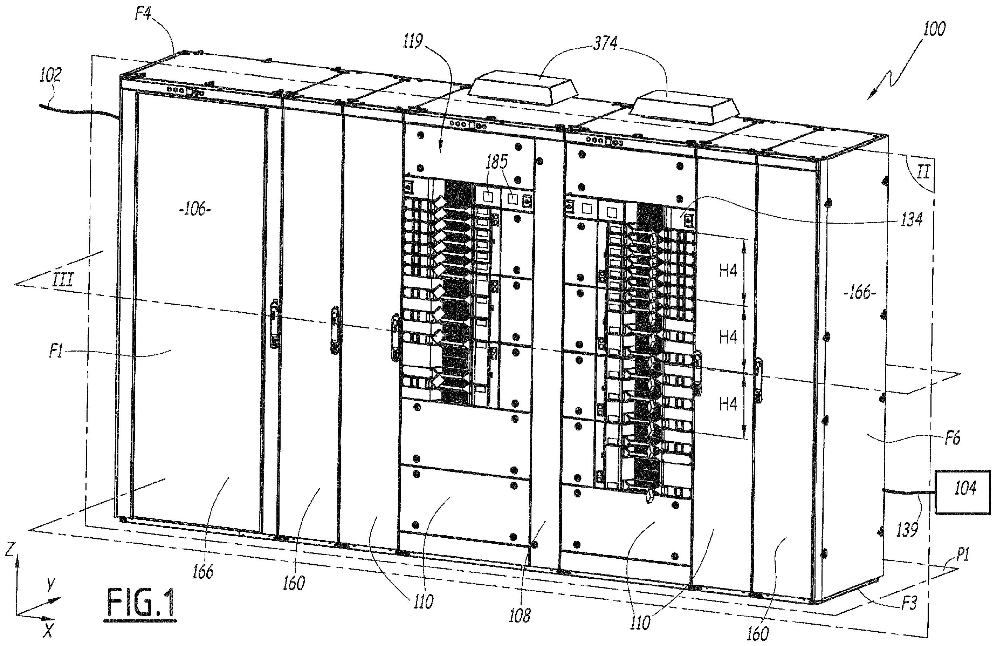

Une armoire électrique 100 est représentée aux figures 1 à 5. Cette armoire électrique est destinée à être intégrée à un réseau électrique partiellement représenté. Ce réseau électrique comprend d'une part, en amont de l'armoire électrique 100, des câbles d'alimentation 102 provenant par exemple d'un poste de transformation et d'autre part, en aval de l'armoire électrique, une ou des charges électriques 104.

L'armoire électrique 100 est une armoire de raccordement configurée pour raccorder les charges électriques 104 aux câbles d'alimentation 102.

En configuration installée de l'armoire électrique 100, l'armoire repose sur une surface horizontale représentée par un plan P1. En pratique, le plan P1 est par exemple le sol d'un bâtiment dans lequel l'armoire électrique 100 est installée.

On définit un axe longitudinal X de l'armoire électrique 100 comme étant l'axe de la plus grande dimension de l'armoire électrique 100, en pratique sa longueur, un axe transversal Y comme étant l'axe de la plus petite dimension de l'armoire électrique 100 et perpendiculaire à l'axe X, en pratique sa largeur, et un axe vertical Z comme étant le troisième axe d'un repère orthogonal comprenant les axes X et Y.

L'orientation des axes X, Y et Z est liée fixement à l'orientation de l'armoire électrique 100. L'orientation de l'armoire électrique 100 décrite dans le présent exposé correspond à sa configuration installée. Il est donc entendu que l'orientation des axes X, Y et Z varie lorsque l'orientation de l'armoire électrique 100 varie. Par exemple, l'axe Z peut ne pas être vertical lorsque l'armoire 100 n'est pas en configuration installée, par exemple lorsqu'elle est transportée. Les qualificatifs « haut », « bas » et « vertical » utilisés dans la suite de l'exposé s'entendent relativement à l'axe Z.

Dans la configuration installée ici décrite, le plan formé par les axes X et Y est horizontal et parallèle au plan P1, alors que l'axe Z est perpendiculaire à ce plan. Le qualificatif « horizontal » utilisé dans la suite de l'exposé s'applique à tout élément contenu dans un plan parallèle au plan formé par les axes X et Y, en configuration installée de l'armoire électrique 100. Les qualificatifs « gauche » et « droite » s'entendent relativement à l'axe X et les qualificatifs « avant » et « arrière » s'entendent relativement à l'axe Y.

Le positionnement relatif des pièces et leur orientation décrits ci-après sont donnés à titre d'exemple uniquement et ne sont pas limitatifs. Sauf en cas de mention contraire explicite, ils s'entendent en configuration montée et installée de l'armoire électrique 100. Ainsi, lorsqu'il est fait mention de l'orientation d'une pièce vis-à-vis des axes X, Y et/ou Z, elle s'entend en configuration montée de l'armoire. Lorsque l'armoire 100 est stockée, transportée, non-assemblée ou en cours d'assemblage, entre-autres exemples, l'orientation des pièces et leur positionnement relatif peuvent varier.

On note « F1 » la face avant de l'armoire 100, « F2 » sa face arrière, « F3 » sa face inférieure, « F4 » sa face supérieure, « F5 » sa face de gauche et « F6 » sa face de droite. Ces faces F1 à F6 sont globalement planes. En pratique, la face F3 de l'armoire est donc disposée sur le plan P1.

Le câble d'alimentation 102 délivre à l'armoire électrique 100 une alimentation électrique principale, de préférence d'une tension de 400V triphasée avec neutre, de préférence à une fréquence 50Hz. En variante, le câble d'alimentation 102 délivre un courant triphasé sans neutre, ou un courant monophasé.

Les charges électriques 104 peuvent par exemple être des moteurs électriques, tels que des moteurs triphasés, des réseaux de distribution d'électricité, ou encore des charges électriques pilotables, tels que des batteries ou des panneaux photovoltaïques.

Comme visible à la figure 1, l'armoire électrique 100 comprend une colonne d'alimentation 106, au moins une colonne de distribution électrique 108 et au moins une colonne de raccordement 110.

Les colonnes d'alimentation 106, de distribution 108 et de raccordement 110 sont juxtaposées selon l'axe X.

Dans l'exemple représenté, l'armoire électrique 100 comprend une colonne de distribution électrique 108 et deux colonnes de raccordement 110, disposées de part et d'autre de la colonne de distribution électrique 108. En pratique, une colonne de raccordement 110 est toujours juxtaposée à une colonne de distribution électrique 108. Une colonne de distribution électrique 108 est toujours juxtaposée à une ou à deux colonnes de raccordement 110.

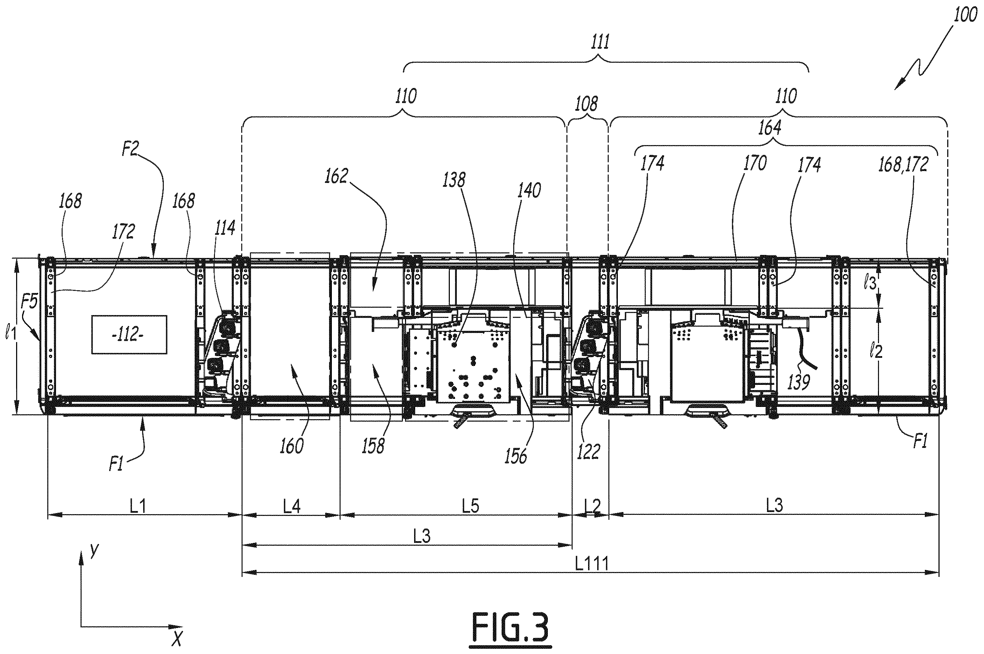

Comme visible à la figure 3, l'association d'une colonne de distribution électrique 108 et d'une ou de deux colonnes de raccordement 110 forme une colonne fonctionnelle 111. Lorsqu'une colonne fonctionnelle 111 comprend deux colonnes de raccordement 110, ces deux colonnes sont situées respectivement de part et d'autre, à savoir à gauche et à droite sur les figures 1 à 5, de la colonne de distribution électrique 108. Lorsqu'une colonne fonctionnelle 111 comprend une seule colonne de raccordement 110, cette colonne est située indifféremment, d'un côté ou de l'autre, à savoir à gauche ou à droite sur les figures 1 à 5, de la colonne de distribution électrique 108.

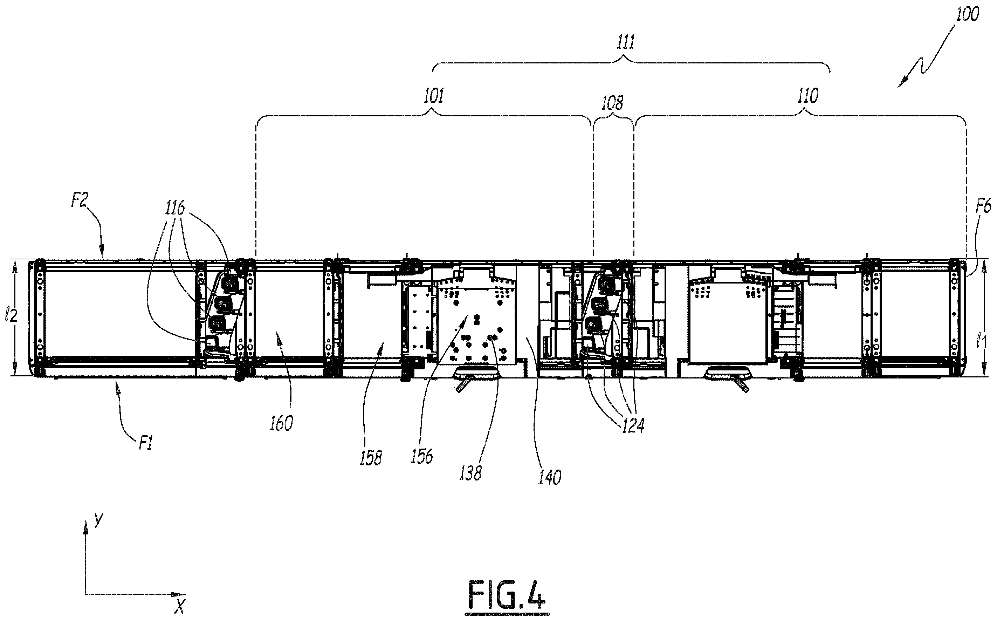

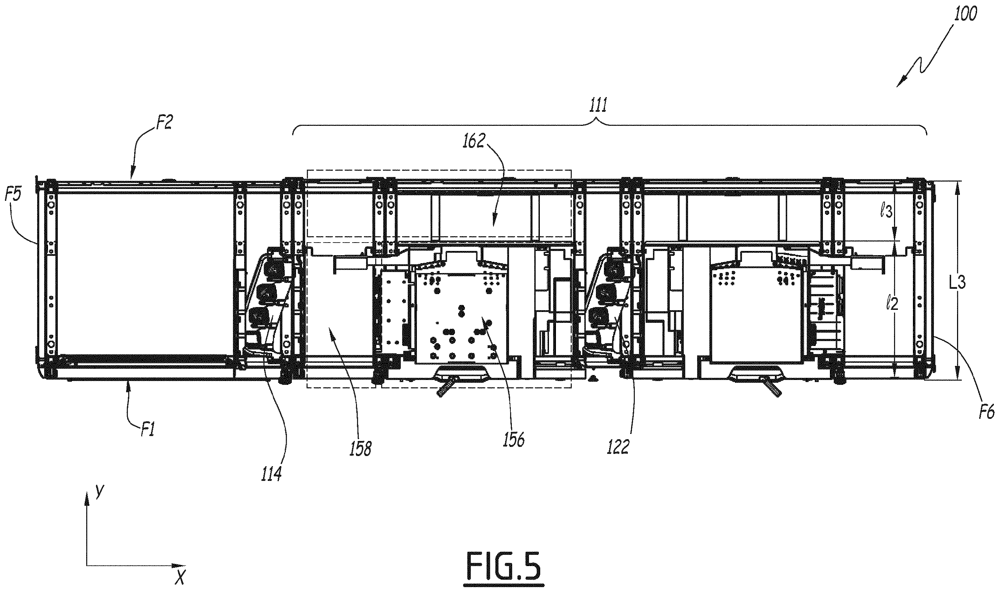

Deux autres modes de réalisation d'une colonne fonctionnelle 111 sont visibles aux figures 4 et 5 et sont décrits ci-après.

Dans l'exemple représenté aux figures 1 à 3, l'armoire électrique 100 comprend une colonne fonctionnelle 111.

En variante non-représentée de l'invention, l'armoire électrique 100 comprend plusieurs colonnes fonctionnelles 111, juxtaposées selon l'axe X.

Dans l'exemple représenté, une colonne fonctionnelle 111 a une hauteur H1, mesurée selon l'axe Z, de 2000 mm. En variante, cette hauteur est différente, par exemple 1500 mm ou 2500 mm.

La hauteur H1 correspond également à la hauteur de l'armoire électrique 100.

La colonne d'alimentation 106 permet d'alimenter l'ensemble de l'armoire électrique 100 en énergie électrique à partir du câble d'alimentation 102. De préférence, la colonne d'alimentation est disposée à une extrémité longitudinale de l'armoire 100, comme dans l'exemple représenté, où la colonne d'alimentation est à gauche de l'armoire 100.

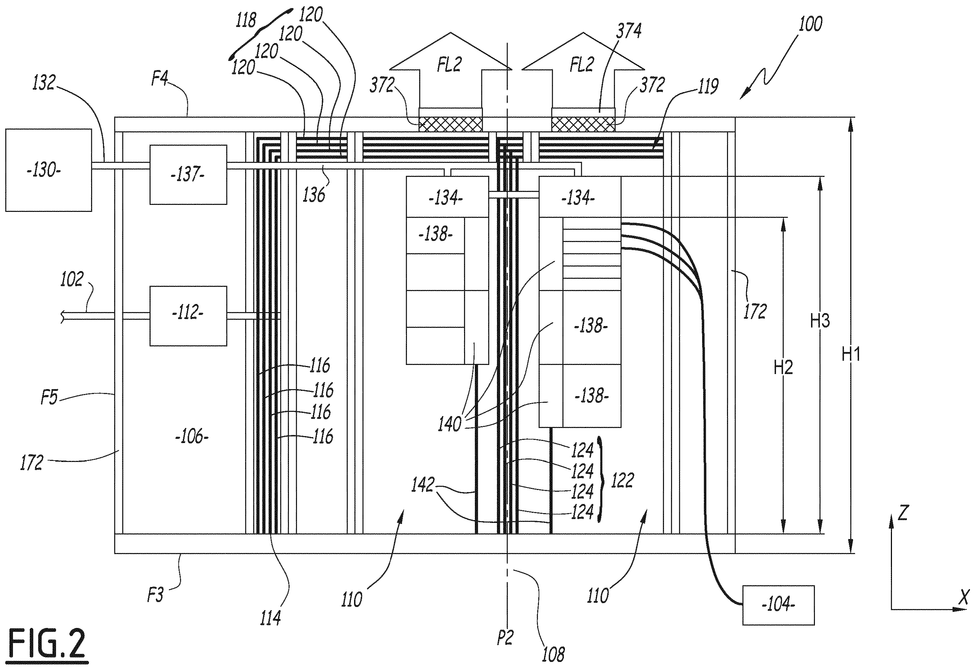

Comme visible à la figure 2, dans la colonne d'alimentation 106, chaque phase et le neutre du câble d'alimentation 102 sont raccordés à une entrée d'un disjoncteur 112.

Comme visible aux figures 2 et 3, la colonne d'alimentation 106 comprend également un jeu de barres d'alimentation 114 comprenant plusieurs barres d'alimentation 116. Chaque sortie du disjoncteur 112 est reliée à une barre d'alimentation 116. Ainsi, dans l'exemple d'une armoire électrique 100 alimentée en courant triphasé avec neutre, le jeu de barres 114 de la colonne 106 comprend quatre barres d'alimentation 116, correspondant aux trois phases et au neutre du courant d'alimentation.

Le jeu de barres d'alimentation 114 est raccordé à un jeu de barres horizontal 118. Le jeu de barres horizontal 118 comprend plusieurs barres horizontales 120, en pratique autant de barres horizontales 120 que de barres 116. Ainsi, chaque barre 116 du jeu de barres d'alimentation 114 est raccordée à une barre 120 du jeu de barres horizontal 118.

Le jeu de barres horizontal 118 s'étend selon l'axe longitudinal X de l'armoire électrique 100 et permet d'alimenter chaque colonne de distribution électrique 108 de l'armoire. Une gaine horizontale 119 est ménagée sur toute la longueur de l'armoire électrique 100 et accueille le jeu de barres horizontal 118.

Dans l'exemple des figures 1 à 3, la gaine horizontale 119 est positionnée à l'extrémité haute de l'armoire électrique 100. En variante non-représentée de l'invention, la gaine horizontale 119 est positionnée à l'extrémité basse de l'armoire électrique 100.

Chaque colonne de distribution électrique 108 comprend un jeu de barres vertical 122 qui permet d'alimenter la ou chaque colonne de raccordement 110 adjacente à chaque colonne de distribution électrique 108. Dans l'exemple représenté, l'armoire 100 comprend donc un jeu de barres vertical qui permet d'alimenter les deux colonnes de raccordement 110.

Chaque jeu de barres vertical 122 comprend plusieurs barres verticales 124, en pratique autant de barres verticales 124 que de barres horizontales 120. Chaque barre verticale 124 est raccordée à une barre horizontale 120. Le raccordement du jeu de barres vertical 122 sur le jeu de barres horizontal 118 s'effectue dans la gaine horizontale 119.

Les barres d'alimentation 116, les barres horizontales 120 et les barres verticales 124 sont fabriquées dans un matériau conducteur d'électricité, par exemple en cuivre, et sont de préférence des barres plates. De préférence, elles ont une section comprise entre 250 et 3000 mm².

L'assemblage d'une barre d'alimentation 116, d'une barre horizontale 120 et d'une barre verticale 124 par colonne de distribution électrique 108 forme une ligne d'alimentation électrique.

Dans l'exemple représenté, l'armoire 100 comprend quatre lignes d'alimentation électrique, correspondant aux trois phases et au neutre du courant d'alimentation provenant du câble 102. D'autres variantes sont envisageables, par exemple une armoire électrique 100 alimentée en courant monophasé ou en courant triphasé sans neutre, comprenant respectivement deux barres et trois barres par jeu de barres.

Le disjoncteur 112 est connecté entre le câble d'alimentation 102 et les lignes d'alimentation électrique et permet donc de couper l'alimentation de chaque ligne d'alimentation électrique. Le disjoncteur 112 est donc un organe de protection de l'armoire électrique 100.

Chaque colonne de raccordement 110 permet le raccordement électrique d'une ou de plusieurs charges électriques 104 à l'armoire électrique 100 et permet de contrôler les charges électriques 104 qui y sont raccordées.

Chaque colonne de raccordement 110 comprend une partie de la gaine horizontale 119. Cette partie de la gaine horizontale 119 s'étend sur toute la longueur de la colonne de raccordement 110, selon l'axe X, et accueille une partie du jeu de barres horizontal 118.

L'armoire électrique 100 est contrôlée par un ordinateur industriel 130, représenté uniquement à la figure 2 pour la clarté du dessin, qui est relié à l'armoire électrique par des câbles de communication 132. Cet ordinateur industriel permet de commander les colonnes de raccordement 110.

En pratique, l'ordinateur industriel 130 comprend une unité de calcul non-représentée qui exécute un logiciel de gestion de l'armoire électrique 100.

En variante, l'ordinateur industriel 130 est remplacé par un système de contrôle et d'acquisition de données en temps réel, dit « SCADA », qui supervise le fonctionnement de l'armoire électrique 100, ou l'ordinateur est intégré dans un tel système.

Chaque colonne de raccordement 110 comprend un module de communication 134. Comme visible à la figure 2, le module de communication 134 est positionné à proximité de l'extrémité haute de la colonne de raccordement 110, et proche de la gaine horizontale 119.

En variante non-représentée de l'invention, le module de communication 134 est positionné à l'extrémité basse de la colonne.

En variante non-représentée de l'invention, lorsque la gaine horizontale 119 est positionné à l'extrémité basse de l'armoire électrique 100, le module de communication 134 peut être positionné soit à l'extrémité haute de la colonne de raccordement 110, soit à proximité de l'extrémité basse de la colonne, au-dessus de la gaine horizontale.

Le module de communication 134 permet de centraliser l'ensemble des informations provenant de la colonne de raccordement 110 et de commander la colonne de raccordement. Le contenu et le rôle de ces informations sont détaillés ci-après.

Le module de communication 134 communique avec l'ordinateur industriel 130 par l'intermédiaire des câbles de communication 132, d'une part pour transmettre des informations sur le fonctionnement de la colonne de raccordement 110 et d'autre part pour recevoir les commandes provenant de l'ordinateur industriel et devant être transmises à la colonne de raccordement.

Le module de communication 134 d'une colonne de raccordement 110 fait donc l'intermédiaire entre l'ordinateur industriel 130 et cette colonne de raccordement 110 et permet de centraliser les échanges entre l'ordinateur et la colonne.

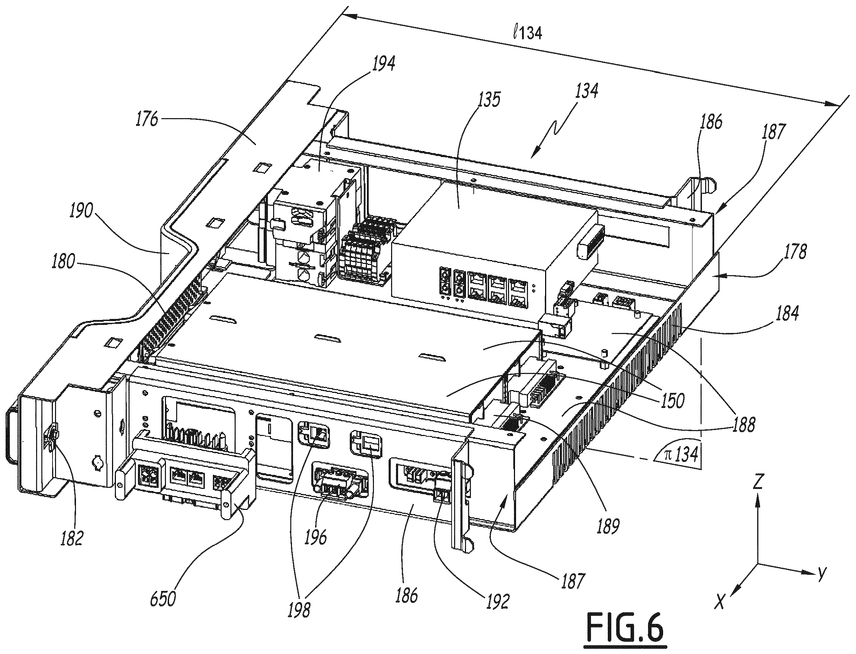

Comme visible à la figure 6, chaque module de communication 134 comporte en pratique un commutateur réseau contrôlé 135, dit « switch managé ».

Lorsque l'armoire électrique 100 comprend plusieurs colonnes de raccordement 110, comme dans l'exemple représenté aux figures 1 à 3, les modules de communication 134 de chaque colonne de raccordement sont reliés entre eux en série par des câbles de communication interne 136. En pratique, ce sont les switchs managés 135 des modules de communication qui sont reliés entre eux par les câbles de communication interne 136.

De plus, dans une telle configuration, les switchs managés des modules de communication 134 sont tous reliés à un commutateur central 137 par les câbles de communication interne 136, le commutateur central 137 étant disposé de préférence dans la colonne d'alimentation 106. Ce commutateur central 137 fait l'intermédiaire entre les modules de communication 134 et l'ordinateur industriel 130, c'est-à-dire que les informations provenant de l'ordinateur industriel 130, par exemple des commandes, sont réparties entre les modules de communication par le commutateur central 137 et que les informations provenant des modules de communication 134 sont agrégées par le commutateur central avant d'être transmises à l'ordinateur industriel.

Ainsi, chaque switch managé 135 est relié à l'ordinateur industriel 130, indépendamment des autres switch managés 135.

Une telle configuration présente l'avantage de fiabiliser le fonctionnement de l'armoire électrique 100. En effet, en cas de défaillance d'un module de communication 134, seul le fonctionnement de la colonne de raccordement 110 comprenant ce module sera affecté car, les autres modules non-défaillants étant interconnectés et connectés au commutateur central 137, leur connexion à l'ordinateur industriel 130 ne sera pas interrompue par le module défaillant.

En variante, lorsque l'armoire électrique 100 comprend plusieurs colonnes de raccordement 110, le switch managé 135 de chaque module de communication 134 est directement relié à l'ordinateur industriel, sans passer par un commutateur du type du commutateur 137.

De manière optionnelle, lorsque l'armoire électrique 100 comprend une seule colonne de raccordement 110, un commutateur central 137 est disposé entre le module de communication et l'ordinateur industriel.

Dans l'exemple représenté, les câbles de communication interne 136 sont des câbles utilisant le protocole Ethernet. En variante, les câbles de communication interne 136 utilisent un autre protocole de réseau local, comme par exemple le protocole MODBUS ou PROFINET.

Pour permettre le raccordement des charges électriques 104, chaque colonne de raccordement 110 comprend une ou plusieurs unités de contrôle-commande 138.

Les charges électriques 104 étant distantes de l'armoire 100, leur raccordement aux unités de contrôle-commande 138 s'effectue par l'intermédiaire de câbles de raccordement 139.

Dans l'exemple représenté, les unités de contrôle-commande 138 sont des tiroirs de contrôle-commande qui peuvent donc être installés dans, et retirés de, la colonne de raccordement 110 de façon simple et rapide. En variante non-représentée de l'invention, les unités de contrôle-commande 138 sont des unités fixes de l'armoire, qui sont assemblées lors de l'installation de l'armoire, par exemple par vissage dans la ou les colonnes 110.

En pratique, une unité de contrôle-commande 138 permet le raccordement électrique d'une charge électrique 104.

Dans l'exemple représenté, une colonne de raccordement 110 comporte jusqu'à trente unités de contrôle-commande 138 et permet donc le raccordement au maximum de trente charges électriques 104. Une colonne de raccordement 110 est modulable, c'est-à-dire qu'il est possible d'y installer autant d'unités de contrôle-commande que souhaité, entre une unité et trente unités. Les unités de contrôle-commande 138 sont juxtaposées verticalement dans la colonne de raccordement 110.

En variante, une colonne de raccordement 110 peut comporter plus de trente unités de contrôle-commande 138, par exemple si la hauteur d'une unité de contrôle-commande est diminuée ou si la hauteur de la colonne de raccordement 110 est augmentée.

Les unités de contrôle-commande 138 permettent également le contrôle des charges électriques 104 qui y sont raccordées. Ce contrôle, également appelé pilotage, consiste, par exemple, lorsque la charge électrique est un moteur, à piloter ce moteur, c'est-à-dire à le démarrer, l'arrêter et éventuellement à contrôler sa vitesse, ou encore, lorsque la charge électrique est un réseau de distribution, à délivrer la tension et l'intensité nécessaire au bon fonctionnement de ce réseau de distribution.

En outre, les unités de contrôle-commande 138 permettent également la surveillance des charges électriques 104 qui y sont raccordées. Cette surveillance consiste par exemple à mesurer la tension et l'intensité délivrée à la charge 104, ou encore à récupérer des informations provenant de capteurs tels que par exemple des capteurs de position ou de vitesse de rotation ou des capteurs de température lorsque la charge 104 est un moteur.

Ainsi, chaque unité de contrôle-commande 138 peut avoir un rôle de raccordement d'une charge électrique 104, de contrôle de cette charge et de surveillance de cette charge. Toutefois, selon le type de charge électrique 104 raccordée à une unité de contrôle-commande 138, cette unité de contrôle-commande peut ne pas avoir de rôle de pilotage de cette charge, ou peut ne pas avoir de rôle de contrôle de la charge.

Comme visible sur les figures 2 et 3, chaque colonne de raccordement 110 comprend une ou plusieurs unités de protection 140. Chaque unité de protection 140 est configurée pour protéger électriquement une ou plusieurs unités de contrôle-commande 138 ainsi que les charges électriques 104 qui sont raccordées à ces unités de contrôle-commande, notamment en cas de défaillance d'une charge électrique 104, comme par exemple un court-circuit.

Les unités de protection 140 sont, par exemple, des disjoncteurs disposés en amont des unités de contrôle-commande 138 et qui permettent d'interrompre le courant électrique alimentant les charges 104 par l'intermédiaire des unités de contrôle-commande 138 en cas d'incident, par exemple en cas de court-circuit. En d'autres termes, les unités de protection 140 contrôlent l'alimentation en électricité des unités de contrôle-commande 138.

Ainsi, les unités de protection 140 d'une colonne fonctionnelle 111 sont disposées entre les unités de contrôle-commande 138 et le jeu de barres vertical 122 de la colonne de distribution électrique 108 de cette colonne fonctionnelle 111 et permettent d'alimenter ces unités de contrôle-commande 138, à partir dudit jeu de barres vertical 122. Le raccordement électrique des unités de protection 140 au jeu de barres vertical 122 s'effectue, de manière connue, par exemple par des jeux de barres rigides horizontaux, des jeux de barres flexibles ou par des câbles électriques, non-représentés.

En d'autres termes, le jeu de barres vertical 122 est une source d'électricité pour chaque unité de protection 140.

Dans le cas où une unité de protection 140 est un disjoncteur, son raccordement électrique et son fonctionnement sont identiques à ceux du disjoncteur 112.

Chaque unité de protection 140 protège une ou plusieurs unités de contrôle-commande 138.

Comme visible à la figure 2, chaque colonne de raccordement 110 comprend un bus informatique 142, qui relie le module de communication 134 d'une colonne de raccordement à l'ensemble des unités de contrôle-commande 138 de cette colonne. Chaque unité de contrôle-commande 138 est donc connectée à un module de communication 134.

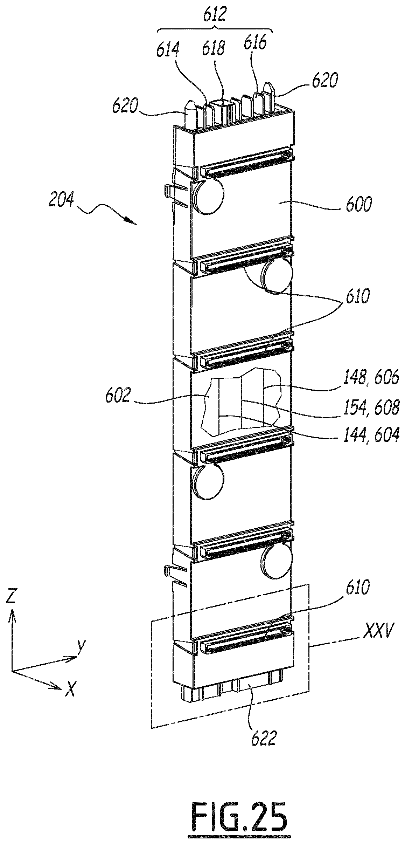

Dans l'exemple représenté, le bus informatique 142 est un boîtier comprenant une carte électronique, c'est-à-dire un circuit imprimé, de forme allongée, disposé verticalement dans la colonne de raccordement 110. Cette carte électronique comporte des circuits électroniques 144, ou pistes, visibles à la figure 25, permettant la communication, c'est-à-dire l'échange de données, dans la colonne par exemple selon le protocole Ethernet, depuis chaque unité de contrôle-commande 138 vers le switch managé 135 du module de communication 134 ainsi que depuis le switch managé du module de communication vers chaque unité de contrôle-commande. En d'autres termes, ces données transitent par les circuits électroniques 144 du bus informatique 142.

Grâce au bus informatique 142, le switch managé 135 de chaque colonne de raccordement 110 contrôle chaque unité de contrôle-commande 138 de cette colonne de raccordement et agrège les données provenant des unités de contrôle-commande.

Les unités de contrôle-commande 138 sont connectées au bus informatique 142.

Chaque bus informatique 142 comporte également des pistes d'alimentation électrique 148, visibles à la figure 25, configurées pour conduire une première tension électrique auxiliaire, ce qui permet d'alimenter les unités de contrôle-commande 138 avec la première tension électrique auxiliaire, cette première tension auxiliaire étant nécessaire pour le fonctionnement de certains composants des unités de contrôle-commande 138, détaillés ci-après. Cette première tension auxiliaire provient du module de communication 134 de chaque colonne de raccordement 110. Cette première tension auxiliaire est par exemple une tension électrique continue de 48V.

En variante, la première tension auxiliaire est une tension de valeur différente, comme par exemple 12V, 24V, 110V en courant continu ou 110V en courant alternatif.

Pour délivrer cette première tension auxiliaire, le module de communication 134 comprend au moins un bloc d'alimentation 150.

Lorsque l'armoire électrique 100 comprend plusieurs colonnes de raccordement 110, chaque module de communication 134 comprend au moins un bloc d'alimentation 150.

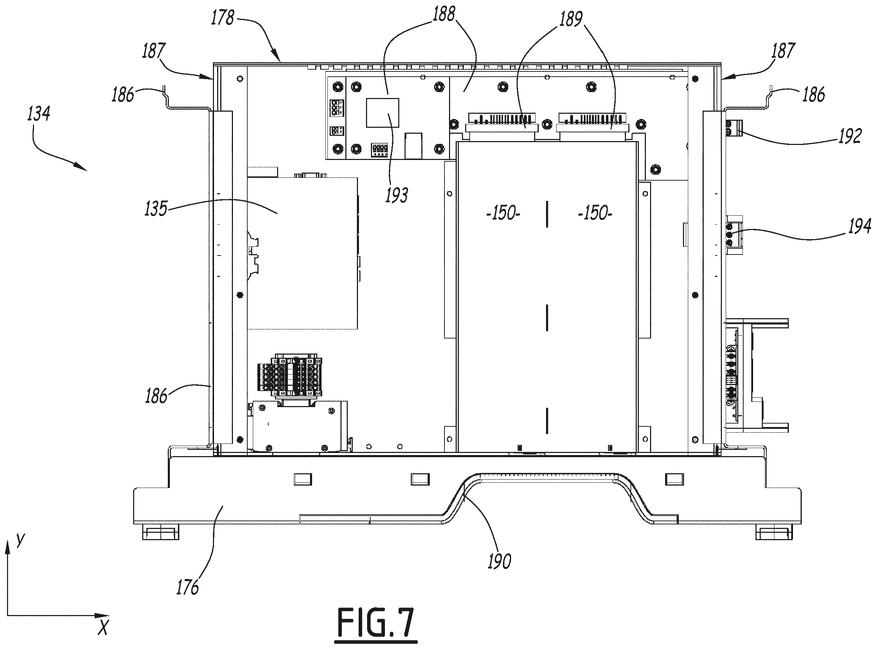

De manière optionnelle, chaque module de communication 134 comprend deux blocs d'alimentation 150 qui sont redondants, comme dans l'exemple représenté aux figures 6 et 7. Une telle configuration est avantageuse car en cas de défaillance d'un bloc d'alimentation 150, le fonctionnement du module de communication 134 contenant ce bloc et le fonctionnement de la colonne de raccordement 110 contenant ce module ne sont pas interrompus.

Chaque bus informatique 142 comporte également des pistes d'alimentation électrique 154, visibles à la figure 25, configurées pour conduire une deuxième tension électrique auxiliaire, qui est de préférence une tension alternative de 230V. Cette deuxième tension électrique auxiliaire alimente des charges électriques 104. Cette deuxième tension électrique auxiliaire provient du module de communication 134 de chaque colonne de raccordement 110.

Dans un exemple de réalisation, le bus informatique 142 est un circuit imprimé à six couches, les pistes d'alimentation électrique 148 et 154 ainsi que les circuits électroniques 144 étant répartis entre ces six couches. En variante, le bus informatique 142 comprend un nombre de couches différents.

En variante, les pistes d'alimentation électrique 148 et 154 du bus informatique 142 sont remplacées par des câbles électriques attachés au bus informatique.

Grâce au bus informatique 142, il est possible de centraliser sur un seul support physique les premier et deuxième circuits électriques auxiliaires ainsi que les circuits de communication reliant un module de communication 134 d'une colonne de raccordement 110 avec les unités de contrôle-commande 138 de cette colonne.

La figure 3 illustre l'agencement intérieur d'une colonne fonctionnelle 111 de l'armoire électrique 100 des figures 1 et 2. En particulier, la figure 3 illustre les différentes zones que comprend chaque colonne de raccordement 110, à savoir :
- une zone fonctionnelle 156, qui comprend les unités de contrôle-commande 138 et les unités de protection 140 et qui est adjacente à la colonne de distribution électrique 108 de sorte que les unités de protections 140 sont disposées entre la colonne de distribution électrique et les unités de contrôle-commande ;
- une zone de raccordement 158, dans laquelle s'effectue le raccordement des charges électriques 104 aux unités de contrôle-commande 138 et qui est adjacente à la zone fonctionnelle 156 ;
- une zone de câblage 160, dans laquelle l'ensemble des câbles de raccordement 139 sont disposés et qui est adjacente à la zone de raccordement 158 ; et
- une zone de gestion thermique 162, dont le rôle est précisé ci-après.

En pratique, la zone fonctionnelle 156 et la zone de raccordement 158 sont situées à l'avant de la colonne de raccordement 110, c'est-à-dire au voisinage de la face F1 de l'armoire, et la zone de câblage 160 occupe toute la largeur de la colonne de raccordement, qui correspond à la largeur de l'armoire 100, c'est-à-dire de sa face avant F1 à sa face arrière F2.

En pratique, la zone de gestion thermique 162 est située à l'arrière de la colonne de raccordement 110, au voisinage de la face arrière F2, et s'étend, en longueur, c'est-à-dire selon l'axe X, depuis la colonne de distribution électrique 108 jusqu'à la zone de câblage 160.

En variante, la colonne fonctionnelle 111 ne comprend pas de zone de câblage 160 et l'ensemble des câbles de raccordement 139 sont disposés dans la zone de raccordement 158.

On comprend que l'agencement intérieur de la colonne de raccordement de gauche 110 et l'agencement intérieur de la colonne de raccordement de droite 110 sont symétriques par rapport à un plan de symétrie P2 parallèle au plan vertical formé par les axes Y et Z et passant au centre de la colonne de distribution électrique 108.

La zone fonctionnelle 156 s'étend sur une hauteur H2 inférieure à la hauteur H1, ce qui permet d'installer le module de communication 134 au-dessus de la zone fonctionnelle 156, comme dans l'exemple représenté aux figures 1 à 3, ou en-dessous de cette zone.

Lorsqu'une colonne de raccordement 110 comporte le nombre maximum d'unités de contrôle-commande 138, par exemple trente unités dans l'exemple représenté, alors ces unités de contrôle-commande occupent l'essentiel de la zone fonctionnelle 156.

Lorsqu'une colonne de raccordement 110 ne comporte pas le nombre maximum d'unités de contrôle-commande 138, la zone fonctionnelle 156 n'est pas entièrement occupée par des unités de contrôle-commande et comprend un espace libre. Dans une telle configuration, le module de communication 134 peut également être installé dans l'espace libre de la zone fonctionnelle 156.

Dans l'exemple représenté, la hauteur H2 est de 1500 mm ; elle pourrait être différente en variante.

La zone de raccordement 158 s'étend sur ure hauteur H3 inférieure à la hauteur H1 et supérieure à la hauteur H2. En pratique, la hauteur H3 est égale à la somme de la hauteur H2 et de la hauteur du module de communication 134. En outre, la hauteur du bus informatique 142 est égale à la hauteur H3.

Dans l'exemple représenté, la hauteur H3 est de 1600 mm.

Les zones de câblage 160 et de gestion thermique 162 s'étendent sur toute la hauteur H1 de la colonne fonctionnelle 111. En pratique, la gaine horizontale 119 passe donc dans la zone de câblage 160.

En outre, la gaine horizontale 119 passe de préférence au-dessus ou en-dessous des zones fonctionnelle 156 et de raccordement 158, de manière à ne pas passer dans la zone de gestion thermique 162.

Dans cette configuration, le raccordement des câbles de raccordement 139 aux unités de contrôle-commande 138 s'effectue par la face avant F1 de l'armoire 100.

De préférence, dans cette configuration, la largeur de la colonne fonctionnelle 111, et donc de l'armoire 100, notée « ℓ1 », est de 600 mm. La largeur de la zone de câblage 160 est donc également de 600 mm. De plus, la largeur des zones fonctionnelles 156 et des zones de raccordement 158, notée « ℓ2 », est de préférence de 400 mm. Dans une telle configuration, la largeur de la zone de gestion thermique 162, notée « ℓ3 », est donc de 200 mm.

La figure 4 illustre l'agencement intérieur d'un deuxième mode de réalisation d'une armoire 100 avec une colonne fonctionnelle 111. Ce deuxième mode de réalisation diffère du mode de réalisation des figures 1 à 3 en ce que la largeur ℓ1 de la colonne fonctionnelle 111 est égale à la largeur ℓ2 et en ce que les colonnes de raccordement 110 ne comprennent pas de zone de gestion thermique 162. La disposition des zones fonctionnelle 156, de raccordement 158 et de câblage 160 est identique à la disposition de ces zones dans la première configuration de la colonne fonctionnelle 111, mise à part la largeur de la zone de câblage 160, qui est égale à la largeur ℓ2. En variante, la colonne fonctionnelle 111 du deuxième mode de réalisation ne comprend pas de zone de câblage 160 et l'ensemble des câbles de raccordement 139 sont disposés dans la zone de raccordement 158.

La figure 5 illustre l'agencement intérieur d'un troisième mode de réalisation d'une armoire 100 avec une colonne fonctionnelle 111. Ce troisième mode de réalisation diffère du mode de réalisation des figures 1 à 3 en ce que le raccordement des câbles de raccordement 139 aux unités de contrôle-commande 138 s'effectue par la face arrière F2 de l'armoire 100. Ainsi, la colonne fonctionnelle 111 ne comprend pas de zone de câblage 160 dédiée et les raccordements sont effectués dans la zone de gestion thermique 162. Les largeurs ℓ1, ℓ2 et ℓ3 sont les mêmes que dans le mode de réalisation des figures 1 à 3.

Comme cela ressort de la comparaison des figures 3 à 5, l'agencement intérieur d'une colonne fonctionnelle 111 est adaptable, ce qui confère une plus grande modularité à l'armoire électrique 100.

En particulier, l'agencement d'une colonne fonctionnelle 111 permet de choisir de raccorder les câbles de raccordement 139 soit par l'avant de l'armoire 100, soit par l'arrière de l'armoire 100.

De préférence, dans une armoire 100, la largeur de toutes les colonnes fonctionnelles 111 est égale soit à ℓ1, soit à ℓ2, et la largeur de la colonne d'alimentation 106 est choisie pour être égale à la largeur des colonnes fonctionnelle.

En variante, il est possible que dans une armoire électrique 100, certaines colonnes fonctionnelle 111 aient une largeur égale à ℓ1 et d'autres colonnes fonctionnelle une largeur égale à ℓ2.

Les câbles de communication interne 136 sont de préférence positionné, selon la hauteur de l'armoire 100, à l'opposé du jeu de barre horizontal 118 afin d'éviter toute interférence électromagnétique. En pratique, cela signifie que, de préférence, les câbles 136 sont positionnés en haut de l'armoire 100 lorsque la gaine horizontale 119 est située en bas de l'armoire et ces câbles sont positionnés en bas de l'armoire lorsque cette gaine horizontale est située en haut de l'armoire.

En variante, lorsque la largeur ℓ1 d'une colonne de raccordement 110 est égale à 600 mm, les câbles de communication interne 136 peuvent être positionnés au plus proche de la face arrière F2 de l'armoire 100, donc de la colonne de raccordement 110, de manière à passer par la zone de gestion thermique 162. Dans une telle configuration, les câbles 136 sont suffisamment éloignés du jeu de barre horizontal 118 pour éviter toute interférence électromagnétique, même lorsque les câbles et le jeu de barres sont positionnés en haut, ou en bas, de la colonne de raccordement.

De préférence, comme visible à la figure 3, la longueur L1 d'une colonne d'alimentation 106 est de 650 mm, la longueur L2 d'une colonne de distribution électrique 108 est de 150 mm, la longueur L4 d'une zone de câblage 160 est de 300 mm et la longueur L5 d'une zone fonctionnelle 156 et d'une zone de raccordement 158 est de 650 mm. Ainsi, la longueur L3 est de 950 mm.

Ainsi, la longueur L111 d'une colonne fonctionnelle 111 comprenant deux colonnes de raccordement 110 est, de préférence, égale à 2650 mm dans une configuration où chaque colonne de raccordement comprend une zone de câblage. En variante, lorsqu'aucune colonne de raccordement ne comprend de zone de câblage 160, la longueur L5 est égale à la longueur L3 et la longueur L111 d'une colonne fonctionnelle 111 est, de préférence, égale à 2050 mm.

En variante, les longueurs L1, L2, L3, L4, L5 et L111 sont différentes.

L'armoire 100 comprend en pratique une ossature 164 et des tôles d'habillage 166.

Dans l'exemple représenté, l'ossature 164 comprend plusieurs cadres 168 et des traverses 170, les traverses 170 reliant les cadres entre eux et chaque cadre étant formé par quatre barres 172.

Parmi les quatre barres 172 d'un cadre 168, deux sont disposées selon l'axe Y et deux sont disposées selon l'axe Z, de manière à former un rectangle. Ainsi, chaque cadre 168 est un rectangle parallèle au plan formé par les axes Y et Z.

Les traverses 170 s'étendent selon l'axe X et permettent d'assembler les cadres 168 entre eux. De manière avantageuse, les traverses 170 sont disposées en extrémité haute et en extrémité basse de l'armoire 100 et forment ainsi respectivement des bandeaux et des plinthes, ce qui est esthétique.

Les tôles d'habillage 166 sont fixées sur l'ossature 164 de manière à fermer les faces avant F1, arrière F2, supérieure F4, gauche F5 et droite F6 de l'armoire 100. Ainsi, l'intérieur de l'armoire 100 est protégé.

Dans l'exemple de la figure 1, l'armoire 100 ne comprend pas de tôle d'habillage 166 sur toute la face avant F1 des colonnes de raccordement 110 de l'armoire 100, de manière à ce qu'une face de chaque module de communication 134, de chaque unité de contrôle-commande 138 et de chaque unité de protection 140 soit accessible depuis l'extérieur. En variante, les modules de communication et les unités de protection et de raccordement sont protégées par des tôles d'habillage 166.

Chaque tôle d'habillage 166 peut en outre être une porte, ce qui permet l'accès à l'intérieur de l'armoire 100. Les tôles d'habillage 166 peuvent être opaques ou transparentes. La figure 1 représente le cas où les tôles d'habillage 166 situées au niveau de la colonne d'alimentation 106 et des zones de câblage 160 sont des opaques.

En outre, lorsque l'armoire 100 a une largeur ℓ1 de 600 mm, l'ossature 164 comprend également des renforts 174, qui s'étendent depuis la face arrière F2 de l'armoire sur une distance de 200 mm. Ainsi, les renforts 174 s'étendent sur toute largeur de la zone de gestion thermique 162, jusqu'à l'interface entre cette zone de gestion thermique et les zones fonctionnelle 156 et de raccordement 158.

En pratique, chaque colonne - d'alimentation, de distribution électrique et de raccordement - de l'armoire 100 comprend une ossature indépendante et les ossatures de deux colonnes adjacentes sont liées entre elles, par exemple à l'aide de vis, ce qui permet une grande modularité dans la conception et dans l'assemblage d'une armoire 100.

En variante, chaque colonne fonctionnelle 111 comprend une ossature 164 commune à la colonne de distribution électrique 108 et à la ou les colonnes de raccordement 110 de cette colonne fonctionnelle 111.

En variante, la conception de l'ossature 164 de l'armoire 100 est différente, par exemple les cadres 168 forment des rectangles parallèles au plan formé par les axes X et Z et les traverses 170 s'étendent selon l'axe Y.

Le détail d'un module de communication 134 est visible aux figures 6 et 7.

Le module de communication 134 comprend une face avant 176 et une face arrière 178.

Dans l'exemple représenté, entre la face avant 176 et la face arrière 178, le module de communication s'étend sur une largeur ℓ134 de 400 mm.

Lorsque le module de communication est installé sur la colonne de raccordement 110, la face avant 176 du module est au niveau de la face avant F1 de la colonne et de l'armoire et la face arrière 178 du module est soit au niveau de la face arrière de l'armoire, lorsque l'armoire a une largeur ℓ2 de 400 mm comme dans le mode de réalisation de la figure 4, soit au niveau des renforts 174, lorsque l'armoire 100 a une largeur ℓ1 de 600 mm, comme dans les modes de réalisation des figures 1 à 3 et 5.

Sur la face avant 176 est ménagée une grille d'aération avant 180 et deux verrous 182, dont un seul est visible sur la figure 6. Les verrous 182 sont disposés de façon symétrique par rapport à un plan médian π134 du tiroir 134 et permettent de maintenir le module de communication 134 monté dans la colonne de raccordement 110 en coopérant avec l'ossature 164. Ils sont actionnables depuis l'extérieur de l'armoire 100, par sa face avant F1.

Sur la face arrière 178 est ménagée une grille d'aération arrière 184. Lorsque l'armoire 100 a une largeur ℓ2 de 400 mm comme dans le mode de réalisation de la figure 4, la grille d'aération 184 relie l'intérieur du module de communication avec l'extérieur de l'armoire. Lorsque l'armoire 100 a une largeur ℓ3 de 600 mm comme dans les modes de réalisation des figures 1 à 3 et 5, la grille d'aération 184 relie l'intérieur du module de communication avec la zone de gestion thermique 162.

Grâce aux grilles d'aération avant 180 et arrière 184, l'air situé à l'intérieur du module de communication 134 est en permanence renouvelé par convection naturelle, ce qui permet de refroidir le module de communication et de conserver une température intérieure à ce module compatible avec son fonctionnement, en évacuant les calories produites par l'échauffement des composants électroniques contenus dans le module de communication, et notamment par l'échauffement des blocs d'alimentation 150.

En pratique, l'air pénètre par la grille d'aération avant 180, est chauffé par les composants électroniques du module de communication, ce qui permet de refroidir ces composants, puis ressort par la grille d'aération arrière 184.

En variante, un ventilateur est installé dans le module de communication 134 afin de forcer la circulation d'air de l'avant vers l'arrière du module. Ce ventilateur est, par exemple, installé sur la grille d'aération avant, ou sur la grille d'aération arrière, ou porté par un bloc d'alimentation 150.

La face avant 176 du module de communication 134 comprend des indicateurs 185 de fonctionnement du module de communication, visibles à la figure 1. Ces indicateurs 185 sont par exemple des voyants qui indiquent le bon fonctionnement des blocs d'alimentation 150 ou une défaillance, c'est-à-dire d'une interruption de la fourniture de la première tension auxiliaire.

Chaque colonne de raccordement 110 comprend deux rails latéraux 186, fixés sur l'ossature 164. Les rails latéraux 186 sont représentés sur les figures 6 et 7.

Le module de communication 134 comprend deux faces latérales 187, qui s'étendent de la face avant 176 à la face arrière 178. Ces faces latérales 187 coopèrent avec les rails latéraux 186 de la colonne de raccordement 110, et permettent de mettre en place le module de communication 134 dans la colonne de raccordement et de le retirer en le faisant coulisser tel un tiroir, selon une direction parallèle à l'axe Y. Le montage et le démontage du module de communication 134 sont donc rapides et faciles.

Les deux blocs d'alimentation 150 redondants sont connectés à une carte électronique 188. En pratique, la carte électronique 188 comprend deux connecteurs 189, sur lesquels les blocs d'alimentation 150 sont enfichés.

La carte électronique 188 permet de contrôler les deux blocs d'alimentation 150 et de gérer la première tension électrique auxiliaire.

La carte électronique 188 est configurée pour, dans le cas où l'un des deux blocs d'alimentation 150 est défaillant, alerter de cette défaillance, par exemple au moyen d'un indicateur 185, mais continue de gérer la première tension électrique auxiliaire, fournie par le second bloc d'alimentation non-défaillant.

La face avant 176 du module de communication comprend un capot 190. Ce capot 190 est démontable de la face avant 176 et il est disposé en regard des deux blocs d'alimentation 150. Ainsi, lorsque la carte électronique 188 signale qu'un bloc d'alimentation 150 est défaillant, il est possible de démonter le capot 190 pour accéder directement au bloc d'alimentation défaillant, l'extraire du module de communication 134 puis le remplacer par un bloc d'alimentation fonctionnel. Cette opération de remplacement s'effectue donc sans nécessiter de sortir le module de communication 134 de la colonne de raccordement 110, ce qui permet de l'effectuer sans interrompre le fonctionnement du module de communication, dont l'autre bloc d'alimentation demeure actif.

Ce remplacement d'un bloc d'alimentation en cours de fonctionnement est avantageux car il permet de ne pas arrêter le fonctionnement de la colonne de raccordement 110.

En outre, la carte électronique 188 alimente en première tension électrique auxiliaire le switch managé 135 pour permettre le fonctionnement de ce switch.

La carte électronique 188 alimente également en première tension électrique auxiliaire un premier connecteur 192, disposé sur une face latérale 187, et qui permet de connecter la première tension électrique auxiliaire à une autre colonne de l'armoire 100, par exemple au premier connecteur 192 du module de communication 134 d'une autre colonne de raccordement 110. Ainsi, en cas de défaillance des deux blocs d'alimentation 150, un module de communication 134 est toujours alimenté en première tension électrique auxiliaire, par le module de communication 134 d'une autre colonne de raccordement.

En variante, ce raccordement permet également de ne pas installer de bloc d'alimentation 150 dans tous les modules de communication 134 d'une armoire 100.

En outre, le premier connecteur 192 alimente en première tension électrique auxiliaire le bus informatique 142.

La carte électronique 188 comprend une unité de calcul 193 qui exécute un logiciel permettant de contrôler le switch managé 135 et les blocs d'alimentation 150. En pratique, la carte électronique 188 et le switch managé 135 sont connectés par un câble de communication interne non-représenté, par exemple un câble Ethernet.

Les blocs d'alimentation 150 sont eux-mêmes alimentés par la deuxième tension électrique auxiliaire. La deuxième tension électrique auxiliaire permet donc à la fois d'alimenter les blocs d'alimentation 150 et les charges électriques 104.

Le module de communication 134 comprend un boîtier de protection 194, qui est par exemple un disjoncteur. Le boîtier de protection 194 alimente le module de communication 134 en deuxième tension auxiliaire. Pour cela, le boîtier de protection 194 est lui-même alimenté en étant connectée à une source d'alimentation externe ou interne à l'armoire électrique 100.

En pratique, le boîtier 194 est relié à un deuxième connecteur 196, disposé sur la même face latérale 187 que le premier connecteur 192, qui permet de raccorder le boîtier de protection à la source d'alimentation externe ou interne.

En variante, le boîtier de protection 194 est relié à une barre verticale 124 du jeu de barres verticales 122 et à un neutre. En se connectant à une seule barre verticale d'un jeu de barre et à un neutre, le boîtier 194 est alimenté à une tension inférieure à la tension délivrée par l'alimentation électrique principale. Par exemple, lorsque l'alimentation électrique principale est une alimentation triphasée qui délivre une tension de 400V, la tension électrique auxiliaire obtenue en se connectant à une phase et à un neutre est de 230V.

Avantageusement, le boîtier de protection 194 alimente également le bus informatique 142 en deuxième tension auxiliaire.

La face latérale 187 qui porte les premier et deuxième connecteurs comprend également deux connecteurs de communication 198 raccordés au switch managé 135. Parmi ces deux connecteurs de communication 198, un premier connecteur permet le raccordement d'un câble de communication interne 136 relié au module de communication d'une autre colonne de raccordement 110, dans le cas où l'armoire 100 comprend plusieurs colonnes de raccordement 110, et un second connecteur permet le raccordement d'un câble de communication interne 136 relié au commutateur central 137. En variante, le premier et le deuxième connecteurs sont chacun reliés à un module de communication d'une autre colonne de raccordement 110, de sorte à relier trois colonnes de raccordement entre elles. En variante, le module de communication 134 comprend un nombre de connecteurs de communication 198 différent de deux, par exemple un ou trois.

Des ouvertures sont ménagées dans les rails latéraux 186, de sorte à permettre l'accès aux connecteurs 192, 196 et 198 lorsque le module de communication est monté sur les rails latéraux.

Une colonne de raccordement 110 peut être configurée pour plusieurs usages différents :
- Une première configuration dans laquelle la colonne de raccordement permet le raccordement à des moteurs électriques, tels que par exemple des moteurs triphasés. Chaque moteur électrique est raccordé à une unité de contrôle-commande. La colonne de raccordement 110 permet alors d'alimenter ces moteurs électriques et de les piloter. Dans cette première configuration, la colonne de raccordement 110 est alors appelée « colonne de démarrage moteur ».
- Une deuxième configuration dans laquelle la colonne de raccordement permet le raccordement à des circuits électriques de distribution aval, tels que par exemple des tableaux électriques ou des armoires de distribution électrique. La colonne de raccordement 110 permet alors de distribuer l'énergie provenant des câbles d'alimentation 102 vers plusieurs circuits aval, chaque circuit aval étant raccordé à une unité de contrôle-commande, et de protéger ces circuits aval. Dans cette deuxième configuration, la colonne de raccordement 110 est alors appelée « colonne de répartition de courant »
- Une troisième configuration dans laquelle la colonne de raccordement permet le raccordement à des charges électriques pilotables, tels que par exemple des panneaux photovoltaïques ou des batteries. Chaque charge électrique est raccordée à une unité de contrôle-commande 138. La colonne de raccordement 110 permet alors d'alimenter ces circuits électriques et de les piloter. Dans cette troisième configuration, la colonne de raccordement 110C est alors appelée « colonne de pilotage de charge ».

En pratique, la configuration et l'architecture de la zone fonctionnelle 156, et plus particulièrement des unités de contrôle-commande 138, diffèrent entre les trois configurations listées ci-dessus. En outre, d'autres configurations associées à d'autres usages sont envisageables.

L'exposé qui suit détaille la configuration et l'architecture d'une colonne de démarrage moteur 110.

Certains éléments mentionnés ci-après sont décrits dans le cadre de la colonne de démarrage moteur, mais leur application ne se limite pas exclusivement à leur utilisation dans une colonne de démarrage moteur. Ainsi, certains éléments introduits ci-après pourront également s'appliquer à des éléments utilisés dans une colonne de répartition de courant ou dans une colonne de de pilotage de charge, par exemple.

Ainsi, la description qui va suivre détaille la configuration et l'architecture d'un module de démarrage moteur 200.

La configuration et l'architecture de ce module se transposent à d'autres configurations, comme par exemple dans le cas d'une colonne de répartition de courant, où le module de démarrage moteur correspond alors à un module de répartition qui permet de répartir un courant électrique vers un ou plusieurs circuits aval et de protéger ces circuits, ou dans le cas d'une colonne de pilotage de charge, où le module de démarrage moteur correspond alors à un module de pilotage qui permet d'alimenter des charges électriques et de les piloter. D'autres usages sont envisageables.

On désigne par « module fonctionnel » tout module dont l'architecture est transposable depuis l'architecture décrit ci-dessous d'un module de démarrage moteur 200, tel que par exemple un module de répartition ou un module de pilotage.

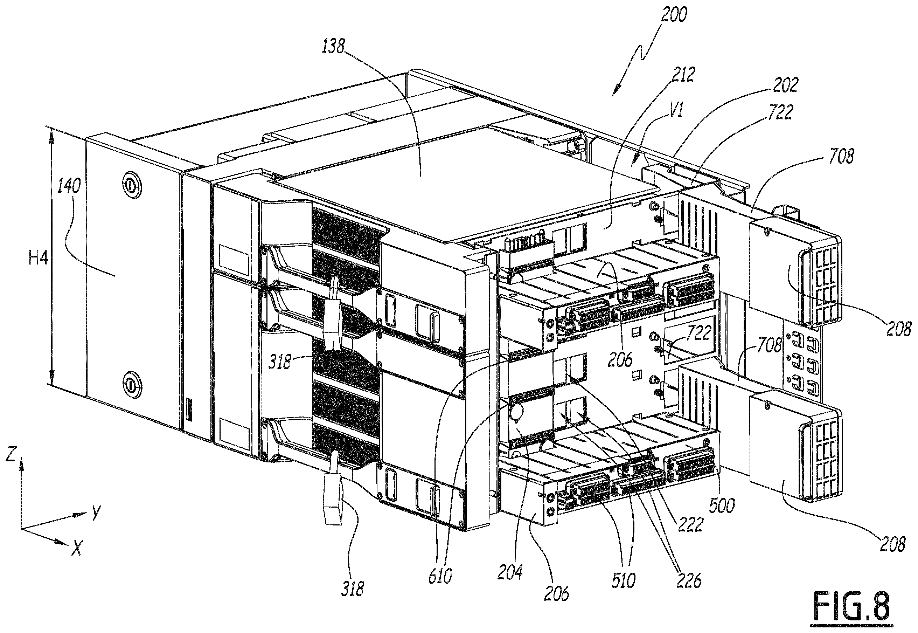

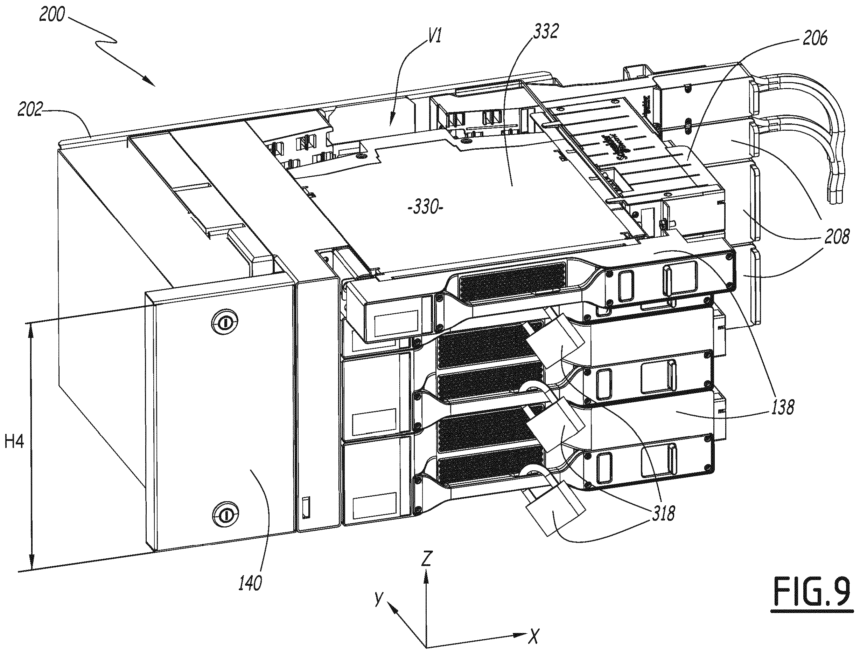

La colonne de démarrage moteur 110, comprend un ou plusieurs modules de démarrage moteur 200, dont un est visible aux figures 8 et 9.

Chaque module de démarrage moteur 200 d'une colonne de démarrage moteur 110 est principalement situé dans la zone fonctionnelle 156 et partiellement situé dans la zone de raccordement 158 de cette colonne de démarrage moteur.

Lorsqu'une colonne de démarrage moteur 110 comprend plusieurs modules de démarrage moteur 200, les modules de démarrage moteur sont juxtaposés verticalement.

En pratique, chaque module de démarrage moteur 200 comprend une unité de protection 140 et au moins une unité de contrôle-commande 138. Chaque unité de contrôle-commande 138 d'un module de démarrage moteur est électriquement protégée par l'unité de protection 140 de ce module de démarrage moteur.

En outre, chaque unité de contrôle-commande 138 est connectée à l'unité de protection 140 protégeant cette unité de contrôle-commande, de manière à pouvoir communiquer à cette unité de protection des informations sur le fonctionnement de cette unité de contrôle-commande.

Dans l'exemple représenté, les unités de contrôle-commande 138 sont des tiroirs dont la hauteur peut prendre plusieurs valeurs définies. Dans la suite de la description, les unités de contrôle-commande 138 sont donc appelées « tiroir 138 ». On définit une hauteur de base d'un tiroir comme une hauteur unitaire, notée « U ». La hauteur d'un tiroir peut être égale à un multiple entier de cette hauteur de base, jusqu'à une limite de six fois la hauteur unitaire U.

Ainsi, un tiroir 138 peut occuper une hauteur de 1U, 2U, 3U, 4U, 5U ou 6U.

De préférence, la hauteur unitaire U est égale à 50 mm. Ainsi, un tiroir 138 de hauteur 6U aura, dans cet exemple, une hauteur de 300 mm.

Chaque module de démarrage moteur 200 a une hauteur principale, notée « H4 », égale à 6U. Dans l'exemple représenté, la zone fonctionnelle 156 a une hauteur H2 de 1500 mm et peut donc comporter jusqu'à cinq modules de démarrage moteur 200.

En outre, la largeur d'un module de démarrage moteur, mesurée selon l'axe Y, est égale à la largeur ℓ2 de la zone fonctionnelle dans laquelle le module est installé

Chaque module de démarrage moteur 200 est configuré pour accueillir toute combinaison techniquement admissible de tiroirs, selon la hauteur de ces tiroirs. Par exemple, un module de démarrage moteur peut accueillir six tiroirs de hauteur 1U, ou trois tiroirs de hauteur 2U, ou un tiroir de hauteur 6U.

Comme visible aux figures 8 et 9, chaque module de démarrage moteur 200 comprend les éléments suivants :
- une structure de support 202 ;
- une unité de protection 140 ;
- un tronçon de bus informatique 204, qui correspond à une partie du bus informatique 142 ;
- au moins un tiroir 138, en pratique entre un et six tiroirs 138 ;
- au moins un module d'entrées-sorties 206, en pratique autant de modules d'entrées-sorties 206 que de tiroirs 138, c'est-à-dire entre un et six modules d'entrées-sorties ; et
- au moins un module de raccordement externe 208, en pratique autant de modules de raccordement 208 que de tiroirs 138, c'est-à-dire entre un et six modules de raccordement externe. Chaque module de raccordement externe 208 est configuré pour qu'une charge électrique 104 y soit raccordée et pour alimenter cette charge électrique. En pratique, dans le cas d'un module de démarrage moteur 200, chaque charge 104 est un moteur électrique.

Sur l'exemple représenté à la figure 8, le module de démarrage moteur 200 représenté accueille un tiroir de hauteur 2U et un tiroir de hauteur 4U.

Sur l'exemple représenté à la figure 9, le module de démarrage moteur 200 représenté accueille deux tiroirs de hauteur 1U et deux tiroirs de hauteur 2U.

On définit trois positions principales du tiroir 138 dans le module de démarrage moteur :
- Une position de fonctionnement du tiroir, dans laquelle le tiroir est entièrement inséré dans le module de démarrage moteur 200. Cette position correspond à la position de fonctionnement normal du tiroir 138, c'est-à-dire que, d'une part, le tiroir 138 alimente en énergie électrique un module de raccordement externe 208 et la charge électrique 104 qui y est raccordée, et d'autre part, le tiroir 138 est connecté au module de communication 134 et à l'unité de protection 140. Tous les tiroirs de la figure 8 et les trois tiroirs inférieurs de la figure 9 sont représentés en position de fonctionnement.
- Une position de test du tiroir, dans laquelle le tiroir est partiellement inséré dans le module de démarrage moteur 200. Cette position correspond à une position intermédiaire dans laquelle le tiroir 138 fonctionne, c'est-à-dire que les éléments qu'il contient sont alimentés en énergie électrique et qu'il communique mais que le tiroir n'alimente pas de charge électrique 104. Le tiroir supérieur de hauteur 1U est représenté en position de test à la figure 9.
- Une position déconnectée du tiroir, dans laquelle le tiroir est partiellement ou complètement sorti du module de démarrage moteur 200 et dans laquelle le tiroir n'est pas alimenté en énergie électrique et n'alimente pas de charge électrique 104.

Le tiroir 138 est configuré pour pouvoir être déplacé entre ces trois positions.

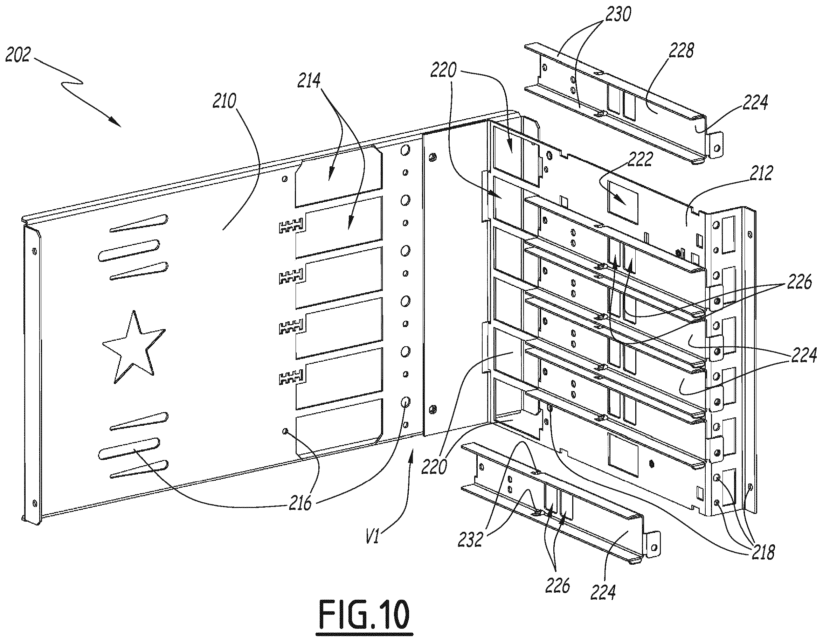

Comme visible à la figure 10, la structure de support 202 de chaque module de démarrage moteur 200 comprend un support arrière 210 et un support latéral 212.

Les supports arrière 210 et latéral 212 permettent, d'une part, de fixer le module de démarrage moteur 200 à la colonne de démarrage moteur 110 et, d'autre part, de fixer le tronçon de bus informatique 204, l'unité de protection 140, chaque tiroir 138, chaque module d'entrées-sorties 206 et chaque module de raccordement externe 208 au module de démarrage moteur 200.

En pratique, chaque module de démarrage moteur 200 est fixé à l'ossature 164 de la colonne de démarrage moteur 110 à laquelle le module appartient à travers son support 202.

Pour cela, le support arrière 210 est fixé soit à des barres 172 de l'ossature 164 situées sur la face arrière de l'armoire, lorsque l'armoire a une largeurr ℓ2 de 400 mm comme dans le mode de réalisation de la figure 4, soit aux renforts 174 de l'ossature 164 lorsque l'armoire a une largeur ℓ1 de 600 mm comme dans les modes de réalisation des figures 1 à 3 et 5. Le support latéral 212 est fixé à des barres 172 de l'ossature 164 situées sur la face avant de l'armoire.

La fixation des supports 210 et 212 à l'ossature 164 s'effectue de préférence à l'aide de vis, non-représentées sur les figures.

Les supports 210 et 212 sont fixés ensemble de préférence à l'aide de vis, non-représentées sur les figures.

En configuration assemblée du module de démarrage moteur 200 sur l'armoire 100, le support arrière 210 s'étend principalement parallèlement au plan formé par les axes X et Z. Il est de forme globalement rectangulaire et comprend des orifices de ventilation 214, dans l'exemple représenté six orifices de ventilation.

Le support arrière 210 comprend un ensemble de trous de fixation 216 qui permettent de fixer le support arrière 210 à la fois à l'ossature 164 et aux éléments du module de démarrage moteur 200 tels que par exemple l'unité de protection 140 ou encore les modules de raccordement externe 208.

Le support latéral 212 s'étend principalement parallèlement au plan formé par les axes Y et Z, en configuration assemblée du module de démarrage moteur 200 sur l'armoire 100. Il est de forme globalement rectangulaire.

Le support latéral 212 est configuré pour être fixé d'une part, à une première extrémité, au support arrière 210 et d'autre part, à une seconde extrémité, à l'ossature 164 de l'armoire 100. Le support latéral 212 comprend un ensemble de trous de fixation 218 qui permettent ce montage, qui s'effectue de préférence à l'aide de vis non-représentées.

Le support latéral 212 comprend des ouvertures 220, situées à proximité du support arrière 210, c'est-à-dire à proximité de l'arrière du module de démarrage moteur. Ces ouvertures sont configurées pour permettre le passage des modules de raccordement externe 208, comme visible à la figure 8. En pratique, le support latéral 212 comprend six ouvertures 220.

Le support latéral 212 comprend, en outre, des fenêtres 222, dont le rôle est expliqué ci-après. En pratique, le support comprend six fenêtres 222.

Les supports arrière 210 et latéral 212 sont, dans l'exemple représenté, formés par des tôles métalliques pliées et percées.

La structure de support 202 comprend, en outre, des rails 224, en pratique six rails 224, qui s'étendent selon l'axe Y. Les rails 224 sont, de préférence, fixés au support latéral 212 par des vis non-représentées.

Chaque rail 224 comprend deux fenêtres 226, juxtaposées selon l'axe Y. Lorsqu'un rail est fixé au support latéral 212, ses deux fenêtres 226 sont en vis-à-vis avec une fenêtre 222 du support latéral 212, comme visible sur les figures 8 et 10.

Sur la figure 10, deux rails 224, à savoir le rail supérieur et le rail inférieur, sont représentés en vue éclatée, c'est-à-dire que ces deux rails sont représentés démontés du support latéral 212. Les autres rails, intermédiaires, sont représentés en place sur le support latéral 212.

Chaque rail 224 est en forme de « U », avec un fond 228 parallèle au plan formé par les axes Y et Z et dans lequel les fenêtres 226 sont ménagées, et deux bords 230 qui s'étendent perpendiculairement au fond 228. Les deux bords 230 sont donc opposés l'un à l'autre.

En outre, les bords 230 de chaque rail 224 comprennent une languette 232, qui s'étend en direction du bord opposé du rail. Les languettes 232 d'un rail sont ménagées dans ses bords 230 au niveau de la fenêtres 226 de ce rail la plus proche du support arrière 210, plus précisément à une extrémité de cette fenêtre la plus proche du support arrière 210.

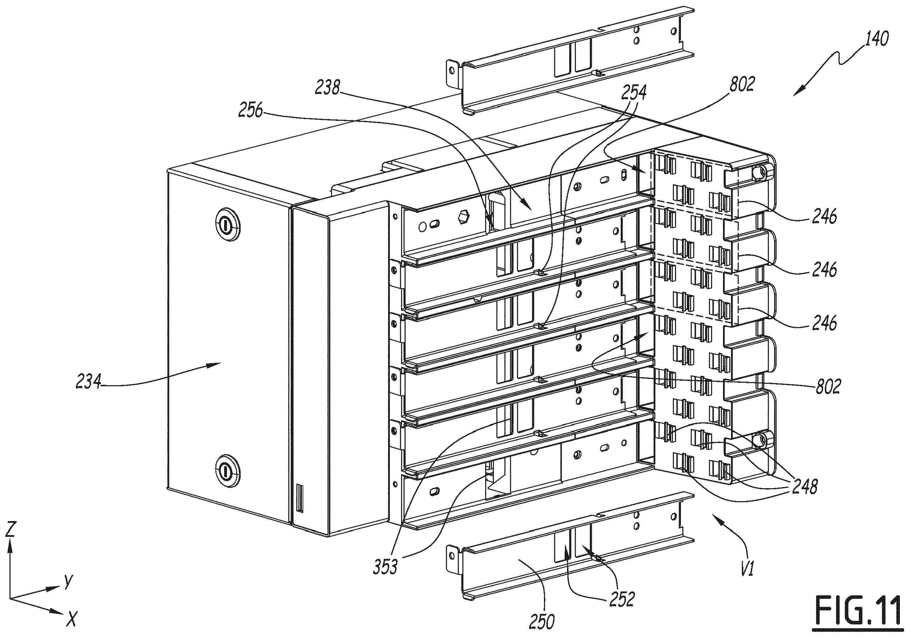

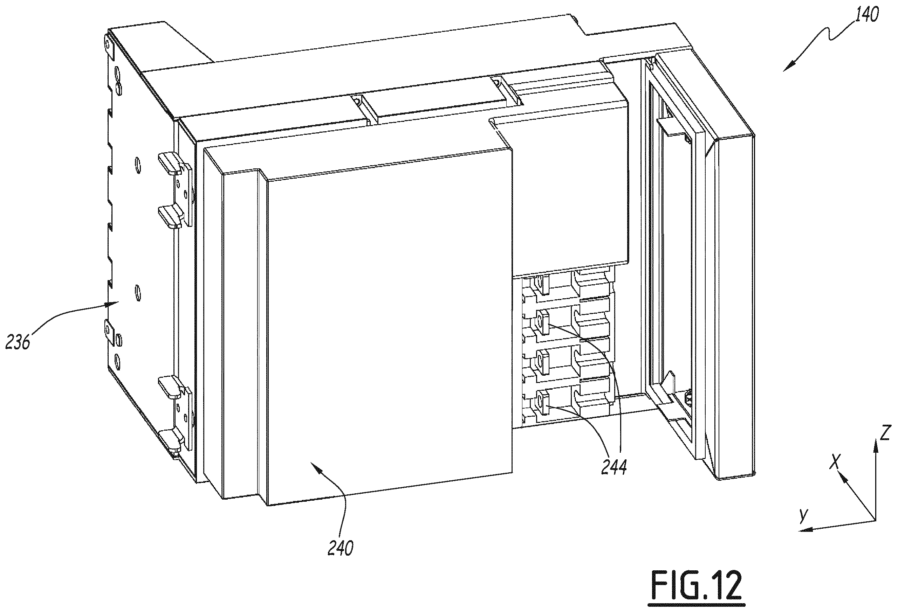

Une unité de protection 140 est représentée en perspective aux figures 11 et 12.

Cette unité de protection contient l'organe ou les organes de protection non-représentés, comme par exemple un disjoncteur, qui protègent le ou les tiroirs 138 du module de démarrage moteur 200.

L'unité de protection 140 comprend une face avant 234, une face arrière 236, une face intérieure 238 et une face extérieure 240.

En pratique, en configuration montée, la face avant 234 de l'unité de protection est contenue dans un même plan que la face avant F1 de l'armoire 100.

En pratique, les faces avant et arrière 234 et 236 sont parallèles au plan formé par les axes X et Z et les faces intérieure et extérieure 238 et 240 sont parallèles au plan formé par les axes Y et Z

La face arrière 236 de l'unité de protection 140 est fixée au support arrière 210 de la structure 202 du module de démarrage moteur 200, par exemple à l'aide de vis, non-représentées, qui passent dans les trous de fixation 216 du support arrière.

Lorsque l'unité de protection 140 est fixée à la structure 202, la face intérieure 238 de l'unité de protection et le support latéral 212 de la structure 202 se font face, c'est-à-dire qu'ils sont disposés en regard l'un de l'autre. On définit un volume V1 comme le volume situé entre la face intérieur 238 de l'unité de protection, le support arrière 210 et le support latéral 212.

Le raccordement électrique de l'unité de protection 140 au jeu de barres vertical 122 s'effectue à l'aide de connecteurs électriques 244, disposés sur la face extérieure 240 de l'unité de protection, comme visible à la figure 12. Chaque connecteur 244 est connecté à une barre verticale 124 du jeu de barres vertical 122. En pratique, l'unité de protection 140 comprend quatre connecteurs électriques 244, ce qui permet de raccorder, par exemple, une alimentation comprenant trois phases et un neutre. En outre, il est possible de ne pas raccorder certains connecteurs électriques 244, par exemple si l'alimentation de l'armoire électrique 100 comprend trois phases sans neutre, ou une phase et un neutre.

L'unité de protection 140 comprend plusieurs groupes de sorties électriques 246. Ces groupes de sorties électriques s'étendent depuis la face arrière 236 de l'unité de protection, en direction de sa face avant 234. En d'autres termes, les groupes de sorties électriques 246 sont disposés dans le volume V1.

En pratique, l'unité de protection 140 comprend six groupes de sorties électriques 246.

L'unité de protection 140 peut donc protéger jusqu'à six tiroirs 138.

L'unité de protection 140 permet donc de mutualiser la protection des tiroirs 138 d'un module de démarrage moteur 200. Cette mutualisation est avantageuse car elle permet de réduire le coût du module de démarrage moteur, chaque tiroir 138 ne nécessitant pas d'unité de protection dédiée.

En outre, il est avantageux que l'unité de protection 140 ne soit pas intégrée aux tiroirs 138. En effet, en cas de défaillance d'un tiroir, seul ce tiroir doit être remplacé et l'unité de protection 140 n'a pas à être remplacée, ce qui est moins onéreux.

Chaque groupe de sorties électriques 246 comprend quatre sorties électriques 248, raccordées chacune à l'un des quatre connecteurs électriques 244.

L'organe de protection de l'unité de protection 140 est donc disposé entre les connecteurs électriques 244 et les sorties électriques 248.

Cet organe de protection est donc relié, pour chaque phase et le neutre, en entrée à un connecteur 244 et en sortie à six sorties électriques 248, c'est-à-dire à l'une des quatre sorties électriques de chaque groupe de sorties électriques.

Un groupe de sortie électrique 246 est contenu dans un volume de hauteur égale à 1U.

L'unité de protection 140 comprend des rails 250, de préférence six rails 250, qui sont identiques aux rails 224 de la structure de support 202. Notamment, les rails 250 comprennent des fenêtres 252 et des languettes 254

Les rails 250 sont disposés sur la face intérieure 238 de l'unité de protection.

Sur la figure 11, les rails 250 supérieur et inférieur sont représentés en vue éclatée, c'est-à-dire que ces rails sont démontés de l'unité de protection 140. Les autres rails 250, intermédiaires, sont représentés en place sur l'unité de protection 140.

Les rails 250 font face aux rails 224 de la structure de support 202, c'est-à-dire que chaque rail 250 s'étend parallèlement à, et dans un même plan horizontal que, un rail 224. Ainsi, un rail 250 et un rail 224 forment ensemble une paire de rails.

Comme décrit ci-après, une paire de rails formée d'un rail 250 et d'un rail 224 permet de déplacer un tiroir 138 entre sa position de fonctionnement, sa position de test et sa position déconnectée.

En outre, la face intérieure 238 de l'unité de protection 140 comprend des fenêtres 256, en pratique six fenêtres 256, qui sont situées en vis-à-vis des fenêtres 252 des rails 250.

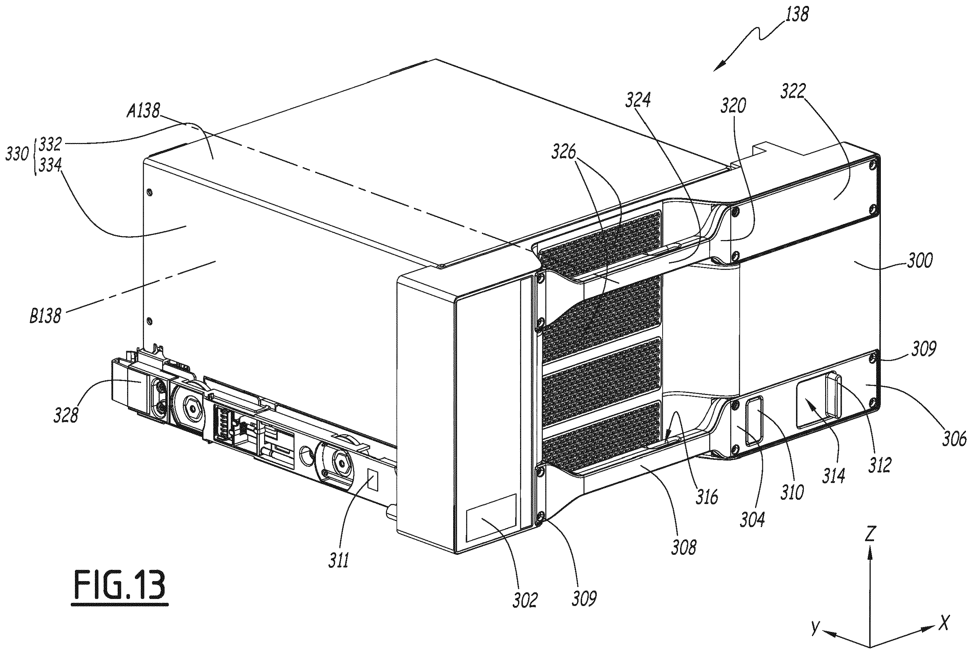

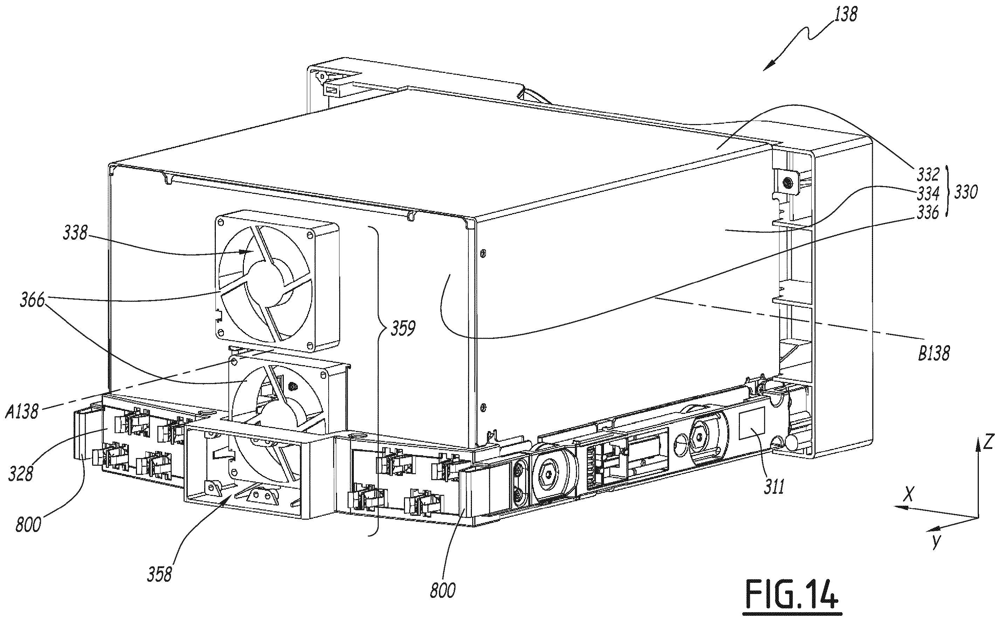

Un tiroir 138 de hauteur 4U est représenté aux figures 13 et 14.

Ce tiroir 138 de hauteur 4U comprend une partie frontale 300.

Comme visible à la figure 13, la partie frontale 300 du tiroir s'étend principalement parallèlement au plan formé par les axes X et Z.

Tous les tiroirs 138 comprennent une partie frontale 300, qui est différente selon la hauteur du tiroir. Ainsi, la hauteur de la partie frontale est adaptée à la hauteur du tiroir de cette partie frontale. Une partie frontale 300 peut donc avoir une hauteur de 1U, 2U, 3U, 4U, 5U ou 6U.

Dans la suite de la description, tout élément décrit en référence au tiroir 138 de hauteur 4U des figures 13 et 14 est également présent dans des tiroirs 138 de hauteur différente, sauf en cas de mention explicite.

La partie frontale 300 comprend un afficheur 302, qui affiche des informations sur le fonctionnement du tiroir 138. Ces informations sont, par exemple, la référence de la charge électrique 104 commandée par le tiroir 138, la puissance électrique délivrée à cette charge électrique, ou encore l'état de cette charge électrique.

En variante, l'afficheur 302 comprend en outre un bandeau de diodes électroluminescentes, ou « DEL », qui comprend une ou plusieurs DEL pouvant émettre des indicateurs visuels sous forme de couleurs.

La partie frontale 300 comprend une poignée principale 304.

La poignée 304 comprend une base 306 et une extension de préhension 308.

En pratique, la base 306 et l'extension de préhension 308 sont formées d'une pièce monobloc, assemblée à la partie frontale par des moyens de fixation 309 tels que des vis.

La base 306 comprend un bouton 310. Le bouton 310 permet d'émettre une commande d'ouverture du verrou électromagnétique 311 disposé sur un côté du tiroir 138, comme visible aux figures 13 et 14 où le verrou électromagnétique 311 est du côté du rail 250 de l'unité de protection 140.

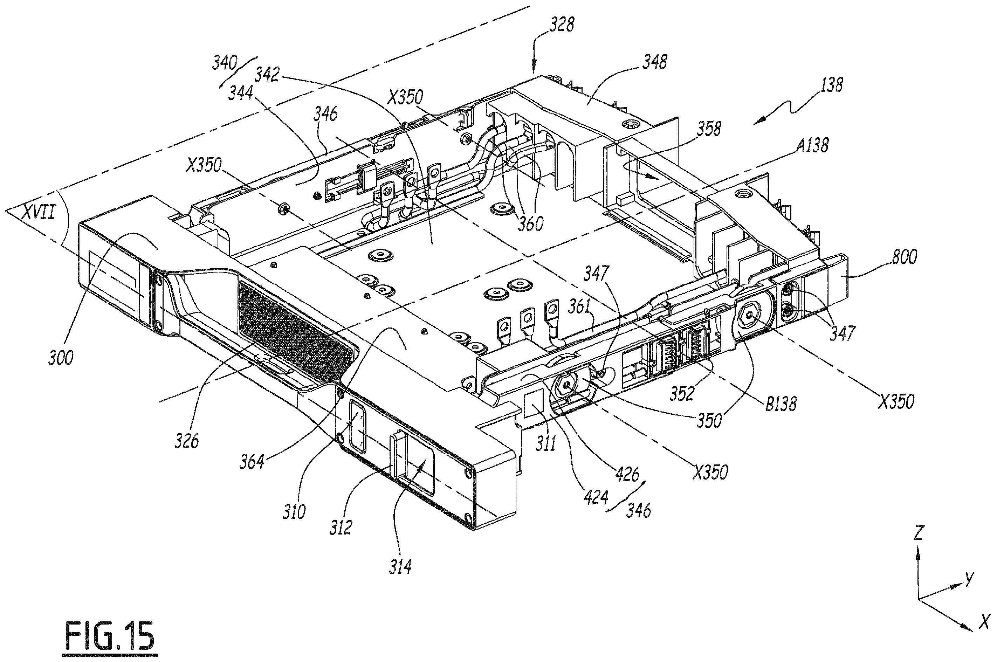

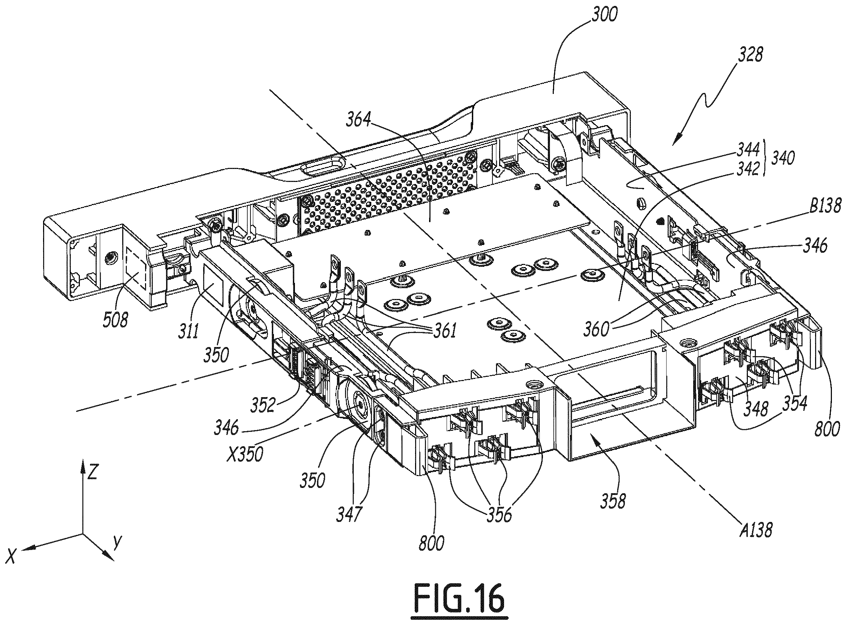

En variante, le verrou électromagnétique 311 est disposé sur un autre côté du tiroir 138, comme visible aux figures 15 et 16, où le verrou électromagnétique 311 est du côté du rail 224 de la structure de support 202.En variante, deux verrous électromagnétiques 311 sont disposés sur le tiroir 138, chacun d'un côté.

En variante non-représenté de l'invention, le bouton 310 est disposé à un autre emplacement de la partie frontale 300 du tiroir 138.

Ce verrou électromagnétique 311 est mobile entre une position de verrouillage du tiroir 138 et une position de déverrouillage du tiroir 138.

En position de verrouillage du tiroir 138, le verrou électromagnétique 311 permet de maintenir le tiroir 138 soit en position de fonctionnement, soit en position de test. Autrement dit, le verrou électromagnétique empêche l'insertion du tiroir dans le module de démarrage moteur 200 depuis sa position de test jusqu'à sa position de fonctionnement et empêche sa sortie du module de démarrage moteur depuis sa position de fonctionnement ou depuis sa position de test.

En position de déverrouillage du tiroir 138, le verrou électromagnétique permet au tiroir d'être librement inséré dans le module de démarrage moteur depuis sa position de test jusqu'à sa position de fonctionnement, ou sorti du module de démarrage moteur depuis sa position de fonctionnement ou depuis sa position de test.

En pratique, en position de verrouillage du tiroir 138, le verrou électromagnétique 311 s'étend en-dehors du tiroir et bloque mécaniquement son insertion dans le module de démarrage moteur ou sa sortie du module de démarrage moteur, comme détaillé ci-après.

Par défaut, le verrou électromagnétique 311 est en position de verrouillage du tiroir 138 et le verrou bascule en position de déverrouillage du tiroir lorsqu'il reçoit une commande d'ouverture. En l'absence de commande d'ouverture, le verrou bascule en position par défaut de verrouillage du tiroir.

Dans l'exemple, le bouton 310 doit être enfoncé dans la base 306 pour émettre une commande d'ouverture et un ressort non-représenté maintien le bouton non-enfoncé.

En d'autres termes, pour insérer le tiroir 138 dans le module de démarrage moteur depuis sa position de test jusqu'à sa position de fonctionnement, ou pour sortir le tiroir 138 du module de démarrage moteur depuis sa position de fonctionnement, il est nécessaire d'actionner le bouton 310. Ainsi, le bouton 310 permet, lorsqu'il est actionné, d'envoyer une commande d'ouverture commandant le déverrouillage du verrou électromagnétique 311 et ainsi d'autoriser le déplacement du tiroir depuis sa position de fonctionnement ou depuis sa position de test.

En pratique, le verrou électromagnétique 311 commandé par le bouton 310 empêche l'insertion du tiroir 138 depuis sa position de test jusqu'à sa position de fonctionnement, ou la sortie du tiroir 138 depuis sa position de fonctionnement, en interférant avec le rail 224 ou avec le rail 250.

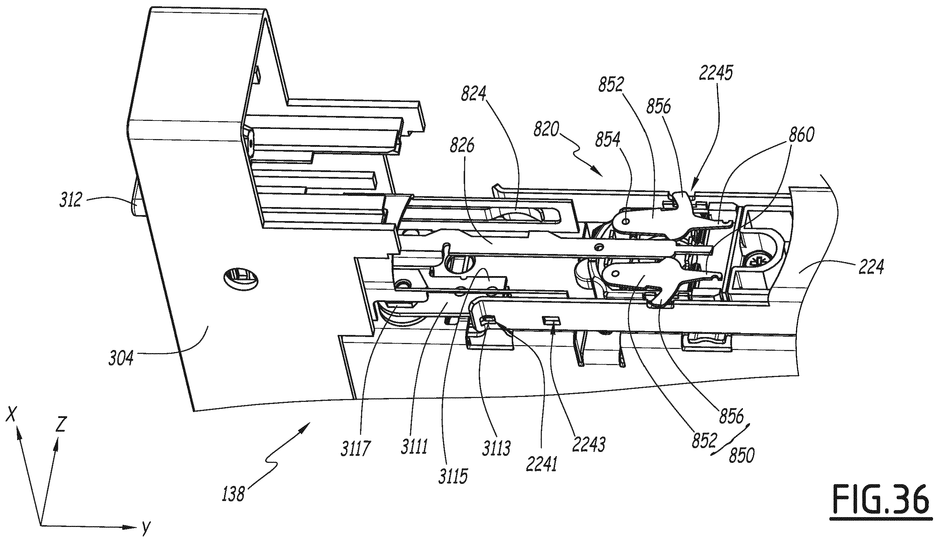

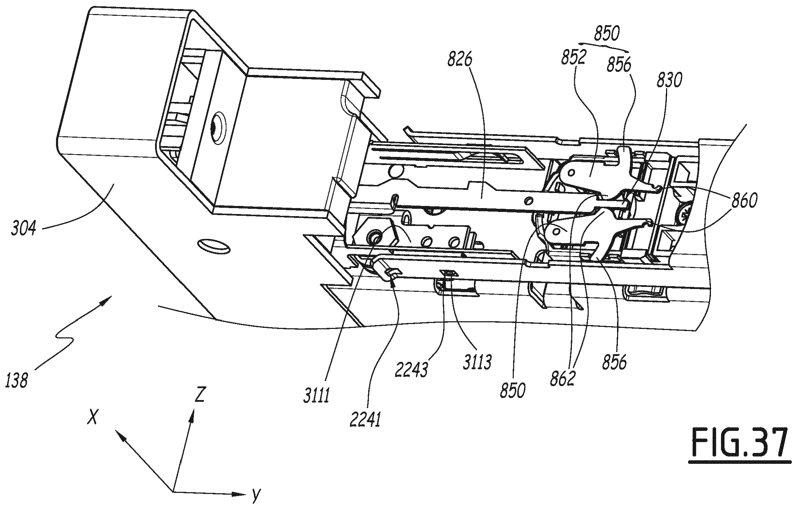

Sur les figures 36 et 37, le tiroir 138 est représenté verrouillé par le verrou électromagnétique 311 respectivement en position de test et en position de fonctionnement. Dans cet exemple, le verrou électromagnétique 311 est représenté du côté du rail 224 de la structure de support 202.

La description ci-dessous du fonctionnement du verrou électromagnétique 311 s'applique de manière identique à un verrou électromagnétique disposé du côté d'un rail 250 et interférant avec ce rail 250 pour empêcher le déplacement du tiroir 138.

Comme visible sur ces figures 36 et 37, le verrou électromagnétique 311 comprend un levier basculant 3111 et un pêne 3113 disposé à une première extrémité 3115 du levier basculant 3111. Le levier basculant est mobile en rotation autour d'une deuxième extrémité 3117. Ainsi, lorsque le verrou électromagnétique 311 reçoit une commande d'ouverture, le levier basculant 3111 est entraîné en rotation de manière à déplacer le pêne 3113.

En position de verrouillage du verrou électromagnétique 311, le pêne 3113 est disposé dans une fente 2241 du rail 224, lorsque le tiroir 138 est en position de test, ou dans une autre fente 2243 du même rail 224, lorsque le tiroir est en position de fonctionnement.

Ainsi, le déplacement du tiroir 138 est bloqué par le contact du pêne 3113 avec le bord de la fente 2241 ou le bord de la fente 2243 du rail 224 de la structure de support 202.

La rotation du levier basculant 3111 est entraînée par un actionneur électromagnétique, non-représenté. Cet actionneur électromagnétique est activé lorsque le verrou électromagnétique 311 reçoit une commande d'ouverture. En pratique, l'actionnement du bouton 310 génère une commande d'ouverture, qui est un signal électrique, lequel commande l'activation de l'actionneur du verrou électromagnétique 311.

En variante non-représentée de l'invention, le verrou électromagnétique 311 ne comprend pas de levier basculant mobile en rotation et le pêne 3113 est entraîné en translation par un actionneur électromagnétique, par exemple par l'intermédiaire d'un coulisseau.

La base 306 comprend une tirette 312, accessible au travers d'une fenêtre 314 de la base 306.

La tirette 312 est actionnable entre une position de verrouillage du bouton 310 et une position de déverrouillage du bouton 310.

En position de verrouillage du bouton 310, la tirette 312 empêche mécaniquement que le bouton 310 soit actionné. En d'autres termes, dans cette position, il n'est pas possible d'envoyer une commande d'ouverture au verrou électromagnétique 311 et, donc, il n'est pas possible de déplacer le tiroir 138 depuis sa position de fonctionnement ou depuis sa position de test dans le module de démarrage moteur 200.

La position de la tirette 312 dans laquelle le bouton 310 est empêché d'être actionné par la tirette correspond donc à une position de verrouillage du tiroir 138.

À la figure 13, la tirette 312 est représenté en position de verrouillage du bouton 310. En pratique, la tirette 312 peut être translaté selon l'axe X par rapport à la base 306 et la position de verrouillage de la tirette est obtenue lorsque la tirette est à droite de la fenêtre 314 de la base.

L'extension de préhension 308 de la poignée est configurée pour être facilement agrippée à la main et ainsi faciliter le déplacement du tiroir 138 au sein du module de démarrage moteur 200, parallèlement à l'axe Y.

En outre, l'extension de préhension 308 comprend un trou débouchant 316. Le trou 316 est configuré pour permettre la mise en place d'un dispositif de verrouillage 318 dans la poignée principale 304.

Des dispositifs de verrouillage 318 sont représentés aux figures 8 et 9, et sont, dans l'exemple, des cadenas.

En pratique, le trou débouchant 316 est configuré pour pouvoir y mettre en place plusieurs dispositifs de verrouillage 318, par exemple les tiges de trois dispositifs de verrouillage.

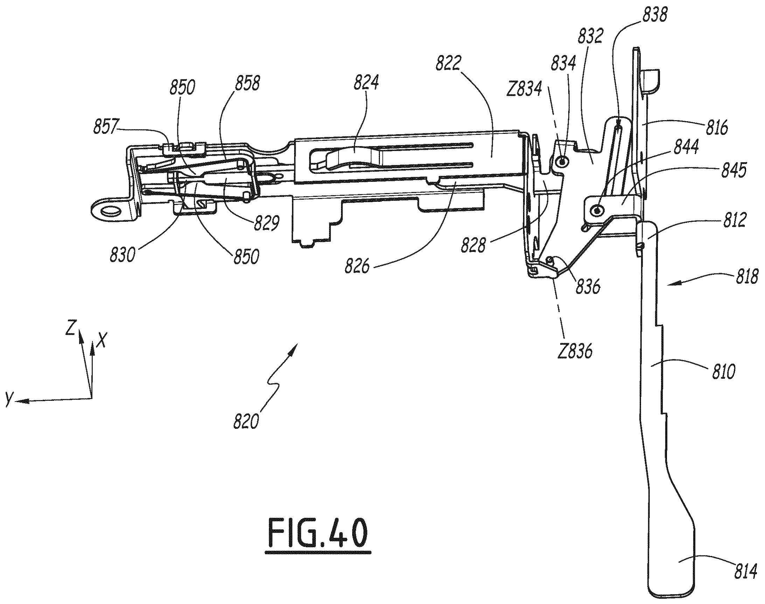

La tirette 312 est fixement attaché à une tige 810 visible à la figure 40, qui s'étend dans la poignée principale 304 du tiroir 138.

La tige 810 comprend une première extrémité libre 812 et une deuxième extrémité libre 814.

La première extrémité 812 de la tige 810 est fixement liée à une plaque de support 816, qui est entraînée en mouvement par la tirette 312. Ainsi, la tirette 312 transmet un mouvement de translation à la tige 810 par l'intermédiaire de la plaque de support 816.

En pratique, la plaque de support 816 est disposée dans la base 306 de la poignée 304, et est mobile en translation dans la base 306 selon un axe parallèle à l'axe X du tiroir 138.

L'extrémité libre 814 de la tige 810 est configurée pour, en position de verrouillage du bouton 310, ne pas s'étendre dans le trou débouchant 316 et pour, en position de déverrouillage du bouton 310, s'étendre dans le trou débouchant 316.

Ainsi, lorsque le dispositif de verrouillage 318 est en place dans le trou débouchant 316, la tirette 312 ne peut pas être actionné vers la position de déverrouillage du bouton 310, car l'extrémité 814 de la tige 810 est empêchée de s'étendre jusque dans le trou débouchant 316 par le dispositif de verrouillage 318, dans l'exemple par l'anse d'un cadenas.

De plus, la tige 810 comprend une découpe 818. Lorsque la tirette 312 est en position de déverrouillage du bouton 310, la découpe 818 est située en vis-à-vis du bouton 310 et n'empêche pas l'activation du bouton. À l'inverse, lorsque la tirette 312 est en position de verrouillage du bouton 310, la découpe 818 est décalée, selon l'axe X, par rapport au bouton 310, et le corps de la tige 810 empêche alors le bouton d'être actionné.

En d'autres termes, lorsque la tirette 312 est en position de verrouillage du tiroir 138 et éventuellement lorsqu'un dispositif de verrouillage 318 est en place dans le trou débouchant 316, le bouton 310 ne peut pas être actionné.

En résumé, lorsque la tirette 312 est en position de verrouillage du bouton 310, il est possible de mettre en place un dispositif de verrouillage 318 dans le trou 316 de la poignée 304, ce qui permet d'empêcher la translation de la tirette 312 vers la position de déverrouillage du bouton 310. Ceci permet de bloquer l'actionnement du bouton 310 et donc l'envoi d'une commande de déverrouillage du tiroir 138 par le verrou électromagnétique 311.

La plaque de support 816, solidaire de, et actionnée par, la tirette 312 est en outre reliée à un verrou mécanique 820, visible sur les figures 36 à 40. Sur les figures 36 et 37, le rail 224 est partiellement masqué, afin de rendre visible une partie du mécanisme du verrou mécanique 820.

Dans l'exemple représenté sur ces figures, le verrou mécanique 820 est représenté du côté d'un rail 224. La description ci-dessous du fonctionnement du verrou mécanique 820 s'applique de manière identique à un verrou mécanique disposé du côté d'un rail 250 et interférant avec ce rail 250 pour empêcher le déplacement du tiroir 138.

Le verrou mécanique 820 est complémentaire du verrou électromagnétique 311 et ces verrous forment ensemble un système de verrouillage du tiroir 138.

De préférence, le verrou mécanique 820 est réalisé dans un matériau métallique, par exemple en acier.

Le verrou mécanique 820 comprend une structure 822, qui est fixée au tiroir 138. Cette structure 822 s'étend principalement parallèlement à l'axe Y, c'est-à-dire parallèlement à l'axe de déplacement du tiroir 138 dans le module de démarrage moteur 200.

En outre, lorsque le tiroir 138 est monté dans le module de démarrage moteur 200, la structure 822 est reçue dans le rail 224.

La structure 822 comprend une languette 824 en forme de bosse qui est en contact avec le rail 224 et permet ainsi de maintenir une continuité électrique entre la structure 822 et le rail 224, lorsque le tiroir est monté dans le module de démarrage moteur. Notamment, cette continuité électrique permet que le tiroir 138 ait une masse commune avec le module de démarrage moteur 200.

Le verrou mécanique 820 comprend une tige 826, qui s'étend principalement parallèlement à l'axe Y et qui est mobile en translation selon cet axe par rapport à la structure 822.

La tige 826 comprend une première extrémité 828, un corps principal 829 et une deuxième extrémité 830.

La deuxième extrémité 830 est fine par rapport au corps principal 829, c'est-à-dire que la dimension de la deuxième extrémité 830, mesurée selon un axe parallèle à l'axe Z du tiroir 138, est plus faible que la dimension du corps principal 829. En d'autres termes, la deuxième extrémité 830 est plus étroite que le corps principal 829.

La première extrémité 828 est reliée à un levier d'actionnement 832, par une liaison pivot 834, d'axe Z834 parallèle à l'axe Z du tiroir 138. Ainsi, le levier d'actionnement 832 est mobile en rotation par rapport à la tige 826.

En outre, le levier d'actionnement 832 est également relié à la structure 822, par une liaison pivot 836, d'axe Z836 parallèle à l'axe Z du tiroir 138. Ainsi, le levier d'actionnement 832 est mobile en rotation par rapport à structure 822. En pratique, l'axe Z836 représente l'axe de rotation du levier d'actionnement 832 par rapport au tiroir 138, puisque la structure 822 est fixe par rapport au tiroir 138.

De plus, un rail de guidage 838 est ménagé dans le levier d'actionnement 832. Le rail de guidage 838 a une forme coudée, c'est-à-dire qu'il comprend deux parties rectilignes obliques l'une par rapport à l'autre, notées respectivement 840 et 842.

Dans le rail de guidage 838 est disposé un ergot 844, fixé à la plaque de support 816. Plus précisément, l'ergot 844 est disposé à l'extrémité d'une patte 845 qui est monobloc avec la plaque de support 816 est pliée à angle droit par rapport à ce support. Ainsi, l'ergot 844 est mobile et son mouvement est entraîné par la tirette 312.

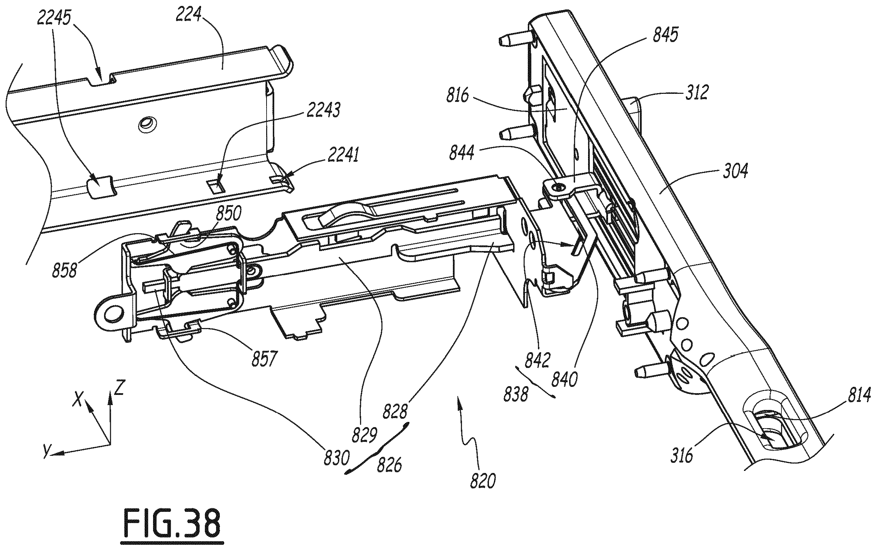

Lorsque la tirette 312 est en position de verrouillage du bouton 310, l'ergot 844 est disposé dans la partie 840 du rail de guidage 838, comme cela est représenté à la figure 38.

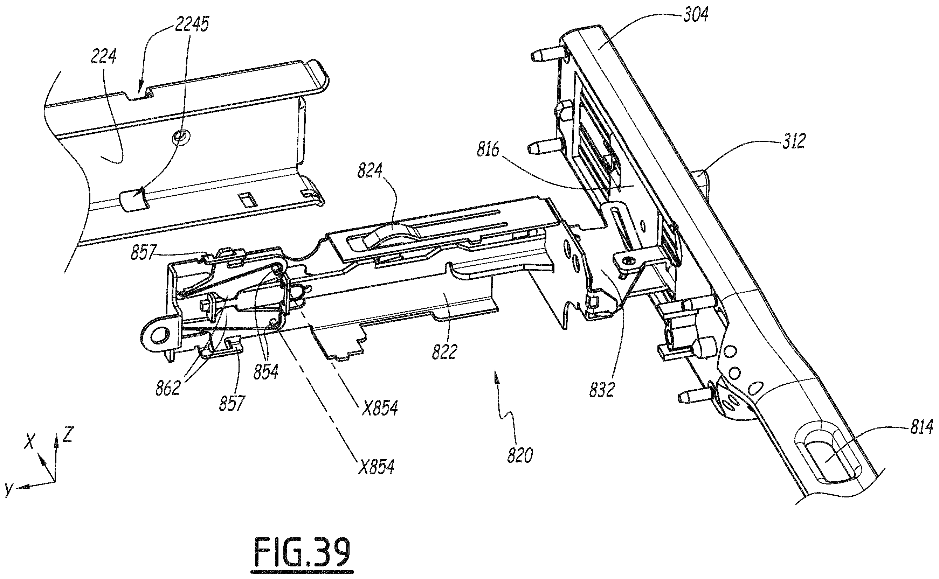

Lorsque la tirette 312 est en position de déverrouillage du bouton 310, l'ergot 844 est disposé dans la partie 842 du rail de guidage 838, comme cela est représenté à la figure 39.

Le passage de la tirette 312 de sa position de verrouillage vers sa position de déverrouillage entraîne une rotation du levier d'actionnement 832 autour de l'axe Z836, du fait de la translation selon un axe parallèle à l'axe X du tiroir de l'ergot 844.

En effet, l'ergot 844 se déplace uniquement en translation, puisqu'il est rattaché à la plaque de support 816 par la patte 845. Cette translation s'effectue sans mouvement du levier d'actionnement 832 lorsque l'ergot 844 est situé dans la première partie 840 du rail de guidage 838. Ensuite, l'ergot 844 force la rotation du levier d'actionnement 832 autour du pivot 836 dès qu'il s'engage dans la deuxième partie 842 du rail de guidage 838, en exerçant un effort sur les parois latérales du rail de guidage.

La rotation du levier d'actionnement 832, sous l'action de l'ergot 844, entraîne un déplacement du pivot 834, qui se rapproche alors, selon un axe parallèle à l'axe Y du tiroir 138, de la plaque de support 816.

Ce déplacement du pivot 834 entraîne alors un déplacement de la tige 826, également selon un axe parallèle à l'axe Y du tiroir 138 et en direction de la plaque de support 816.

Ainsi, le levier d'actionnement 832 permet de convertir un mouvement de translation de la tirette 312 selon un axe parallèle à l'axe X du tiroir 138 en un mouvement de translation de la tige 826 selon un axe parallèle à l'axe Y du tiroir, c'est-à-dire selon une direction perpendiculaire à la direction de la translation de la tirette 312.

De préférence, la liaison entre la tige 826 et le levier d'actionnement 832 comprend un jeu de fonctionnement, selon un axe parallèle à l'axe X du tiroir 138, non-visible sur les figures, qui facilite la conversion de la rotation du levier d'actionnement en translation de la tige.

La deuxième extrémité 830 de la tige 826 coopère avec deux loquets 850, qui appartiennent au verrou mécanique 820. Chaque loquet 850 comprend un corps principal 852, monté pivotant autour d'un pivot 854 dont l'axe de rotation X854 est parallèle à l'axe X du tiroir 138, et un crochet 856.

Chaque loquet 850 est mobile entre une position de verrouillage du tiroir 138, représentée aux figures 36 et 38, et une position de déverrouillage du tiroir 138, représentée aux figures 37 et 39.

Lorsque les loquets 850 sont en position de verrouillage du tiroir 138, leur crochet 856 s'étend dans une encoche 2245 du rail 224. Cette position est visible à la figure 36.

Dans cette position, le tiroir 138 est en position de test et ne peut pas être déplacé vers sa position de fonctionnement ou vers sa position déconnectée, car les crochet 856 butent contre les parois des encoches 2245 du rail 224.

Lorsque les loquets 850 sont en position de déverrouillage du tiroir 138, comme visible à la figure 37, les crochets 856 ne s'étendent pas dans les encoches 2245 et n'empêchent pas le déplacement du tiroir 138 dans le module de démarrage moteur.

Comme visible aux figures 38 et 39, la structure 822 comprend également deux encoches de guidage 857. Chaque encoche 857 est configurée pour guider un crochet 856, c'est-à-dire qu'un crochet 856 s'étend au vers d'une encoche 857, lorsque les loquets 850 sont en position de verrouillage du tiroir 138 et lorsque les loquets sont en position de déverrouillage du tiroir.

Grâce aux encoches de guidage 857, le mouvement des crochets 856 est guidé de sorte à faciliter leur insertion dans les encoches 2245 du rail 224 lorsque les loquets 850 basculent en position de verrouillage du tiroir 138.

Par défaut, les loquets 850 sont en position de déverrouillage du tiroir 138.

En effet, le verrou mécanique 820 comprend en outre un organe élastique 858, qui maintient les loquets 850 en position de déverrouillage du tiroir 138.

Dans l'exemple représenté, cet organe élastique 858 est une languette élastiquement déformable, par exemple réalisé en acier à ressort.

Cette languette élastiquement déformable est globalement en forme de U, avec des branches qui convergent en s'éloignant de son fond. Elle s'étend autour des pivots 854 et ses deux extrémités sont maintenues chacune par une extrémité 860 du corps principal 852 d'un loquet 850.

En variante non-représentée de l'invention, l'organe élastique 858 est un ressort de traction, par exemple hélicoïdal, qui s'étend entre les deux extrémités 860 des corps principaux 852 des deux loquets, selon un axe parallèle à l'axe Z du tiroir 138.

Chaque loquet 850 comprend en outre une came 862 qui est orientée vers l'autre loquet 850. Ainsi, les deux cames 862 sont situées en regard l'une de l'autre.

Lorsque la tirette 312 est en position de déverrouillage du bouton 310, les loquets 850 sont en position de déverrouillage du tiroir 138.

En effet, lorsque la tirette 312 est en position de déverrouillage du bouton 310, la deuxième extrémité 830 de la tige 826 est située entre les cames 862 des loquets 850. Cette deuxième extrémité 830 étant fine, les cames 862 sont rapprochées l'une de l'autre et les crochets 856 sont suffisamment éloignés du rail 224 pour ne pas s'étendre dans les encoches 2245 du rail.

À l'inverse, lorsque la tirette 312 est en position de verrouillage du bouton 310, les loquets 850 sont en position de verrouillage du tiroir 138.

En effet, lorsque la tirette 312 est en position de verrouillage du bouton 310, la tige 826 est déplacée de sorte que le corps principal 829 de la tige est située entre les cames 862 des loquets 850, comme visible à la figure 36. Ainsi, les loquets 850 sont éloignés l'un de l'autre et les crochets 856 s'étendent dans les encoches 2245 du rail 224.

En d'autres termes, lorsque la tirette 312 passe de sa position de déverrouillage à sa position de verrouillage du bouton 310, la tige 826 du verrou mécanique 820 se déplace de sorte à pousser sur les cames 862 et ainsi écarter les crochets 856 dans les encoches 2245 du rail 224 jusqu'à ce que les loquets 850 atteignent leur position de verrouillage du tiroir 138. Le mouvement de la tirette 312 permet donc de déplacer les crochets 856.

Les encoches 2245 du rail 224 sont ménagées à un emplacement spécifique, de manière à ce que les crochets 856 puissent s'y étendre uniquement lorsque le tiroir 138 est en position de test. Le verrou mécanique 820 permet donc de verrouiller le tiroir 138 en position de test.

Ainsi, le verrou mécanique 820 est mobile entre deux positions : une position de verrouillage du tiroir 138, dans laquelle le tiroir est en position de test, et une position de déverrouillage du tiroir 138, dans laquelle le verrou mécanique 820 ne s'oppose pas au mouvement du tiroir 138.

En outre, lorsque la tirette 312 est en position de verrouillage du bouton 310, alors le verrou mécanique 820 est en position de verrouillage du tiroir 138, et lorsque la tirette 312 est en position de déverrouillage du bouton 310, alors le verrou mécanique 820 est en position de déverrouillage du tiroir 138.

Ainsi, lorsque la tirette 312 est en position de verrouillage du bouton 310, il est possible de bloquer mécaniquement le déplacement du tiroir 138 dans le module de démarrage moteur 200, grâce au verrou mécanique 820.

En outre, dans cette position de la tirette 312 un dispositif de verrouillage peut être mis en place dans le trou 316 de la poignée, ce qui empêche alors le passage de la tirette en position de déverrouillage du bouton 310 et donc le passage du verrou mécanique 820 en position de déverrouillage du tiroir 138.

En résumé, la tirette 312 permet d'actionner le verrou mécanique 820.

Le système de verrouillage du tiroir 138 comprend ainsi deux mécanisme de verrouillage distincts, c'est-à-dire le verrou électromagnétique 311 et le verrou mécanique 820.

On comprend que la tirette 312 interagit avec ces deux mécanismes de verrouillage, car, en fonction de sa position, la tirette 312 autorise ou empêche l'activation du bouton 310, qui contrôle le verrou électromagnétique 311, et déplace le verrou mécanique 820 entre ses positions de verrouillage ou de déverrouillage du tiroir 138.

En résumé, le verrou électromagnétique 311 permet de verrouiller le tiroir 138 soit en position de fonctionnement, soit en position de test, et le verrou mécanique 820 permet de verrouiller le tiroir 138 en position de test.

En outre, le verrou électromagnétique 311 ne peut être déverrouillé que lorsque le verrou mécanique 820 est déverrouillé.

Le verrouillage de la position du tiroir 138 en position de test est alors redondant, ce qui est particulièrement avantageux pour sécuriser l'utilisation du tiroir 138 et de la charge électrique 104 qui y est raccordée.

En effet, au cours d'opérations de maintenance de la charge électrique 104 raccordée à un tiroir 138, il est souhaitable que le tiroir 138 soit alimenté en énergie électrique mais que la charge électrique 104 ne soit pas alimentée en énergie électrique, ce qui correspond à la position de test du tiroir. Dans cette position du tiroir, il est alors possible d'intervenir sur la charge électrique 104 raccordée au tiroir sans risque, puisque la charge électrique 104 n'est pas alimentée en énergie électrique.

Pour garantir la sécurité d'un agent de maintenance intervenant sur la charge électrique 104, il est nécessaire de garantir que le tiroir 138 ne puisse pas être basculé depuis sa position de test vers sa position de fonctionnement. Pour cela, l'agent de maintenance met en place un dispositif de verrouillage 318, tel qu'un cadenas, sur le tiroir 138, ce qui empêche le déplacement du tiroir 138. Cette opération est désignée sous le nom de « consignation électrique » de la charge électrique 104, puisqu'il n'est pas possible de rétablir l'alimentation électrique de la charge électrique 104 tant que le dispositif de verrouillage 318 est installé.

Le dispositif de verrouillage 318 empêche ainsi le déverrouillage du tiroir 138.

Puisque le trou traversant 316 est configuré pour pouvoir accueillir plusieurs dispositifs de verrouillage 318, plusieurs agents de maintenance peuvent empêcher le déverrouillage du tiroir 138 en installant chacun un dispositif de verrouillage 318.

Le fait d'avoir un verrouillage redondant est alors plus sécurisé, car en cas de défaillance de l'un des deux verrous, le basculement du tiroir 138 en position de fonctionnement reste impossible.

En outre, le verrou électromagnétique 311 et le verrou mécanique 820 fonctionnent tout deux indépendamment des éléments contenus dans le tiroir 138. Ainsi, le système de verrouillage décrit ci-dessus est utilisable pour de nombreux types de tiroir de contrôle-commande, indépendamment des fonctions que comprennent ces tiroirs.

En variante, le tiroir 138 comprend en outre un mécanisme à commande manuelle permettant de déverrouiller le verrou électromagnétique 311 en l'absence de tension électrique, de sorte à permettre le déplacement du tiroir depuis sa position de fonctionnement vers sa position de test, ou depuis sa position de test vers sa position déconnectée.

En variante, le tiroir 138 ne comprend pas de verrou mécanique 820 et le système de verrouillage du tiroir est alors formé uniquement du verrou électromagnétique 311.

En variante, le bouton 310 est remplacé par un autre dispositif de commande, comme par exemple un écran tactile ou une poignée.

En variante, le verrou électromagnétique 311 est contrôlé par un autre dispositif que le bouton 310, notamment par un dispositif distant. Dans une telle variante, les commandes d'ouverture du verrou électromagnétique 311 sont par exemple émises par un ordinateur distant, pouvant être l'ordinateur 130, ou par exemple par le module de communication 134.

La partie frontale 300 du tiroir 138 comprend en outre une poignée secondaire 320.

La poignée secondaire 320 comprend une base 322 et une extension de préhension 324.

L'extension de préhension 324 de la poignée secondaire est identique à l'extension de préhension 308 de la poignée principale 304.

La base 322 de la poignée secondaire 320 diffère de la base 306 de la poignée principale en ce que la base 322 ne comprend pas de bouton, ni de tirette.

En pratique, seuls les tiroirs 138 d'une hauteur de 4U, 5U et 6U comprennent une poignée secondaire 320. Les tiroirs d'une hauteur de 1U, 2U et 3U comprennent seulement la poignée principale 304.

La poignée principale 304 a une hauteur égale à 1U, afin de pouvoir être montée sur un tiroir de hauteur 1U.

La partie frontale 300 comprend des grilles d'aération 326. Les grilles d'aération sont en pratique des perforations ménagées dans une zone de la partie frontale et qui permettent la circulation d'air entre l'extérieur du tiroir 138 et l'intérieur du tiroir.

Chaque grille d'aération 326 a une hauteur égale à 1U.

En pratique, la partie frontale d'un tiroir d'une hauteur N×U, avec N un entier compris entre 1 et 6, comprend N grilles d'aération. Par exemple, la partie frontale 326 du tiroir de hauteur 4U des figures 13 et 14 comprend quatre grilles d'aération 326 et la partie frontale du tiroir de hauteur 2U visible à la figure 8 comprend deux grilles d'aération 326.

Le tiroir 138 comprend une base 328, qui a une hauteur égale à 1U et un capot 330.

La base 328 est la structure principale du tiroir. La partie frontale du tiroir est fixée à la base 328 et le tiroir est monté et fixé dans le module de démarrage moteur 200 par la base 328.

En pratique, le verrou électromagnétique 311 est disposé dans la base 328 du tiroir.

La base 328 est horizontale et les éléments contenus dans le tiroir, qui sont détaillés ci-après, y sont fixés.

Dans l'exemple représenté sur les figures 8, 9, 13 et 14, la base 328 est située en bas du tiroir 138.

Le capot 330 est une structure de protection, qui permet de fermer le tiroir 138 et de protéger les éléments contenus dans le tiroir. En pratique, le capot 330 a une forme qui dépend de la hauteur du tiroir 138. Ainsi, à chaque hauteur de tiroir correspond une hauteur de capot.

Lorsque le tiroir 138 a une hauteur égale à 1 U, le capot 330 est formé par une plaque plane et horizontale 332. Un tel exemple est visible à la figure 9. Dans un tel exemple, on considère que la hauteur du capot 330 est de 0×U.

Comme visible aux figures 13 et 14, lorsque le tiroir 138 a une hauteur supérieure à 1U, le capot 330 comprend une plaque plane horizontale 332, deux parois latérales 334 qui s'étendent depuis deux bords opposés de la plaque plane vers la base 328 et qui sont parallèles à un plan formé par les axes Y et Z, et une paroi arrière 336 qui s'étend depuis un bord de la plaque plane opposé à la partie frontale 300 du tiroir vers la base 328 et qui est parallèle à un plan formé par les axe X et Z. Dans une telle configuration, la hauteur du capot 330 est inférieure de 1U à la hauteur du tiroir 138.

Ainsi, la hauteur du capot 330 est comprise entre 0U et 5U.

En pratique, dans l'exemple des figures 13 et 14 qui correspond à un tiroir de hauteur 4U, le capot 330 a une hauteur égale à 3U. Ainsi, lorsqu'il est positionné sur la base 328, le capot 330 s'étend depuis la base jusqu'en haut du tiroir 138, c'est-à-dire que la plaque plane 332 du capot 330 est au niveau du bord supérieur de la partie frontale 300.

Dans le cas d'un tiroir d'une hauteur égale à 2U ou 3U, la paroi arrière 336 du capot 330 comprend un orifice de ventilation 338.

Dans le cas d'un tiroir d'une hauteur égale à 4U, 5U, ou 6U, la paroi arrière 336 du capot 330 comprend deux orifices de ventilation 338.

En variante, la paroi arrière 336 du capot d'un tiroir de hauteur 6U comprend trois orifices de ventilation 338.

Sur les figures 15 et 16, un tiroir 138 de hauteur égale à 1U est représenté sans son capot 330 qui est le même que celui représenté à la figure 9.

On voit sur la figure 15 la partie frontale 300 du tiroir 138 dont la tirette 312 est en position de déverrouillage du bouton 310, c'est-à-dire que la tirette est à gauche de la fenêtre 314 de la base 306 et que le bouton 310 peut être actionné pour déverrouiller le tiroir 138 du module de démarrage moteur 200.

La base 328 comprend une plaque de support 340. La plaque de support 340 est en forme de « U », c'est-à-dire qu'elle comprend une partie principale 342, horizontale, qui est en pratique le fond du tiroir 138, et deux parois verticales 344, qui s'étendent parallèlement au plan formé par les axes Y et Z.

La base 328 comprend, en outre, deux structures latérales 346. Les structures latérales 346 sont fixées sur l'extérieur des parois verticales 344 de la plaque de support 340 par des moyens de fixation tels que par exemple des vis 347. En pratique, les structures latérales 346 s'étendent depuis la partie frontale 300 du tiroir 138 selon l'axe Y jusqu'à l'arrière du tiroir, c'est-à-dire jusqu'à une partie arrière 348 du tiroir opposée à sa partie frontale, cette partie arrière 348 du tiroir appartenant également à la base 328 du tiroir 138.

Les structures latérales 346 appartiennent donc à la base 328 du tiroir 138.

En pratique, la structure 822 du verrou mécanique 820 est solidaire d'une structure latérale 346.

Chaque structure latérale 346 comprend des roulettes 350, de préférence deux roulettes 350.

Les roulettes 350 ont chacune un axe X350 parallèle à l'axe X et sont configurées pour rouler dans les rails 224 de la structure 202 du module de démarrage moteur et dans les rails 250 de l'unité de protection 140. Ainsi, le diamètre des roulettes 350 est inférieur à l'écartement entre les deux bords des rails 224 et 250.

En pratique, chaque tiroir 138 est monté dans le volume V1 du module de démarrage moteur 200. Pour cela, une première structure latérale 346 est insérée dans un premier rail parmi les rails 224 et 250 et une seconde structure latérale 346 est insérée dans un second rail parmi les rails 224 et 250 de la même paire de rails, puis le roulement des roulettes 350 sur les rails permet de faire entrer le tiroir dans le module de démarrage moteur et de l'en ressortir.

Ainsi, le tiroir 138 est mobile dans le module de démarrage moteur entre les trois positions principales du tiroir, grâce aux structures latérales 346.

Chaque structure latérale 346 comprend en outre un contact latéral mobile 352, qui permet de connecter le tiroir 138 à une interface de communication 353 qui appartient soit au module d'entrées-sorties 206 soit à l'unité de protection 140 et dont le fonctionnement est expliqué ci-après.

La partie arrière 348 du tiroir 138 s'étend entre les deux structures latérales 346.

Dans le cas d'un tiroir de hauteur 1U, le capot 330 s'étend de la partie frontale 300 à la partie arrière 348 et entre les deux structures latérales 346.

Dans le cas d'un tiroir de hauteur supérieure ou égale à 2U, les parois latérales 334 du capot 330 s'étendent jusqu'aux parois verticales 344 et la paroi arrière 336 du capot s'étend jusqu'à la partie arrière 348.

La partie arrière 348 comprend un groupe de connecteurs amont 354, un groupe de connecteurs aval 356 et un orifice de ventilation 358.

Les connecteurs amont 354 et aval 356 sont donc montés sur la base 328 du tiroir 138.

Comme mieux visible à la figure 16, l'orifice de ventilation 358 est située entre le groupe de connecteurs amont 354 et le groupe de connecteurs aval 356, selon l'axe longitudinal X du tiroir 138. Avantageusement, l'orifice de ventilation 358 est centré par rapport à la base 328, selon l'axe X. De plus, les groupes de connecteurs amont 354 et aval 356 sont disposés de part et d'autre de l'orifice de ventilation 358 de manière symétrique.

Lorsqu'un tiroir est monté dans le module de démarrage moteur 200, l'orifice de ventilation 358 est situé en regard d'un orifice de ventilation 214 du support arrière 210.

En pratique, la partie arrière 348 comprend quatre connecteurs amont 354 et quatre connecteurs aval 356.

Lorsque le tiroir 138 est en position de fonctionnement, les connecteurs amont 354 sont embrochés sur les quatre sorties électriques 248 d'un groupe de sorties électriques 246 de l'unité de protection 140. Ainsi, le tiroir 138 est alimenté en énergie électrique provenant d'une ligne d'alimentation électrique, par l'intermédiaire de l'unité de protection 140. En d'autres termes, l'unité de protection 140 est une source d'électricité pour le tiroir 138.

Lorsque le tiroir 138 est en position de fonctionnement, les connecteurs aval 356 sont embrochés sur un module de raccordement externe 208. Ainsi, le tiroir 138 alimente en énergie électrique un module de raccordement externe 208 et permet d'alimenter une charge électrique 104 lorsqu'une telle charge est raccordée au module de raccordement externe 208.

Lorsque le tiroir 138 est en position de test ou en position déconnectée, les connecteurs amont 354 et aval 356 sont débrochés respectivement des sorties électriques 248 de l'unité de protection 140 et du module de raccordement externe 208.

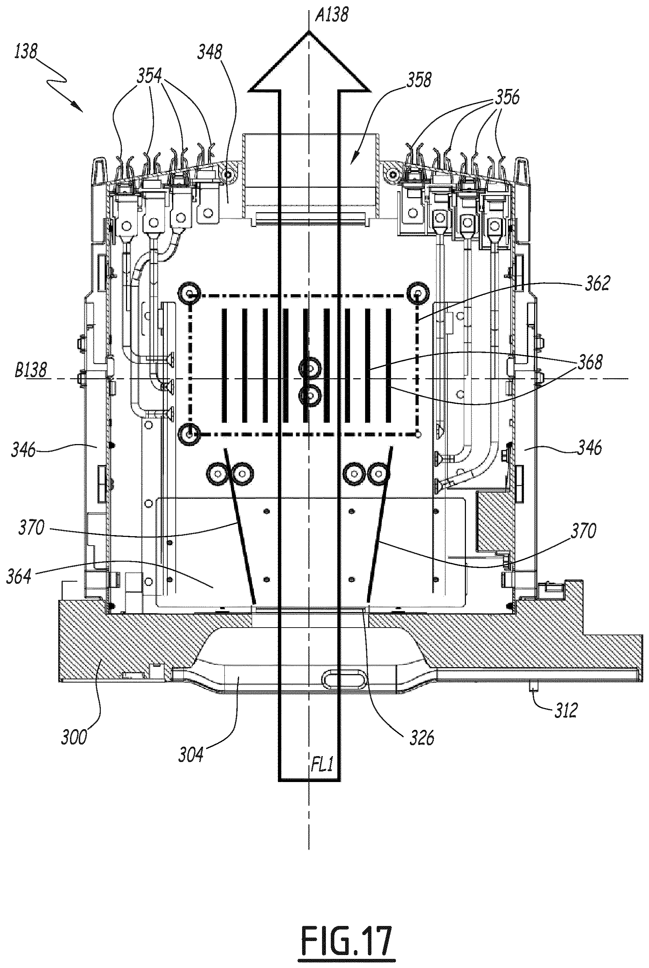

Le tiroir 138 comprend des éléments fonctionnels 362, non-représentés en détail mais dont l'emplacement est marqué par des pointillés à la figure 17. De manière connue, ces éléments fonctionnels 362 permettent de contrôler la charge électrique 104, en pratique un moteur électrique, et permettent le fonctionnement du tiroir 138.

Ces éléments fonctionnels comprennent notamment :
- au moins un contacteur ;
- un relai de protection thermique, par exemple un relai électromécanique à bilame ou encore un relai électronique, qui a pour rôle de protéger le moteur électrique alimenté par le tiroir 138 d'éventuelles surcharges pouvant se produire notamment au démarrage du moteur ;
- des capteurs de fonctionnement du tiroir 138, tels que par exemple des capteurs de tension de l'alimentation électrique provenant des connecteurs amont 354 ; et
- des composants électroniques configurés pour collecter des signaux provenant de capteurs de fonctionnement de la charge électrique 104, disposés sur, ou à proximité de, la charge électrique 104, tels que par exemple des sondes de température ou des capteurs de vitesse.

En pratique, le contacteur est directement raccordé aux connecteurs amont 354 par des barres de connexion 360 et aux connecteurs aval 356 par des barres de connexion aval 361. En pratique, il est prévu une barre de connexion 360 ou 361 par connecteur 354 ou 356. Sur les figures 15 et 16, seules trois barres de connexion sont représentées par souci de simplification, à savoir celles des phases du courant.

Ainsi, le contacteur peut, de manière connue, sélectivement interrompre ou permettre le passage d'un courant électrique entre les connecteurs amont 354 et les connecteurs aval 356. Grâce au contacteur, il est possible d'alimenter en énergie électrique la charge électrique 104, ce qui permet par exemple de faire démarrer puis de faire fonctionner un moteur électrique lorsque le passage d'un courant est permis, et d'arrêter le fonctionnement d'un tel moteur lorsque le courant est interrompu.

En outre, le tiroir 138 peut contenir plusieurs contacteurs, ce qui permet par exemple de contrôler la tension délivrée à la charge électrique 104 afin de contrôler, par exemple, la vitesse de rotation d'un moteur ; ou encore de contrôler le sens de rotation d'un moteur.

Le tiroir 138 comprend également une carte électronique de contrôle 364. La carte électronique de contrôle est fixée à plaque de support 340.

La carte électronique de contrôle 364 est reliée au module de communication 134 de la colonne de démarrage moteur 110. Elle permet de commander les éléments fonctionnels 362 du tiroir 138, tels que le contacteur, le relai de protection thermique, l'afficheur 302 selon les commandes provenant du module de communication. Elle permet également de regrouper les informations provenant des capteurs de fonctionnement du tiroir et les informations provenant des composants électroniques configurés pour collecter des signaux provenant des capteurs de fonctionnement de la charge électrique, avant de les analyser et de les transmettre au module de communication 134.

En fonction de cette analyse des informations provenant des capteurs de fonctionnement du tiroir et de la charge électrique, la carte électronique de contrôle 364 peut adapter sa commande des éléments fonctionnels 362, par exemple en donnant l'ordre au contacteur d'interrompre l'alimentation de la charge électrique lorsqu'un capteur de fonctionnement remonte un dysfonctionnement de la charge électrique.

Ainsi, grâce aux éléments fonctionnels 362 et à la carte électronique 364, chaque tiroir 138 alimente une charge électrique 104, commande cette charge électrique et surveille cette charge électrique. Chaque tiroir 138 a donc simultanément un rôle d'alimentation, de commande et de surveillance d'une charge électrique 104.

La carte électronique de contrôle 364, les éléments fonctionnels 362 et le verrou électromagnétique 311 du tiroir sont alimentés en première tension électrique auxiliaire.

Le verrou électromagnétique 311 est en pratique commandé par la carte électronique de contrôle 364 et le bouton 310 communique avec la carte électronique de contrôle.

Lorsque le bouton 310 est actionné, il envoie un signal de commande à la carte électronique de contrôle 364, demandant l'activation du verrou électromagnétique 311 de sorte à basculer en position de déverrouillage du tiroir 138.

Dans ce cas, la carte électronique de contrôle 364 effectue des opérations de vérification, après la réception du signal provenant du bouton 310 et avant de basculer le verrou électromagnétique en position de déverrouillage du tiroir.

Ces opérations de vérification consistent, par exemple, à analyser les informations provenant des capteurs de fonctionnement du tiroir et des capteurs de fonctionnement de la charge électrique 104, de sorte à basculer le verrou électromagnétique 311 en position de déverrouillage du tiroir seulement si les états de fonctionnement du tiroir, par exemple des éléments fonctionnels 362, et/ou de la charge électrique sont satisfaisants.

La carte électronique de contrôle est configurée pour que si, au cours de ces opérations de vérification, une défaillance du tiroir 138, par exemple de l'un des éléments fonctionnels 362, ou de la charge électrique 104, par exemple de l'un des capteurs de fonctionnement de la charge électrique, est détectée, alors le verrou 311 ne soit pas basculé en position de déverrouillage du tiroir et pour que, de préférence, un message d'information sur cette défaillance soit affiché sur l'afficheur 302.

Ainsi, grâce au verrou électromagnétique 311 dont l'ouverture est commandée par le bouton 310 et validée par la carte électronique de contrôle 364, le tiroir 138 ne peut être déverrouillé, c'est-à-dire déplacé depuis sa position de test ou depuis sa position de fonctionnement, qu'après validation du bon état de fonctionnement du tiroir 138 et/ou de la charge électrique 104.

Cette validation préalable au déverrouillage du tiroir 138 est particulièrement avantageuse, car elle permet de sécuriser l'utilisation de l'armoire électrique 100 et de la charge électrique 104 en assurant le bon fonctionnement du tiroir et de la charge électrique avant leur raccordement.

Le choix de la hauteur d'un tiroir 138 - c'est-à-dire de 1U à 6U - dépend de la puissance devant être fournie à la charge électrique 104. En effet, plus la puissance consommée par la charge électrique 104 est élevée et plus les dimensions du contacteur et des autres éléments fonctionnels sont importantes.

Ainsi, un contacteur contrôlant un moteur de faible puissance, par exemple jusqu'à 11 kW, sera peu encombrant et pourra être installé dans un tiroir de hauteur 1U, alors qu'un contacteur contrôlant un moteur de forte puissance, par exemple 75 kW, sera plus encombrant et devra être installé dans un tiroir de hauteur 6U. Un contacteur contrôlant un moteur de puissance intermédiaire, par exemple 30 kW, sera par exemple installé dans un tiroir de hauteur 3U.

La conception des tiroirs 138 décrite ici est avantageuse, car la base 328, qui constitue la structure principale du tiroir permettant son installation dans le module de démarrage moteur et qui porte l'ensemble des connecteurs électriques - connecteurs amont et avant, contacts latéraux - et des éléments fonctionnels 362 du tiroir 138, est commune aux six hauteur de tiroir 138.

Grâce à la partie frontale 300 et au capot 330, dont les hauteurs sont adaptées aux dimensions des éléments fonctionnels 362, le tiroir 138 est modulaire.

Ainsi, il est simple d'adapter la hauteur d'un tiroir 138 aux dimensions d'un contacteur et des autres éléments fonctionnels, car seuls la partie frontale 300 et le capot 330 diffèrent entre des tiroirs 138 de hauteur différente.

Les éléments fonctionnels 362 d'un tiroir 138 chauffent lors de leur fonctionnement, et notamment le contacteur et le relai de protection thermique. La chaleur ainsi produite réchauffe l'air contenu dans le tiroir 138, qui doit alors être renouvelé pour conserver une température intérieure compatible avec le fonctionnement en conditions normales des éléments fonctionnels du tiroir.

Un flux d'air FL1 traversant un tiroir 138 est représenté à la figure 17.

Sur cette figure, l'emplacement des éléments fonctionnels 362 du tiroir 138 est représenté par des pointillés. On constate que le flux d'air FL1 passe au niveau de ces éléments fonctionnels, ce qui permet leur refroidissement par échange thermique. En pratique, lorsque le flux d'air FL1 passe au niveau des éléments fonctionnels, le flux d'air refroidit les éléments fonctionnels en se réchauffant.

La quantité de chaleur produite par les éléments fonctionnels 362 du tiroir dépend notamment de la puissance électrique du moteur 104 contrôlé par ce tiroir.

Dans le cas d'un moteur électrique de faible puissance, par exemple jusqu'à 11 kW, la chaleur produite sera évacuée du tiroir 138 de hauteur 1U contrôlant ce moteur par le flux d'air FL1 qui est causé par convection naturelle.

Cette convection naturelle se produit grâce à la grille d'aération 326 de la partie frontale 300 du tiroir 1U et à l'orifice de ventilation 358 de la partie arrière 348 du tiroir.

En pratique, le flux d'air FL1 pénètre par la grille d'aération 326 et ressort par l'orifice de ventilation 358.

Dans le cas d'un moteur électrique de plus forte puissance, par exemple comprise entre 11 kW et 75 kW, le tiroir 138 contrôlant ce moteur aura une hauteur comprise entre 2U et 6U, selon la puissance du moteur. Dans une telle configuration, le flux d'air FL1 permettant le refroidissement du tiroir pénètre par les grilles d'aération 326 de la partie frontale 300 et ressort d'une part par l'orifice de ventilation 358 de la partie arrière 348 et d'autre part par le ou les orifice(s) de ventilation 338 de la paroi arrière 336 du capot 330.

En d'autres termes, l'orifice de ventilation 358 de la partie arrière 348 et le ou les orifice(s) de ventilation 338 de la paroi arrière 336 du capot 330 forment ensemble une zone de ventilation arrière 359 du tiroir 138. La zone de ventilation arrière du tiroir est donc située au niveau de la partie arrière 348 du tiroir.

Dans le cas d'un tiroir 138 de hauteur 1U, la zone de ventilation arrière 359 du tiroir est assimilée à l'orifice de ventilation 358 de la partie arrière 348 du tiroir.

En pratique, dans le cas d'un tiroir de hauteur comprise entre 2U et 6U, le tiroir 138 comprend un ou plusieurs ventilateurs 366 pour forcer la circulation du flux d'air FL1 dans le tiroir 138.

Chaque ventilateur 366 est disposé sur la paroi arrière 336 du capot et a une hauteur légèrement inférieure à 2U. Les ventilateurs 366 sont configurés pour expulser l'air contenu dans le tiroir 138 vers l'extérieur du tiroir.

Lorsque le tiroir 138 a une hauteur égale à 2U ou à 3U, il comprend un ventilateur 366. Ce ventilateur est disposé à cheval entre l'orifice de ventilation 358 de la partie arrière 348 du tiroir et l'orifice de ventilation 338 du capot 330. En d'autres termes, ce ventilateur est disposé sur la zone de ventilation arrière 359 du tiroir.

Lorsque le tiroir 138 a une hauteur égale à 4U, comme visible à la figure 14, 5U ou 6U, il comprend deux ventilateurs 366, superposés, dont un premier est disposé à cheval entre l'orifice de ventilation 358 de la partie arrière 348 du tiroir et un premier orifice de ventilation 338 du capot et un second est disposé entièrement sur un deuxième orifice de ventilation 338 du capot. En d'autres termes, ces deux ventilateurs sont disposés sur la zone de ventilation arrière 359 du tiroir.

Lorsque le tiroir 138 a une hauteur égale à 6U, il comprend de manière optionnelle un troisième ventilateur 366 disposé sur un troisième orifice de ventilation 338.

Grâce au(x) ventilateur(s) 366, le renouvellement de l'air dans le tiroir 138 est amélioré et le refroidissement des éléments fonctionnels est plus efficace.

Avantageusement, la carte électronique de contrôle 364 contrôle le ou les ventilateur(s) 366 pour optimiser leur fonctionnement.

De façon avantageuse, la carte électronique de contrôle 364 est configurée pour couper les ventilateurs 366 lorsque les éléments fonctionnels du tiroir 138 ne génèrent pas de chaleur, notamment lorsque la charge électrique 104 n'est pas alimentée en énergie électrique.

Selon une autre approche avantageuse, le tiroir 138 comprend un capteur de température mesurant la température intérieure du tiroir 138 et la vitesse de rotation des ventilateurs 366 est adaptée en fonction de la température intérieure du tiroir 138, c'est-à-dire que la vitesse de rotation augmente lorsque la température est élevée pour accélérer le renouvellement d'air et diminue lorsque la température intérieure du tiroir est satisfaisante.

Avantageusement, le tiroir 138 comporte un ou plusieurs radiateurs 368, dont un est représenté à la figure 17, qui sont disposés sur un ou plusieurs éléments fonctionnels 362 et qui permettent d'augmenter l'échange de chaleur avec le flux d'air FL1 circulant dans le tiroir 138, améliorant ainsi le refroidissement de ces éléments fonctionnels.

Dans ce cas, de manière avantageuse, le tiroir 138 comporte des déflecteurs 370 qui concentrent le flux d'air FL1 sur ces radiateurs 368. En pratique, les déflecteurs 370 sont par exemple des tôles qui dirigent le flux d'air le long de sa traversée du tiroir. La présence de déflecteurs dans le tiroir 138 conduit à modifier l'écoulement du flux d'air dans le tiroir 138, sans modifier sa direction principale, c'est-à-dire de la partie frontale 300 vers la zone de ventilation arrière 359.

Le fait que l'air pénètre dans le tiroir 138 par sa partie frontale 300 et en ressorte par sa zone de ventilation arrière 359 est avantageux. En effet, ces deux parties sont disposées à deux extrémités du tiroir, selon l'axe Y, et le flux d'air circulant dans le tiroir circule alors directement entre ces deux extrémités selon l'axe Y, c'est-à-dire qu'il ne subit pas de variation significative de direction, ce qui est plus efficace qu'une circulation d'air dans laquelle l'entrée d'air et la sortie d'air seraient situées sur une même face, par exemple la face frontale. En effet, toute variation de la direction d'écoulement d'un flux d'air ralentit ce flux d'air.

En d'autres termes, le flux d'air FL1 traverse le tiroir de part en part sans variation notable de direction. Par « sans variation notable », on entend que le flux d'air FL1 ne suit pas de courbe ayant une amplitude angulaire de plus de 30°, de préférence de plus de 15°.

En pratique, le flux d'air FL1 est perturbé lorsqu'il entre en contact avec les éléments fonctionnels 362, mais ces perturbations ne constituent pas un changement de la direction principale du flux d'air et sont nécessaires pour assurer un échange thermique entrai l'air et les éléments fonctionnels.

Par ailleurs, la hauteur cumulée des grilles d'aération 326 de la partie frontale 300 est sensiblement égale à la hauteur de la zone de ventilation arrière 359 du tiroir 138. En d'autres termes, la zone de ventilation arrière du tiroir 359 ainsi que les grilles d'aération 326 d'un tiroir 138 s'étendent sur toute la hauteur du tiroir, quelle que soit la hauteur du tiroir. Ainsi, le flux d'air FL1 traverse le tiroir 138 de part en part sans variation de direction verticale, c'est-à-dire que le flux d'air FL1 est horizontal.

Grâce à cette gestion thermique basée sur un flux d'air traversant le tiroir 138 de part en part, le refroidissement des éléments fonctionnels du tiroir 138 est amélioré.

En outre, cette gestion thermique basée sur un flux d'air traversant un élément de part en part permet également de refroidir le module de communication 134.

En effet, le module de communication 134 comprend une grille d'aération avant 180, sur sa face avant 176, et une grille d'aération arrière 184, sur sa face arrière 178, qui ont un rôle analogue respectivement aux grilles d'aération 326 de la partie frontale 300 des tiroirs 138 et à l'orifice de ventilation 358 de la partie arrière 348 des tiroirs 138.

La grille d'aération arrière 184 a donc un rôle analogue à la zone de ventilation arrière 359 du tiroir 138.

Le module de communication 134 est donc également traversé de part en part par un flux d'air FL1, sans variation notable de direction.

Ce flux d'air permet de refroidir les éléments produisant de la chaleur dans le module de communication 134, en pratique le ou les blocs d'alimentation 150 et la carte électronique 188.

En variante non-représentée de l'invention, le module de communication 134 comprend, en outre, au moins un ventilateur monté pour forcer la circulation du flux d'air FL1 dans le module de communication et disposé sur la grille d'aération arrière 184 et/ou sur la grille d'aération avant 180. De préférence, ce ou ces ventilateurs sont contrôlés par la carte électronique 188.

En variante non-représentée de l'invention, le module de communication 134 comprend, en outre, au moins un radiateur, disposé sur le ou les blocs d'alimentation 150 ou sur la carte électronique 188. De préférence, le module de communication 134 comprend en outre au moins un déflecteur, configuré pour diriger le flux d'air FL1 vers le ou les radiateurs.

On désigne par « unité fonctionnelle » une unité qui est soit un module de communication 134, soit une unité de contrôle-commande 138, dans l'exemple un tiroir 138, et qui est refroidie par le flux d'air FL1.

Le tiroir 138 a une largeur, mesurée selon l'axe Y, égale à ℓ2, c'est-à-dire 400 mm. Cette largeur est mesurée entre la partie frontale 300 et la partie arrière 348 du tiroir.

Lorsque le module de démarrage moteur 200 est installé dans une armoire 100 de largeur ℓ2 égale à 400 mm comme dans le mode de réalisation de la figure 4, la partie arrière 348 de chaque tiroir est située au niveau de la face arrière F2 de l'armoire 100. En outre, la tôle 166 formant la face arrière de l'armoire 100 comprend des grilles d'aération 372, visibles à la figure 4. Ces grilles d'aération sont disposées en vis-à-vis de la zone de ventilation 359 de chaque tiroir. Ainsi, la zone de ventilation 359 d'un tiroir 138 relie l'intérieur de ce tiroir avec l'extérieur de l'armoire, au-travers de ces grilles d'aération 372. Dans une telle configuration, l'air circulant dans le tiroir 138 ressort directement en-dehors de l'armoire 100, par sa face arrière.

Lorsque le module de démarrage moteur 200 est installé dans une armoire 100 de largeur ℓ1 égale à 600 mm comme dans les modes de réalisation des figures 1 à 3 et 5, la partie arrière 348 de chaque tiroir est située au niveau de l'interface entre la zone fonctionnelle 156, qui comprend le module de démarrage moteur 200, et la zone de gestion thermique 162. Ainsi, la zone de ventilation 359 relie l'intérieur du tiroir 138 avec la zone de gestion thermique 162 de l'armoire. Dans une telle configuration, le flux d'air FL1 circulant dans le tiroir 138 ressort dans la zone de gestion thermique 162 de l'armoire.

De plus, dans une telle configuration, l'air circulant dans le module de communication 134 ressort également dans la zone de gestion thermique 162 de l'armoire, par la grille d'aération arrière 184 du module de communication.

La zone de gestion thermique 162 est une colonne essentiellement vide, qui s'étend sur toute la hauteur de l'armoire 100. Ainsi, l'air sortant des tiroirs 138, chauffé par les éléments fonctionnels 362 de ces tiroirs, monte par convection jusqu'en haut de la zone de gestion thermique 162, tout comme l'air sortant du module de communication 134.

En outre, la zone de gestion thermique 162 comprend une face supérieure, en haut de l'armoire 100, qui est en pratique une partie de la face supérieure F4 de l'armoire. Cette face supérieure comprend une grille d'évacuation, non-représentée. Cette grille d'évacuation permet à l'air chaud de sortir de la zone de gestion thermique 162. Ainsi, un flux d'air FL2 provenant des tiroirs 138 et du module de communication 134 monte par la zone de gestion thermique 162 et sort par le haut de la zone de gestion thermique 162, c'est-à-dire par la face supérieure F4 de l'armoire 100, comme représenté à la figure 2.

En d'autres termes, la zone de gestion thermique 162 a le rôle d'une cheminée d'évacuation de l'air chaud provenant des tiroirs 138 et du module de communication 134.

De manière optionnelle, la face supérieure de la zone de gestion thermique, qui correspond à la face supérieure F4 de l'armoire, comprend un ventilateur d'extraction 374, qui aspire l'air contenu dans la zone de gestion thermique pour le rejeter à l'extérieur de l'armoire 100. Grâce à un tel ventilateur, l'évacuation du flux d'air chaud FL2 est facilitée.

Grâce à la zone de gestion thermique 162, qui permet une extraction de l'air chaud provenant de l'ensemble des tiroirs 138, ainsi que du module de communication 134, par le haut de l'armoire 100, il est possible d'installer l'armoire 100 de manière à ce que sa face arrière soit obstruée, par exemple en positionnant l'armoire contre un mur, ou dos-à-dos avec une seconde armoire 100, sans nuire à la gestion thermique des tiroirs 138 et du module de communication 134.

En variante, les ventilateurs 366 sont disposés sur les grilles d'aération 326 de la partie frontale du tiroir 138 et facilitent l'entrée du flux d'air FL1 dans le tiroir.

En variante, les ventilateurs 366 sont disposés à la fois sur les grilles d'aération 326 de la partie frontale du tiroir et sur la zone de ventilation arrière 359.

En outre, lorsque l'armoire 100 ne comprend pas de zone de câblage 160, comme dans le mode de réalisation de la figure 5, le raccordement des câbles 139 est effectué dans la zone de gestion thermique 162, mais les câbles 139 ne sont pas disposés dans le flux d'air FL2 et n'impactent donc pas le refroidissement de l'armoire. En effet, les câbles sont situés à l'arrière de la zone de raccordement 158 alors que le flux d'air FL2 est situé à l'arrière de la zone fonctionnelle 156.

En variante, la gestion thermique d'un tiroir 138 et d'une armoire 100 comprenant un ou plusieurs tiroirs 138 décrite ci-avant est appliquée à des tiroirs 138 installés dans des colonnes de répartition de courant ou de de pilotage de charge.

En variante, la gestion thermique d'un tiroir 138 et d'une armoire 100 comprenant un ou plusieurs tiroirs 138, décrite ci-avant et comprenant l'utilisation des grilles 326 et des orifices 338 et 358, est appliquée à des unités de contrôle-commande 138 qui sont des unités fixes de l'armoire.

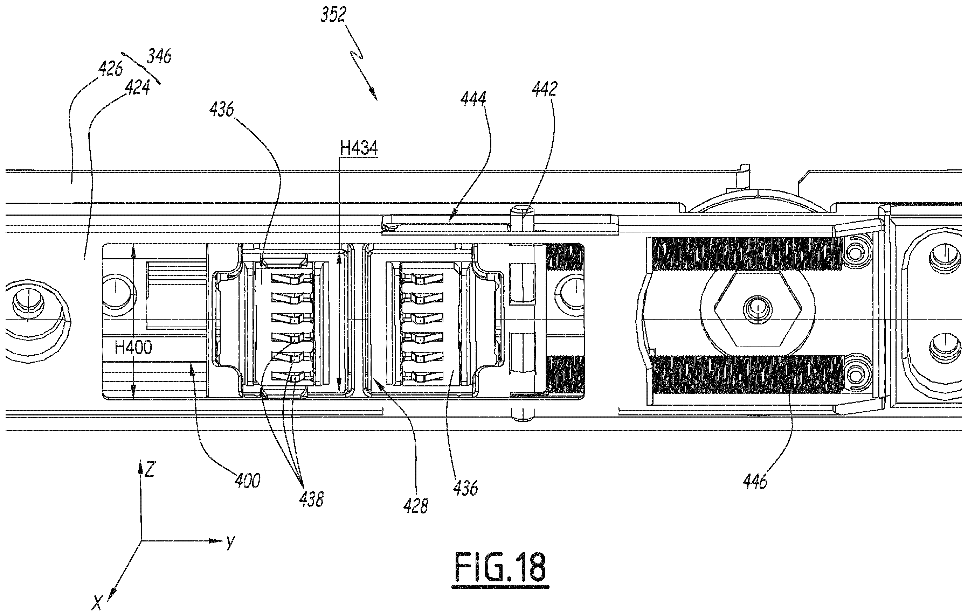

La figure 18 est une vue en perspective d'un contact latéral mobile 352 d'une structure latérale 346. Chaque contact latéral mobile 352 est en pratique disposé au niveau d'une fenêtre 400 ménagée dans la structure latérale 346 et d'une fenêtre 402 ménagée dans la paroi verticale 344.

Chaque tiroir 138 comprend deux contacts latéraux mobiles 352, disposés chacun dans une structure latérale 346. Parmi ces deux contacts latéraux mobiles, un premier permet de connecter le tiroir 138 à l'interface de communication 353 du module d'entrées-sorties 206 et un second permet de connecter le tiroir 138 à une interface de communication 353 de l'unité de protection 140. La conception et le fonctionnement de ces deux contacts latéraux mobiles sont identiques.

En variante, le tiroir 138 ne comprend qu'un seul contact latéral mobile 352, disposé dans une structure latérale 346, qui permet de connecter le tiroir 138 soit à l'interface de communication 353 d'un module d'entrées-sorties 206, soit à l'interface de communication 353 de l'unité de protection 140.

En pratique, chaque module d'entrées-sorties 206 comprend une interface de communication 353 et l'unité de protection 140 comprend six interfaces de communication 353, disposées dans les fenêtres 256.

Chaque contact latéral mobile 352 comprend une plaquette 404. La plaquette 404 comprend un corps principal 406 qui est de forme allongée selon l'axe Y et deux ailettes 408 qui s'étendent perpendiculairement au corps principal 406 selon l'axe X.

Le corps principal 406 de la plaquette comprend une ouverture 410.

En pratique, le corps principal 406 a une hauteur selon l'axe Z inférieure à la hauteur de la fenêtre 402 de la paroi verticale 344.

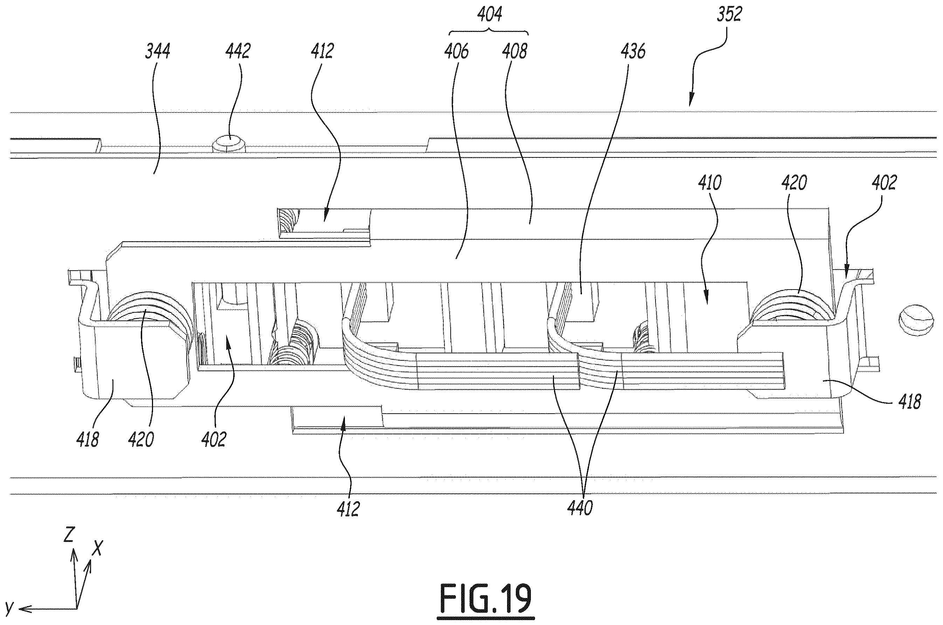

Comme visible à la figure 19, la plaquette 404 est disposée à l'intérieur du tiroir 138, en contact avec la face de la paroi verticale 344 dirigée vers l'intérieur du tiroir 138.

Les deux ailettes 408 de la plaquette s'étendent vers l'extérieur du tiroir 138, sont disposées dans deux fentes 412 de la paroi verticale 344 et s'étendent entre la paroi verticale 344 et la structure latérale 346.

Chaque ailette comprend une arête d'extrémité 414, parallèle à l'axe Y et un chanfrein 416, qui relie l'arête d'extrémité 414 au corps principal 406 de la plaquette 404.

La paroi verticale 344 comprend deux équerres de maintien 418, qui sont situées en vis-à-vis de la fenêtre 402 et formées par découpage et pliage de la paroi verticale 344. En pratique, les équerres de maintien 418 comprennent une première partie qui s'étend perpendiculairement à la paroi verticale 344 vers l'intérieur du tiroir 138 et une second partie qui s'étend perpendiculairement à la première partie, c'est-à-dire parallèlement à la paroi verticale 344, de sorte à s'étendre en regard de la fenêtre 402.

La plaquette 404 est maintenue en position par rapport au tiroir 138 par les ailettes 408, disposées dans les fentes 412, par les équerres 418, qui empêchent la plaquette de translater vers l'intérieur du tiroir 138 selon l'axe X, et par la paroi verticale 344, qui empêche la plaquette de translater vers l'extérieur du tiroir selon l'axe X.

La plaquette 404 est fixe par rapport au tiroir 138 selon l'axe Y.

En outre, un ressort 420 est disposé entre chaque équerre 418 et le corps principal 406 de la plaquette. Les deux ressorts 420 permettent de maintenir la plaquette 404 en appui contre la paroi verticale 344.

Chaque contact mobile 352 comprend également un cadre 422, disposé entre la paroi verticale 344 et la structure latérale 346.

En pratique, la structure latérale 346 comprend une paroi principale 424 et deux parois secondaires 426. La paroi principale 424 est parallèle à la paroi verticale 344 de la plaque de support 340 et les deux parois secondaires 426 s'étendent depuis la paroi principale 424 vers la paroi verticale 344, comme visible pour l'une d'entre elles à la figure 15.

Ainsi, la structure latérale 346 définit un volume intérieur compris entre les parois principale 424 et secondaires 426 et la paroi verticale 344 de la plaque de support 340.

Le cadre 422 est disposé à l'intérieur du volume intérieur de la structure latérale 346 et est mobile dans ce volume intérieur, selon l'axe Y.

En pratique, le cadre 422 n'est pas mobile selon l'axe X car il est en contact d'une part avec la paroi verticale 344 et d'autre part avec la paroi principale 424.

La hauteur H422 du cadre 422 est inférieure à la distance, mesurée selon l'axe Z, qui sépare les deux parois secondaires 426 de la structure latérale 346.

La hauteur du cadre 422 est supérieure à la hauteur H400 de la fenêtre 400 de la structure latérale, de sorte que le cadre ne peut pas sortir du volume intérieur de la structure latérale par la fenêtre 400.

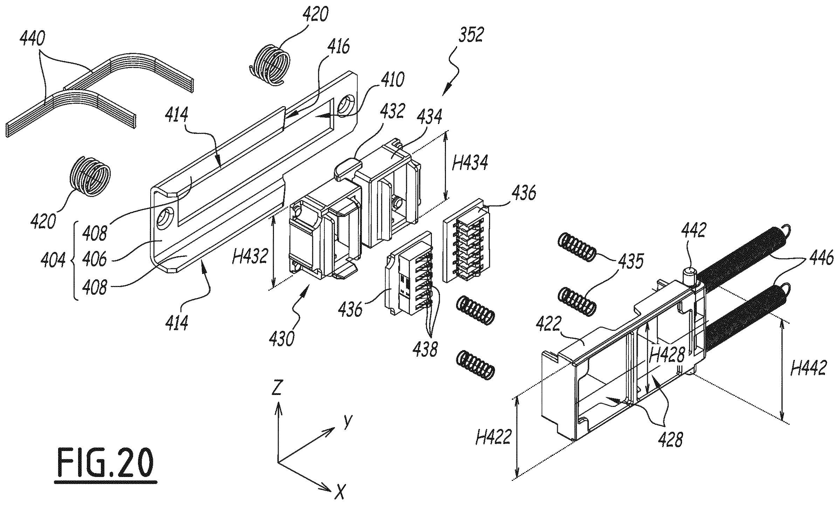

Comme visible à la figure 20, le cadre 422 comprend deux ouvertures 428 de hauteur H428 qui traversent le cadre 422 selon un axe parallèle à l'axe X.

Chaque contact latéral mobile 352 comprend également un boîtier de contacts 430. Le boîtier de contacts comprend un bâti 432 depuis lequel s'étendent deux porte-contacts 434, de chaque côté du bâti 432, selon l'axe Y.

La hauteur de chaque porte-contact 434, notée « H434 », est inférieure à la hauteur H428 des ouvertures 428.

La hauteur du bâti 432, notée « H432 », est supérieure à la hauteur H428 des ouvertures 428.

Le boîtier de contacts 430 est disposé dans le volume intérieur de la structure latérale 346, entre le cadre 422 et la paroi verticale 344, et s'étend partiellement en-dehors de ce volume intérieur, selon l'axe X, au-travers de la fenêtre 400. En pratique, le cadre 422 porte le boîtier de contacts 430. Chaque porte-contact 434 passe par une ouverture 428 du cadre 422. En d'autres termes, le cadre 422 guide le déplacement du boîtier de contacts 430 selon l'axe Y dans la structure latérale 346.

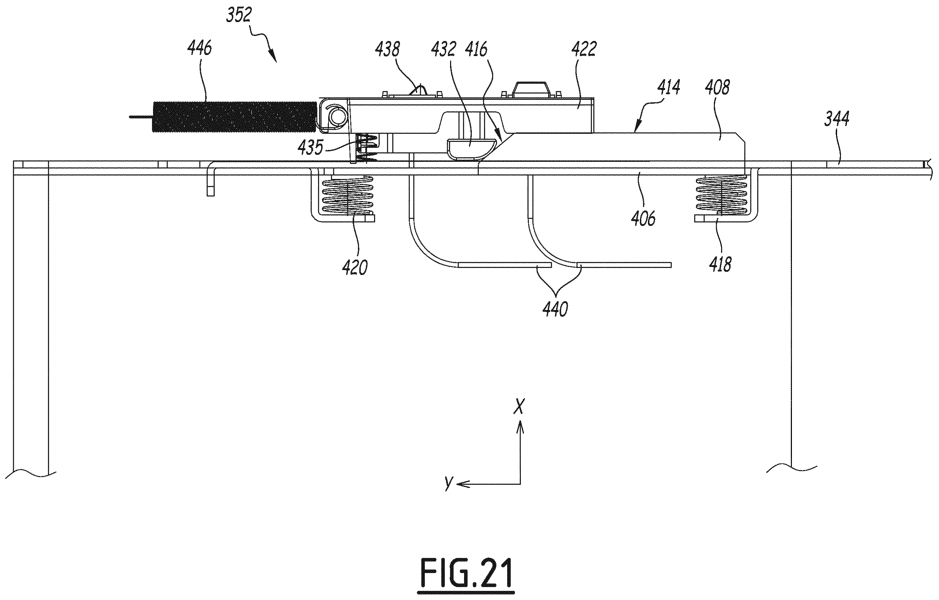

Le boîtier de contacts 430 est mobile selon l'axe X dans le cadre 422. Son mouvement de translation selon l'axe X est limité, d'une part, par la paroi verticale 344 et, d'autre part, par le bâti 432 qui entre en contact avec le cadre 422, comme visible sur les figures 21, 22 et 23.

Chaque contact latéral mobile 352 comprend des ressorts 435, en pratique quatre ressorts 435. Les ressorts 435 sont disposés entre le boîtier de contacts 430 et le cadre 422 et sont configurés pour exercer une force qui éloigne le boîtier de contacts 430 du cadre 422, selon l'axe X. Le cadre 422 n'étant pas mobile selon l'axe X, la force exercée par les ressorts 435 conduit à déplacer le boîtier de contacts 430 selon l'axe X par rapport au tiroir 138, vers l'intérieur de ce tiroir.

Chaque contact latéral mobile 352 comprend également deux contacts électriques 436.

Chaque contact électrique 436 est disposé fixement dans un porte-contact 434.

Les contacts électriques 436 comprennent chacun des connecteurs souples 438.

Les connecteurs souples 438 sont configurés pour pouvoir connecter le tiroir 138 soit à un module d'entrées-sorties 206, soit à l'unité de protection 140. Cette connexion est décrite ci-après.

Des câbles 440 sont en outre connectés à la carte électronique de contrôle 364 du tiroir 138. Sur les figures 18 à 23, les câbles 440 ne sont représentés que partiellement.

En pratique, les câbles sont connectés aux connecteurs souples 438 et s'étendent depuis l'arrière des contacts électriques 436 au travers de la fenêtre 402 de la paroi verticale 344 et au travers de l'ouverture 410 de la plaquette 404, jusqu'à l'intérieur du tiroir 138.

Chaque contact latéral mobile 352 comprend également un arbre de guidage 442. L'arbre de guidage est de préférence un cylindre qui s'étend selon l'axe Z et il est monté dans le cadre 422.

En variante l'arbre de guidage est monobloc avec le cadre 422.

La hauteur H442 de l'arbre de guidage 442 est supérieure à la distance, mesurée selon l'axe Z, qui sépare les parois secondaires 426 de la structure latérale 346. Ainsi, l'arbre de guidage 442 s'étend en-dehors du volume intérieur de la structure latérale 346, au-travers de deux fentes 444 ménagées dans les parois secondaires 426.

Chaque contact latéral mobile 352 comprend également des ressorts de traction 446, de préférence deux ressorts 446. Les ressorts de traction 446 s'étendent parallèlement à l'axe Y. Chaque ressort de traction 446 est fixé à l'une de ses extrémités à l'arbre de guidage 442 et à l'autre de ses extrémités à la structure latérale 346.

Chaque contact latéral mobile 352 est configuré pour assurer une connexion des connecteurs souples 438 avec une unité de protection 140 ou un module d'entrées-sorties 206 pour toute position du tiroir 138 entre sa position de fonctionnement et sa position de test et pour que cette connexion ne soit pas interrompue lorsque le tiroir 138 est déplacé entre sa position de test et sa position de fonctionnement.

Pour cela, chaque contact latéral mobile 352 est mobile le long de l'axe longitudinal A138 du tiroir 138, qui est parallèle à l'axe Y, ainsi que le long de l'axe transversal B138 du tiroir, qui est parallèle à l'axe X.

Les figures 21, 22 et 23 illustrent trois positions différentes d'un contact latéral 352.

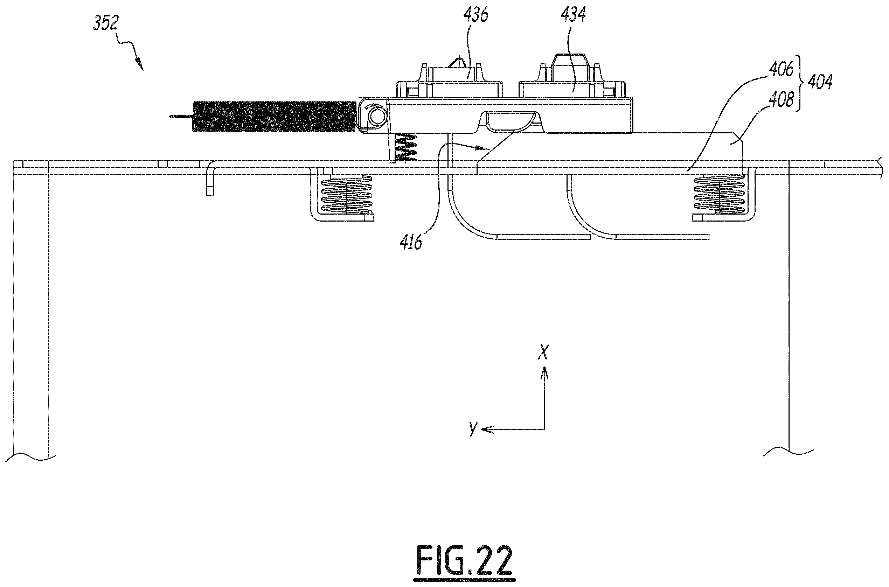

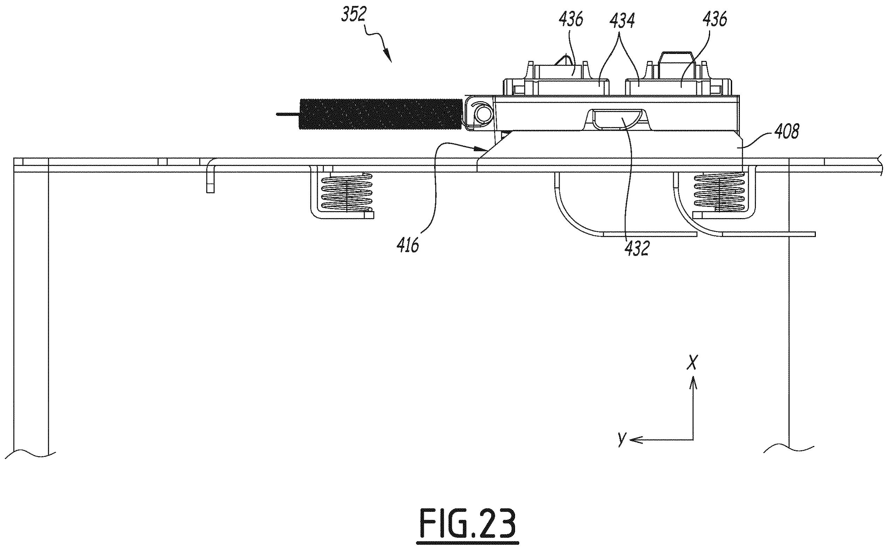

On définit une position d'engagement du tiroir 138 comme une position située entre la position déconnectée et la position de test du tiroir. À la figure 21, le tiroir 138 est représenté entre sa position d'engagement et sa position de test. La position de test du tiroir est représentée à la figure 22 et la position de fonctionnement du tiroir est représentée à la figure 23.

Sur ces figures, seul le contact latéral mobile 352 et une partie du tiroir 138 sont représentées. Notamment, les rails 224 et 250 dans lesquels les structures latérales du tiroir sont insérés sont masqués, pour plus de clarté. En pratique, le mouvement de chaque contact latéral mobile est affecté par l'interaction du contact latéral mobile avec le rail 224 ou 250 dans lequel la structure latérale 346 portant ce contact latéral mobile est inséré.

Lorsque le tiroir 138 est inséré dans le module de démarrage moteur 200 entre sa position déconnectée et sa position d'engagement, le contact latéral mobile 352 ne se déplace pas par rapport au tiroir 138.

Dans cette position, le cadre 422 et l'arbre de guidage 442 sont maintenus par les ressorts de traction 446 au plus proche de la partie arrière 348 du tiroir, dans une position de repos. En pratique, le cadre 422 et l'arbre de guidage 442 sont au plus proche de la partie arrière du tiroir 348 lorsque l'arbre de guidage 442 est en contact avec une extrémité de la fente 444. Cette position n'est pas représentée sur les figures.

De plus, dans cette position, le boîtier de contacts 430 et les contacts 426 sont en position rentrée dans le tiroir 138, c'est-à-dire que le boîtier de contacts 430 est éloigné du cadre 422 et est plus proche de la paroi verticale 344. En d'autres termes, en position rentrée, le boîtier de contacts 430 et les contacts 426 sont contenus au maximum dans le volume intérieur de la structure latérale 346 et s'étendent au minimum en-dehors de ce volume intérieur au-travers de la fenêtre 400.

En pratique, la position rentrée du boîtier de contacts 430 et des contacts 426 est imposée par les ressorts 435 qui exercent sur le boîtier de contacts 430 une force l'éloignant du cadre 422.

Au cours de l'insertion du tiroir 138 dans le module de démarrage moteur 200, lorsque le tiroir 138 arrive en position d'engagement, l'arbre de guidage 442 entre en contact avec les languettes 232 ou 254 des rails 224 ou 250.

En effet, la hauteur H442 de l'arbre de guidage 442 est supérieure à la distance, mesurée selon l'axe Z, entre les bords des rails 224 et 250 mais est inférieure à la distance entre les languettes des rails.

À partir de cette position d'engagement, la translation du cadre 422, du boîtier de contacts 430 et des contacts électriques 436 selon l'axe Y est arrêtée. Ces éléments commencent alors à se déplacer par rapport au tiroir 138. Ainsi, entre la position d'engagement du tiroir et la position de fonctionnement du tiroir, en passant par la position de test du tiroir, le cadre 422 est translaté dans le volume intérieur de la structure latérale 346. En pratique, le cadre 422 devient fixe par rapport au module de démarrage moteur 200 alors que le tiroir 138 est en mouvement. Au cours de ce mouvement du tiroir, les ressorts de traction 446 sont étirés.

Le déplacement du cadre 422, du boîtier de contact 430 et des contacts électriques 436 entre la position d'engagement du tiroir et la position de test du tiroir s'effectue en deux phases.

Au cours d'une première phase, le cadre 422, le boîtier de contact 430 et les contacts électriques 436 se déplacent par rapport au tiroir 138 selon l'axe Y et l'axe B138, en s'éloignant de la position de repos du cadre 422, tout en restant fixes par rapport au module de démarrage moteur 200. Ce déplacement se poursuit jusqu'à ce que le bâti 432 du boîtier de contacts 430, qui est fixe selon l'axe Y, entre en contact avec l'arrête d'extrémité 414 de l'ailette 408 de la plaquette 404, qui est mobile selon l'axe Y. Cette position est représentée à la figure 21.

Au cours d'une deuxième phase, après que le bâti 432 est entré en contact avec l'arrête d'extrémité 414, le déplacement par rapport au tiroir 138 du cadre 422 et des éléments qu'il porte selon l'axe Y se poursuit et le boîtier de contacts 430 est de plus translaté selon l'axe X et l'axe A138, en s'éloignant du volume intérieur de la structure latérale 346.

La translation du boîtier de contacts 430 selon l'axe X a donc lieu grâce au chanfrein 416 de l'ailette, qui, au cours de sa translation selon l'axe Y, repousse le boîtier de contacts ainsi que les contacts 436 depuis leur position rentrée vers une position sortie du tiroir 138, visible à la figure 22. Ce mouvement conduit à une compression des ressorts 435 entre le boîtier de contacts et le cadre 422.

En outre, cette translation du boîtier de contacts 430 et des contacts électriques 436 selon l'axe X est permise car, depuis la position d'engagement jusqu'à la position de fonctionnement du tiroir 138, le boîtier de contacts 430 du contact latéral mobile 352 est situé en regard des fenêtres 226 ou 252 du rail dans lequel la structure latérale est engagée.

En pratique, chaque porte-contact 434 du boîtier de contacts 430 est situé en regard de l'une des deux fenêtres 226 ou 252 du rail.

Grâce à cette translation, les contacts électriques 436 s'étendent en-dehors de la structure latérale 346 et peuvent entrer en contact avec l'unité de protection 140 ou un module d'entrées-sorties 206.

Entre la position de test du tiroir et la position de fonctionnement du tiroir, le boîtier de contacts 430 est fixe selon l'axe X par rapport au module de démarrage moteur 200 et le bâti 432 du boîtier de contacts glisse sur l'arête d'extrémité 414 de l'ailette 408 de la plaquette 404.

En d'autre termes, le bâti 432 impose le mouvement du boîtier de contacts 430 par rapport au tiroir 138, vers sa position sortie.

En outre, les ressorts 420 qui maintiennent la plaquette 404 contre la paroi verticale 344, c'est-à-dire dans une position de référence, sont configurés pour que, dans le cas où la sortie du boîtier de contacts 430 selon l'axe X est bloquée, par exemple par un obstacle présent dans la fenêtre du rail, l'effort exercé par les ressorts 420 soit inférieur à l'effort exercé par le bâti 432 sur l'ailette 408 de la plaquette 404, ce qui conduit alors la plaquette 404 à se déplacer selon l'axe X, vers les équerres de maintien 418, c'est-à-dire vers une position de sécurité.

Grâce à ce mouvement de la plaquette 404, dans un tel cas de figure, le contact latéral mobile 352 n'est pas dégradé.

Ce mouvement de la plaquette 404 permet également d'accommoder des variations dans le positionnement relatif des pièces. Par exemple, si les interfaces de communication 353 sont plus proches des tiroirs 138, le mouvement selon l'axe X de la plaquette permettra de ne pas exercer de contraintes excessive sur les contacts électriques 436.

En résumé, par rapport au module de démarrage moteur 200, le mouvement des contacts électrique 436 comprend trois phases :
- de la position déconnectée jusqu'à la position d'engagement du tiroir, les contacts électriques 436 sont en translation selon l'axe Y dans un rail 224 ou 250 par rapport au module de démarrage moteur et sont fixes par rapport au tiroir 138 ;
- de la position d'engagement du tiroir jusqu'à la position de test du tiroir, les contacts électriques 436 sont en translation selon l'axe X en s'éloignant de la structure latérale 346, au travers des fenêtres 226 ou 252 du rail et sont fixes selon l'axe Y par rapport au module de démarrage moteur 200 ; et
- de la position de test du tiroir jusqu'à la position de fonctionnement du tiroir, les contacts électriques 436 sont fixes par rapport au module de démarrage moteur.

Grâce à ce mouvement en trois phases des contacts électriques 436, et plus particulièrement grâce au fait que les contacts électriques 436 sont fixes par rapport au module de démarrage moteur 200 entre la position de test et la position de fonctionnement du tiroir, le contact entre les contacts électriques 436 et l'unité de protection 140 ou le module d'entrées-sorties 206 est maintenu sans interruption, ce qui permet de conserver une liaison entre la carte électronique de contrôle 364 et l'unité de protection 140 ou entre la carte électronique de contrôle 364 et un module d'entrées-sorties 206 entre ces deux positions.

Lorsque les contacts électriques 436 s'étendent au travers des fenêtres 226 d'un rail 224, ils s'étendent également au travers des fenêtres 222 du support latéral 210 sur lequel le rail 224 est fixé.

Les câbles 440 sont souples, de sorte que leur extrémité reliée aux contacts électriques 436 est mobile avec les contacts électriques 436. De plus, les dimensions de la fenêtre 402 de la paroi verticale 344 ainsi que de l'ouverture 410 de la plaquette 404 permettent de ne pas gêner le mouvement des câbles 440.

Lorsque le tiroir 138 est sorti du volume V1 du module de démarrage 200, c'est-à-dire lorsqu'il passe de sa position de fonctionnement à sa position déconnectée, le mouvement des contacts électrique 436 du contact latéral mobile 352 comprend trois phases :
- de la position de fonctionnement jusqu'à la position de test du tiroir, les contacts électrique 436 sont fixes par rapport au module de démarrage moteur 200 et sont en translation selon l'axe Y par rapport au tiroir 138 ;
- de la position de test jusqu'à la position d'engagement du tiroir, les contacts électriques 436 sont fixes selon l'axe Y par rapport au module de démarrage moteur et sont en translation selon l'axe X en s'éloignant du cadre 422 et en se rapprochant de la structure latérale 346, sous l'effet des ressorts 435 ; et
- de la position d'engagement jusqu'à la position déconnectée du tiroir, les contacts électriques 436 sont en translation selon l'axe Y par rapport au module de démarrage moteur et sont fixes par rapport au tiroir 138.

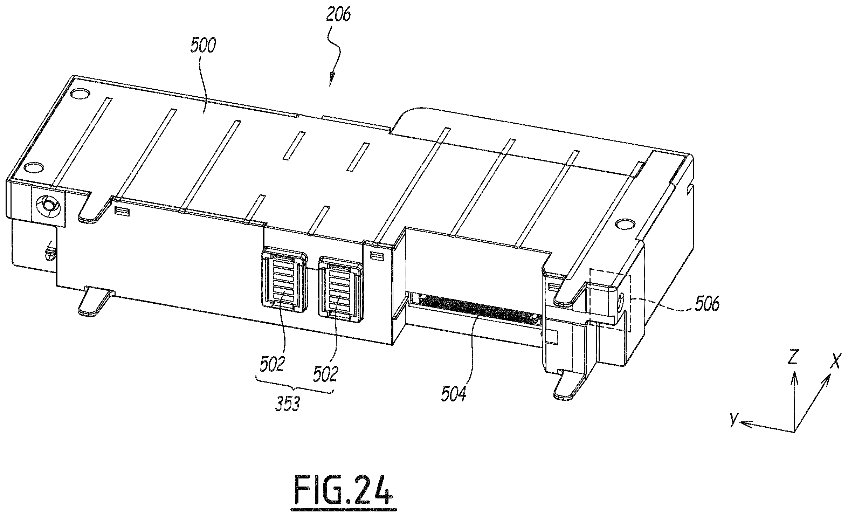

Comme visible à la figure 24, le module d'entrées-sorties 206 comprend un boîtier 500 sur lequel sont disposées deux pastilles de connexion 502, qui forment l'interface de communication 353.

Lorsque le tiroir 138 est en position de fonctionnement ou en position de test, les connecteurs souples 438 des deux contacts électriques 436 sont en contact avec les deux pastilles de connexion 502. En pratique, les connecteurs 438 sont dit « souples » car ils peuvent se déformer de manière élastique selon l'axe X sous un effort, par exemple sous l'effort généré par le contact avec les pastilles de connexion 502. Cette déformation permet de maintenir un bon contact électrique entre les connecteurs souples et les pastilles de connexion 502 car elle permet de tolérer des défauts d'alignement et de position relatifs des connecteurs et des pastilles.

Comme visible à la figure 8, le boîtier 500 du module d'entrées-sorties 206 est fixé au support latéral 212 du module de démarrage moteur 200. Chaque module d'entrées-sorties 206 est associé à un tiroir 138 et est situé, sur le support latéral 212, à la hauteur de la base 328 de ce tiroir.

Le module d'entrées-sorties 206 comprend également un connecteur linéaire 504 qui permet de connecter le module d'entrées-sorties 206 au tronçon de bus informatique 204 du module de démarrage moteur 200. Ainsi, le module d'entrées-sorties 206 est relié aux circuits électroniques 144, aux pistes d'alimentation électrique 148 conduisant la première tension auxiliaire et aux pistes d'alimentation électrique 154 conduisant la deuxième tension électrique auxiliaire.

Le module d'entrées-sorties 206 comprend une première carte de communication sans fil 506, disposée dans le boîtier 500. Cette première carte de communication sans fil n'est pas visible depuis l'extérieur du boîtier 500 et est représentée en pointillés à la figure 24.

La première carte de communication sans fil 506 communique avec une deuxième carte de communication sans fil 508, qui est en pratique disposée dans le tiroir 138 associé au module d'entrées-sorties, comme visible à la figure 16 où la deuxième carte est également représentée en pointillés.

En pratique, les première et deuxième cartes de communication sans fil sont disposées face-à-face, c'est-à-dire qu'elles sont alignées selon un même axe parallèle à l'axe transversal Y de l'armoire électrique.

Les première et deuxième cartes de communication sont configurées pour pouvoir échanger des données en émettant et recevant des radiofréquences, par exemple en utilisant un protocole sans fil, de préférence à une fréquence de 60 GHz. Par exemple, le protocole utilisé est le protocole Ethernet. Cet échange de données se fait donc à distance, sans contact entre les cartes de communication.

En outre, les première et deuxième cartes de communication 506 et 508 sont configurées pour permettre cet échange de données lorsque le tiroir 138 est en position de fonctionnement, lorsque le tiroir est en position de test, et lorsque le tiroir se déplace entre ces deux positions.

Dans l'exemple, le contact entre un contact latéral mobile 352 d'un tiroir et les deux pastilles de connexion 502 d'un module d'entrées-sorties permet de délivrer la première tension électrique auxiliaire provenant des pistes d'alimentation électrique 148 au tiroir et les données échangées entre les première et deuxième cartes de communication 506 et 508 correspondent aux données qui transitent par les circuits électroniques 144.

Cette solution est avantageuse car elle permet de séparer dans deux connexions différentes les données échangées d'une part et la transmission d'une tension électrique d'autre part.

En outre, puisque l'un des deux contacts latéraux mobiles 352 d'un tiroir 138 est connecté au module d'entrées-sorties dès la position de test du tiroir jusqu'à la position de fonctionnement du tiroir, la première tension électrique auxiliaire est délivrée au tiroir dès sa position de test. Ainsi, la carte électronique de contrôle 364 et les éléments fonctionnels 362 sont alimentés en première tension électrique auxiliaire en position de test du tiroir.

Cette alimentation en position de test est avantageuse, car elle permet, par exemple, de vérifier le bon fonctionnement du tiroir 138 avant de permettre le passage du tiroir 138 en position de fonctionnement.

En variante, une première pastille de connexion 502 parmi les deux pastilles permet de délivrer la première tension électrique auxiliaire au tiroir 138 et une deuxième pastille de connexion permet d'échanger des données entre le tiroir et le module d'entrées sorties 206, de manière complémentaire ou de manière redondante avec l'échange de données réalisé par les cartes de communication, comme par exemple des signaux d'arrêt d'urgence.

En variante, le tiroir 138 et le module d'entrées-sorties 206 ne comportent pas de cartes de communication et les données qui transitent par les circuits électroniques 144 sont échangées entre le tiroir 138 et le module d'entrées-sorties par les pastilles de connexion 502 et un contact latéral mobile 352.

Comme visible à la figure 8, chaque module d'entrées-sorties 206 comporte également des borniers de connexion 510.

Parmi les borniers de connexion 510 d'un module d'entrées-sorties certains sont connectés d'une part aux pistes d'alimentation électrique 154 et d'autre part à la charge électrique 104 raccordée au tiroir 138 associé audit module d'entrées-sorties, ce qui permet d'alimenter cette charge électrique en deuxième tension électrique auxiliaire. En pratique, des câbles d'alimentation non-représentés relient les borniers de connexion 510 à la charge électrique 104.

En variante, ces câbles d'alimentation sont raccordés à des prises mobiles et les prises mobiles sont configurées pour être raccordées aux borniers de connexion 510.

Alimenter une charge électrique 104 en deuxième tension électrique auxiliaire permet d'alimenter des fonctions annexes de la charge électrique 104. Lorsque la charge électrique 104 est un moteur électrique, ces fonctions annexes sont, par exemple, des circuits de chauffe, qui permettent de maintenir le moteur électrique au-dessus d'une température minimale lorsque le moteur n'est pas en fonctionnement. Ces circuits de chauffe sont avantageux car ils permettent d'éviter des phénomènes de condensation qui pourraient dégrader ce moteur.

Parmi les borniers de connexion 510 d'un module d'entrées-sorties, d'autres sont connectés d'une part aux circuits électroniques 144 et d'autre part à des capteurs non-représentés disposés au niveau de la charge électrique 104, tels que par exemple des capteurs de position, de vitesse ou de température lorsque la charge 104 est un moteur, ou encore un bouton d'arrêt d'urgence. Les données issues de ces capteurs sont transmises d'une part au tiroir 138 et d'autre part au tronçon de bus informatique.

Ainsi, chaque module d'entrées-sorties 206 permet relier le tronçon de bus informatique 204 à un tiroir de contrôle-commande 138 et à la charge électrique 104 raccordée à ce tiroir de contrôle-commande et permet l'échange de données entre le tiroir de contrôle-commande 138 et la charge électrique 104.

Ce module d'entrées-sorties 206 est avantageux, car il permet de centraliser plusieurs connexions dans un seul boîtier et il permet de raccorder le tiroir 138 au tronçon de bus informatique 204 sans nécessiter la mise en oeuvre de câbles électriques.

Comme visible à la figure 25, le tronçon de bus informatique 204 comprend un boîtier 600 dans lequel est disposé une carte électronique 602.

Comme le bus informatique 142, le tronçon de bus informatique 204 s'étend en longueur selon l'axe Z.

La carte électronique 602 porte des circuits électroniques 604, des premières pistes d'alimentation électrique 606 et des deuxièmes pistes d'alimentation électrique 608.

Le tronçon de bus informatique 204 comprend également des connecteurs linéaires 610, en pratique six connecteurs linéaires.

Chaque connecteur linéaire 610 est relié aux circuits électroniques 604 et aux pistes d'alimentation électrique 606 et 608.

En pratique, le tronçon de bus informatique 204 est configuré pour pouvoir être connecté avec un ou plusieurs modules d'entrées-sorties 206, jusqu'à six modules d'entrées-sorties. Chaque module d'entrées-sorties est connecté au tronçon de bus informatique par un connecteur linéaire 610. En effet, les connecteurs linéaires 610 sont configurés pour être raccordés avec les connecteurs linéaires 504 des modules d'entrées-sorties, assurant ainsi une connexion entre le tronçon de bus informatique 204 et les modules d'entrées-sorties 206.

Sur la figure 8, deux modules d'entrées-sorties 206 sont connectés au tronçon de bus informatique.

Le tronçon de bus informatique 204 comprend également des connecteurs mâles 612 à une première extrémité selon l'axe Z, dans l'exemple à une extrémité haute. En pratique, les connecteurs mâles 612 comprennent un premier connecteur 614 relié aux premières pistes d'alimentation électrique 606, un deuxième connecteur 616 relié aux deuxièmes pistes d'alimentation électrique 608 et un troisième connecteur 618 relié aux circuits électroniques 604.

Cette première extrémité comporte également des ergots 620, en pratique deux ergots 620, qui s'étendent depuis le boîtier 600 selon l'axe Z, en s'éloignant du boîtier.

Le tronçon de bus informatique 204 comprend également des connecteurs femelles 622 à une seconde extrémité selon l'axe Z, dans l'exemple à une extrémité basse. En pratique, les connecteurs femelles 622 comprennent un premier connecteur 624 relié aux premières pistes d'alimentation électrique 606, un deuxième connecteur 626 relié aux deuxièmes pistes d'alimentation électrique 608 et un troisième connecteur 628 relié aux circuits électroniques 604.

Les connecteurs mâles 612 et les connecteurs femelles 622 sont de formes complémentaires, c'est-à-dire que les connecteurs mâles peuvent s'emboîter dans les connecteurs femelles.

Cette seconde extrémité comporte également des cavités 630. Les ergots 620 et les cavités 630 sont de formes complémentaires, c'est-à-dire que les ergots peuvent s'emboîter dans les cavités.

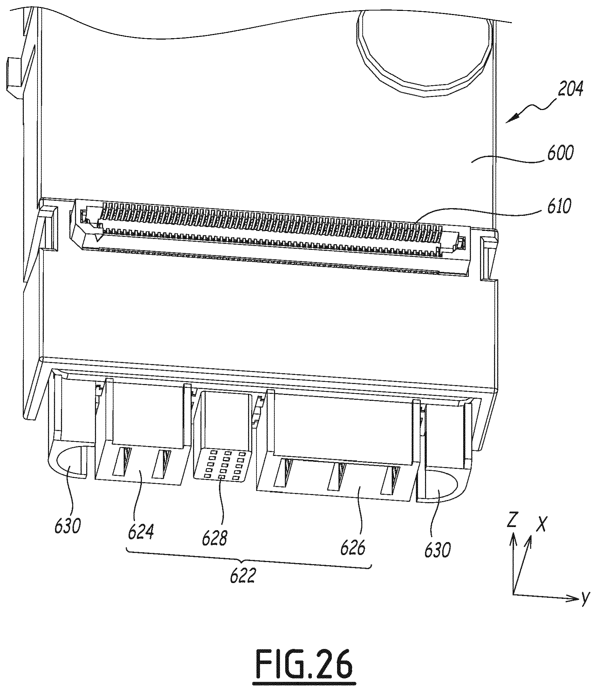

Les connecteurs femelles 622 et les cavités 630 sont visibles en détail à la figure 26.

Grâce aux ergots 620 et aux cavités 630, plusieurs tronçons de bus informatique 204 peuvent être assemblés ensemble. Grâce aux connecteurs mâles 612 et aux connecteurs femelles 622, plusieurs tronçons de bus informatique 204 peuvent être mis en continuité électrique.

Lorsque deux tronçons de bus informatique 204 sont assemblés, ils sont juxtaposés selon l'axe Z, les connecteurs mâles d'un premier tronçon sont emboîtés dans les connecteurs femelles d'un deuxième tronçon et les ergots 620 du premier tronçon sont emboîtés dans les cavités 630 du deuxième tronçon.

En pratique, chaque module de démarrage moteur 200 comprend un tronçon de bus informatique 204. Ainsi, lorsqu'une colonne de démarrage moteur 110 comprend plusieurs modules de démarrage moteur 200, qui sont superposés, les tronçons de bus informatique 204 de tous les modules de démarrage moteur 200 sont assemblés et raccordés électriquement entre eux.

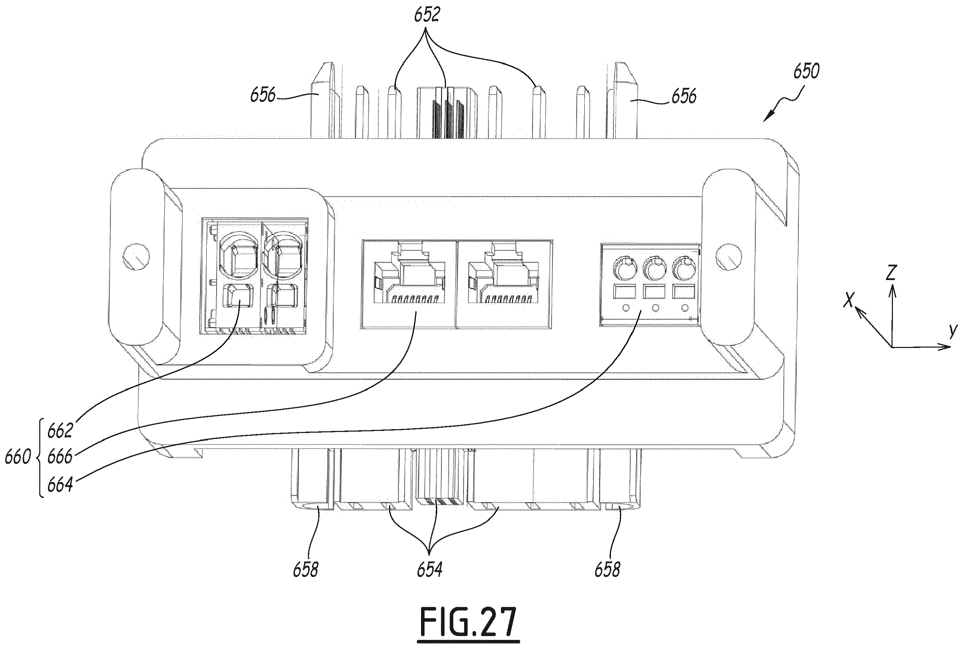

Un raccord de bus informatique 650 est représenté à la figure 27. Ce raccord est également visible à la figure 6, assemblé à un module de communication 134.

Le raccord de bus informatique 650 permet de raccorder un tronçon de bus informatique 204 d'une colonne de raccordement 110 au module de communication 134 de cette colonne de raccordement. Ainsi, chaque colonne de raccordement 110 comprend un raccord de bus informatique 650 fixé au module de communication 134 de la colonne.

Pour cela, le raccord de bus informatique 650 comprend des connecteurs mâles 652 et des connecteurs femelles 654, qui sont identiques respectivement aux connecteurs mâles 612 et aux connecteurs femelles 622 du tronçon de bus informatique 204.

Le raccord de bus informatique 650 comprend également des ergots 656 et des cavités 658, qui sont identiques respectivement aux ergots 620 et aux cavités 630 du tronçon de bus informatique 204.

Ainsi, le raccord de bus informatique 650 peut être assemblé sur, et raccordé électriquement à, un tronçon de bus informatique, de la même manière que deux tronçons de bus informatique peuvent être assemblés entre eux, c'est-à-dire en s'emboîtant.

De plus, le fait que le raccord de bus informatique 650 comprend des connecteurs mâles et des connecteurs femelles est avantageux, car il peut être assemblé soit au-dessus d'un tronçon de bus informatique, par exemple lorsque le module de communication 134 est disposé au-dessus du ou des modules de démarrage moteur 200, soit en-dessous d'un tronçon de bus informatique, lorsque le module de communication 134 est disposé en-dessous du ou des modules de démarrage moteur 200.

En pratique, seuls les connecteurs mâles ou les connecteurs femelles sont utilisés lorsque le raccord de bus informatique 650 est monté dans une colonne 110. Il est alors avantageux de protéger les connecteurs non-utilisés par un bouchon, non-représenté.

Dans une colonne de démarrage moteur 110, le bus informatique 142 est formé de l'assemblage d'un raccord de bus informatique 650 et d'un ou de plusieurs tronçons de bus informatique 204.

Dans une colonne de démarrage moteur 110, les circuits électroniques 604 correspondent aux circuits électroniques 144 du bus informatique 142, les premières pistes d'alimentation électrique 606 du ou des tronçons de bus informatique correspondent aux pistes d'alimentation 148 du bus informatique 142 et les deuxièmes pistes d'alimentation électrique 608 correspondent aux pistes d'alimentation 154 du bus informatique 142.

Le raccordement du bus informatique 142 au module de communication s'effectue par plusieurs connecteurs de façade 660. En pratique, ces connecteurs comprennent :
- Un premier connecteur 662, qui est raccordé d'une part au premier connecteur 192 du module de communication par des câbles non-représentés et d'autre part aux pistes d'alimentation 148 du bus informatique 142. Grâce au premier connecteur 662, les pistes d'alimentation 148 du bus informatique 142 sont alimentées en première tension électrique auxiliaire.
- Un deuxième connecteur 664, qui est raccordé d'une part au boîtier de protection 194 du module de communication 134 par des câbles non-représentés et d'autre part aux pistes d'alimentation 154 du bus informatique 142. Grâce au deuxième connecteur 664, les pistes d'alimentation 154 du bus informatique 142 sont alimentées en deuxième tension électrique auxiliaire.
- Un troisième connecteur 666, qui est raccordé d'une part au switch managé 135 du module de communication 134 par des câbles non-représentés et d'autre part aux circuits électroniques 144 du bus informatique 142. Grâce au troisième connecteur 666, les circuits électroniques 144 du bus informatique 142 sont connectés au switch managé 135 et peuvent donc échanger des informations avec le module de communication 134.

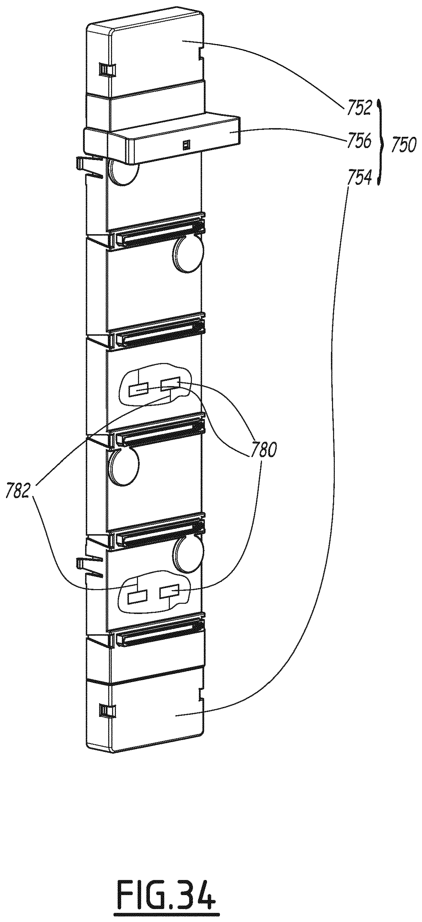

Comme visible à la figure 34, le tronçon de bus informatique 204 peut être équipé de cavaliers 750.

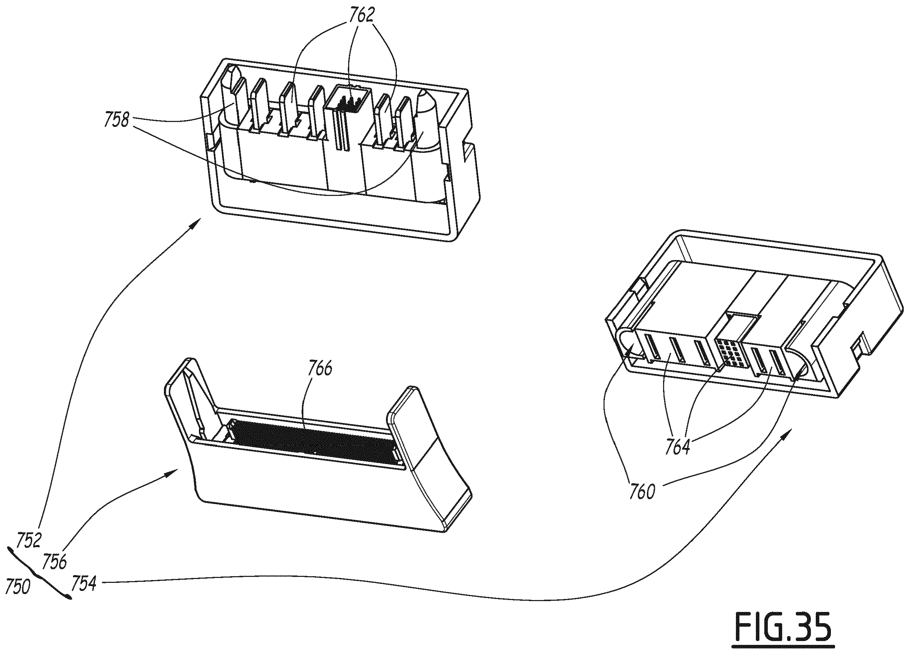

On distingue aux figures 34 et 35 trois types de cavaliers 750 :
- un cavalier d'extrémité mâle 752 ;
- un cavalier d'extrémité femelle 754 ; et
- un cavalier d'entrées-sorties 756.

Les cavaliers d'extrémité mâle 752 et femelle 754 permettent d'éviter que dans une colonne de démarrage moteur 110, l'extrémité du bus informatique 142 - qui comprend plusieurs tronçons de bus informatique 204 assemblés entre eux - opposée à l'extrémité raccordée au raccord de bus informatique 650 ne soit libre.

Ainsi, une première extrémité du bus informatique 142 est raccordée au raccord de bus informatique 650 et une seconde extrémité du bus informatique est raccordée à un cavalier d'extrémité mâle 752 ou femelle 754.

Ce raccordement permet de protéger les connecteurs 622 ou 612 du tronçon de bus informatique 204 opposé au raccord de bus informatique.

En pratique, le cavalier d'extrémité mâle 752 permet de protéger les connecteurs femelle 622 et le cavalier d'extrémité femelle 754 permet de protéger les connecteurs mâle 612.

Pour permettre l'assemblage des cavaliers d'extrémité sur le tronçon de bus informatique 204, le cavalier d'extrémité mâle 752 comprend deux ergots 758, de forme complémentaire aux cavités 630 de la première extrémité du tronçon de bus informatique, et le cavalier d'extrémité femelle 754 comprend deux cavités 760, de forme complémentaire aux ergots 620 de la seconde extrémité du tronçon de bus informatique.

En outre, les cavaliers d'extrémité 752 et 754 permettent d'assurer la continuité des circuits électroniques 604 du tronçon de bus informatique 204, correspondant, dans une colonne de démarrage moteur 110, aux circuits électroniques 144 du bus informatique 142.

En effet, les circuits électroniques 144, en particulier lorsqu'ils permettent un échange de donnée selon le protocole Ethernet, connectent le module de communication 134 d'une colonne de démarrage moteur 110 aux tiroirs de contrôle-commande 138 en série. Ainsi, les circuits électroniques 144 forment une boucle dont le point d'origine est le module de communication 134.

Lorsqu'un tronçon de bus informatique 204 comprend une extrémité libre, le cavalier d'extrémité 752 ou 754 monté sur cette extrémité libre permet de fermer cette boucle, grâce à des connecteurs reliés aux circuits électroniques 604, en étant connecté à l'extrémité libre du tronçon de bus informatique.

En pratique, le cavalier d'extrémité mâle 752 comprend des connecteurs mâle 762 et le cavalier d'extrémité femelle 754 comprend des connecteurs femelle 764, qui sont identiques respectivement aux connecteurs mâles 612 et aux connecteurs femelles 622 du tronçon de bus informatique 204.

En variante non-représentée de l'invention, la colonne de démarrage moteur 110 ne comprend pas de module de communication 134 et les circuits électroniques 144 forment une boucle dont le point d'origine est l'ordinateur industriel 130, qui a alors un rôle fonctionnel identique à celui du module de communication 134.

Avantageusement, ces connecteurs mâle 762 et femelle 764 permettent également de connecter les cavaliers d'extrémité 752 et 754 aux pistes d'alimentation électrique 606 et 608.

Ainsi, les pistes d'alimentation électrique 606 et 608 peuvent alimenter les connecteurs linéaires 610 soit en parallèle, soit en série. En effet, dans le cas d'une alimentation en série, les cavaliers d'extrémité mâle 762 et femelle 764 permettent de fermer les boucles des pistes d'alimentation électrique 606 et 608.

Sur le même principe, les cavaliers d'entrées-sorties 756 permettent de fermer la boucle formée par les circuits électroniques 144 au niveau d'un connecteur linéaire 610 donné, lorsqu'aucun module d'entrées-sorties 206 n'est connecté à ce connecteur linéaire 610.

Pour cela, chaque cavalier d'entrées-sorties 756 dispose d'un connecteur complémentaire 766, configuré pour être connecté à un connecteur linéaire 610.

En pratique, dans un module de démarrage moteur 200, le nombre de cavaliers d'entrées-sorties 756 dépend du nombre de modules d'entrées-sorties 206. Ce nombre est égal au nombre total de connecteurs linéaires 610, moins le nombre de modules d'entrées-sorties 206 du module de démarrage moteur 200.

Ainsi, dans l'exemple représenté à la figure 8, dans lequel deux modules d'entrées-sorties 206 sont connectés au tronçon de bus informatique 204, qui comprend six connecteurs linéaires 610, quatre cavaliers d'entrées-sorties 756 sont connectés sur le tronçon de bus informatique, mais ne sont pas représentés pour simplifier la figure.

Puisqu'un module d'entrées-sorties 206 est toujours associé à un tiroir de contrôle-commande, on peut également considérer que les cavaliers d'entrées-sorties 756 permettent de fermer la boucle formée par les circuits électroniques 144 au niveau d'un connecteur linéaire 610, lorsqu'aucun tiroir de contrôle-commande n'est connecté à ce connecteur linéaire.

Comme visible à la figure 34, le tronçon de bus informatique 204 comprend également des blocs mémoire 780, qui sont en pratique des puces électroniques, également appelées circuits intégrés.

Avantageusement, le tronçon de bus informatique 204 comprend autant de bloc mémoire 780 que de connecteurs linéaires 610.

Dans l'exemple, le tronçon de bus informatique 204 comprend donc six blocs mémoires 780. À la figure 34, seuls quatre blocs mémoire 780 sont représentés, au travers de deux arrachements du boîtier 600 du tronçon de bus informatique, pour simplifier la figure.

Chaque bloc mémoire 780 est ainsi associé à un connecteur linéaire 610.

Ainsi, lorsque le module de démarrage moteur 200 est assemblé, chaque bloc mémoire 780 est associé à un module d'entrées-sorties 206, qui correspond au module d'entrées-sorties connecté au connecteur linéaire 610, et à un tiroir de contrôle-commande 138, qui correspond au tiroir connecté au module d'entrées-sorties connecté au connecteur linéaire 610.

Au cours du fonctionnement de l'armoire électrique 100, chaque bloc mémoire 780 enregistre des informations et des paramètres à propos du tiroir de contrôle-commande 138, à propos de la charge électrique 104 raccordée au tiroir de contrôle-commande 138 et/ou à propos du module d'entrées-sorties 206 auquel le tiroir et la charge électrique sont raccordés.

Par exemple, un bloc mémoire 780 enregistre, à propos de la charge électrique 104 raccordée au tiroir de contrôle-commande 138 associé au bloc mémoire, tout ou partie des informations suivantes :
- le type de la charge électrique 104, telle que par exemple un moteur électrique monophasé, un moteur électrique triphasé, ou encore une charge électrique pilotable ;
- les conditions de fonctionnement de la charge électrique 104, telles que par exemple la puissance électrique nécessaire à son fonctionnement ; et
- le type du tiroir de contrôle-commande 138 devant contrôler la charge électrique, c'est-à-dire les caractéristiques représentatives du tiroir, comprenant par exemple le nombre et la disposition des contacteurs des éléments fonctionnels 362 ou le type du relai de protection thermique.

En pratique, un bloc mémoire 780 enregistre notamment, à propos du tiroir de contrôle-commande 138 associé au bloc mémoire, le type du tiroir de contrôle-commande, c'est-à-dire les caractéristiques représentatives du tiroir, ainsi que des paramètres de fonctionnement des éléments fonctionnels 362. Ces paramètres de fonctionnement sont, par exemple, un réglage de puissance à fournir à la charge électrique 104, un réglage de seuil de déclenchement du relais de protection thermique, ou des seuils de détection de capteurs de fonctionnement.

En pratique, un bloc mémoire 780 enregistre, à propos du module d'entrées-sorties 206 associé au bloc mémoire, des informations qui sont par exemple le type de la charge électrique 104 connectée au module d'entrées-sorties et/ou le type des capteurs disposés au niveau de la charge électrique et connectés au module d'entrées-sorties.

Ces paramètres de fonctionnement sont généralement sauvegardés au niveau de la carte électronique de contrôle 364 du tiroir de contrôle-commande 138.

En outre, chaque bloc mémoire 780 communique avec le module de communication 134 de la colonne de démarrage moteur 110 correspondante. En effet, chaque bloc mémoire 780 est relié aux circuits électroniques 604, grâce à des circuits de connexion 782 visibles à la figure 34, permettant ainsi cette communication.

Les blocs mémoire 780 sont particulièrement avantageux au cours de l'utilisation de l'armoire électrique 100, et particulièrement au cours des phases de maintenance de l'armoire électrique 100.

En effet, en cas de remplacement d'un ancien tiroir de contrôle-commande 138 d'une colonne de démarrage moteur 110 par un nouveau tiroir de contrôle-commande, une première méthode de vérification est réalisée par le module de communication 134, ou par l'ordinateur industriel 130 par l'intermédiaire du module de communication 134, comprenant au moins les étapes suivantes :
a) détecter le type de l'ancien tiroir de contrôle-commande 138 initialement installé à un emplacement donné, à partir des informations enregistrées dans le bloc mémoire 780 associé au tiroir ;
b) vérifier si le type du nouveau tiroir de contrôle-commande 138 installé en remplacement correspond au type de l'ancien tiroir et/ou est compatible avec le type de la charge électrique 104, à partir des informations enregistrées dans le bloc mémoire 780 associé au tiroir ;
c) déterminer si le nouveau tiroir est adapté pour remplacer l'ancien tiroir ;
d) dans le cas où le nouveau tiroir de contrôle-commande 138 est déterminée à l'étape c) comme adapté pour remplacer l'ancien tiroir, régler les paramètres de fonctionnement des éléments fonctionnels 362 du nouveau tiroir, en les sauvegardant dans la carte électronique de contrôle 364 du nouveau tiroir, à partir des informations enregistrées dans le bloc mémoire 780, de sorte que ces paramètres de fonctionnement soient identiques aux paramètres de fonctionnement de l'ancien tiroir ; et
e) dans le cas où le nouveau tiroir de contrôle-commande 138 est déterminé à l'étape c) comme non-adapté pour remplacer l'ancien tiroir, empêcher le démarrage du nouveau tiroir de contrôle-commande et signaler une anomalie.

Cette première méthode de vérification est avantageuse car elle permet de s'assurer qu'un remplacement de tiroir de contrôle-commande est correctement réalisé et permet d'effectuer un tel remplacement sans devoir indiquer de paramètres de fonctionnement au nouveau tiroir de contrôle-commande, ces paramètres de fonctionnement étant automatiquement chargés.

Avantageusement, si au cours de l'étape b) il est détecté que le type du nouveau tiroir de contrôle-commande 138 n'est pas identique au type de l'ancien tiroir, mais que le nouveau tiroir est compatible avec le type de la charge électrique 104, alors au cours de l'étape c), le nouveau tiroir est déterminé comme adapté à remplacer l'ancien tiroir et l'étape d) est réalisée, et un signal indiquant la différence de type entre le nouveau tiroir et l'ancien tiroir est émis, par exemple par l'intermédiaire d'un message affiché sur l'afficheur 302. Par exemple, le nouveau tiroir de contrôle-commande 138 peut comporter des éléments fonctionnels 362 permettant de contrôler une charge électrique de plus forte puissance que l'ancien tiroir, mais également adaptés pour contrôler la charge électrique associée au tiroir. Le nouveau tiroir est alors compatible avec la charge électrique, et peut donc être utilisé en remplacement de l'ancien tiroir, même si le nouveau tiroir est d'un type différent de l'ancien tiroir.

En variante, la première méthode de vérification est réalisée par le module d'entrées-sorties 206 associé au tiroir de contrôle-commande 138 remplacé. Le module d'entrées-sorties est alors équipé d'une unité de calcul configurée pour exécuter les étapes a) à e) et accéder aux informations enregistrées dans le bloc mémoire 780 associé à ce tiroir.

En cas de remplacement d'un ancien module d'entrées-sorties 206 par un nouveau module d'entrées-sorties, ce qui implique de câbler à nouveau les borniers de connexion 510 de ce module, une deuxième méthode de vérification est réalisée par le module de communication 134, ou par l'ordinateur industriel 130 par l'intermédiaire du module de communication 134, comprenant au moins les étapes suivantes :
a) détecter le type de la charge électrique 104 associée au nouveau module d'entrées-sorties 206 et/ou le type des capteurs disposés au niveau de la charge électrique connectés au module d'entrées-sorties, à partir des informations enregistrées dans le bloc mémoire 780 associé à ce nouveau module d'entrées-sorties ;
b) vérifier si le type de cette charge électrique et/ou de ces capteurs branchés au nouveau module d'entrées-sorties correspond au type de la charge électrique et/ou des capteurs initialement branchés à l'ancien module d'entrées-sorties ;
c) déterminer si la charge électrique 104 et/ou les capteurs branchés au nouveau module d'entrées-sorties correspondent bien à la charge électrique 104 et/ou aux capteurs branchés à l'ancien module d'entrées-sorties ;
d) si tel est le cas, autoriser le démarrage de la charge électrique 104 ; et
e) dans le cas contraire, empêcher le démarrage de la charge électrique 104 et signaler une anomalie.

Cette deuxième méthode de vérification est avantageuse car elle permet de s'assurer qu'un remplacement de module d'entrées-sorties 206 est correctement réalisé, et plus particulièrement que les raccordements aux borniers de connexion 510 sont correctement réalisés.

En variante, la deuxième méthode de vérification est réalisée par le nouveau module d'entrées-sorties 206. Le nouveau module d'entrées-sorties est alors équipé d'une unité de calcul configurée pour exécuter les étapes a) à e) et accéder aux informations enregistrées dans le bloc mémoire 780 associé à ce module d'entrées-sorties.

En outre, en cas de remplacement du module de communication 134 d'une colonne de démarrage moteur 110, une méthode de récupération de données est réalisée par le nouveau module de communication, qui consiste à récupérer les paramètres de fonctionnement des tiroirs de contrôle-commande 138 et/ou les informations liées aux charges électriques 104 à partir des informations enregistrées dans les blocs mémoire 780 pour que le nouveau module de communication 134 dispose de ces informations.

Cette méthode de récupération de données est particulièrement avantageuse, car elle évite de devoir fournir manuellement un grand nombre de données au nouveau module de communication 134, ce qui serait fastidieux, ces données étant ici automatiquement récupérées.

Dans la variante où la colonne de démarrage moteur 110 ne comprend pas de module de communication 134, cette méthode de récupération de données s'applique de manière similaire au remplacement de l'ordinateur industriel 130.

En outre, le fait que les blocs mémoire 780 sont disposés sur les tronçons de bus informatique 204 est particulièrement avantageux, car les tronçons de bus informatique sont des éléments fiables, peu propice à des pannes, qui ne sont donc généralement pas remplacés au cours de la durée de vie de l'armoire électrique 100. Ainsi, les informations enregistrées dans ces blocs mémoires 780 ne sont pas perdues, même au cours d'opérations de maintenance complexes dans lesquelles, par exemple, un remplacement simultané de tiroirs de contrôle-commande 138, des modules d'entrées-sorties 206 associés et du module de communication 134 aurait lieu.

Le raccordement d'un tiroir 138 à une charge électrique 104, c'est-à-dire l'alimentation en énergie de cette charge électrique par ce tiroir 138, s'effectue par l'intermédiaire d'un module de raccordement externe 208. Ainsi, un module de raccordement externe 208 est associé à chaque tiroir 138.

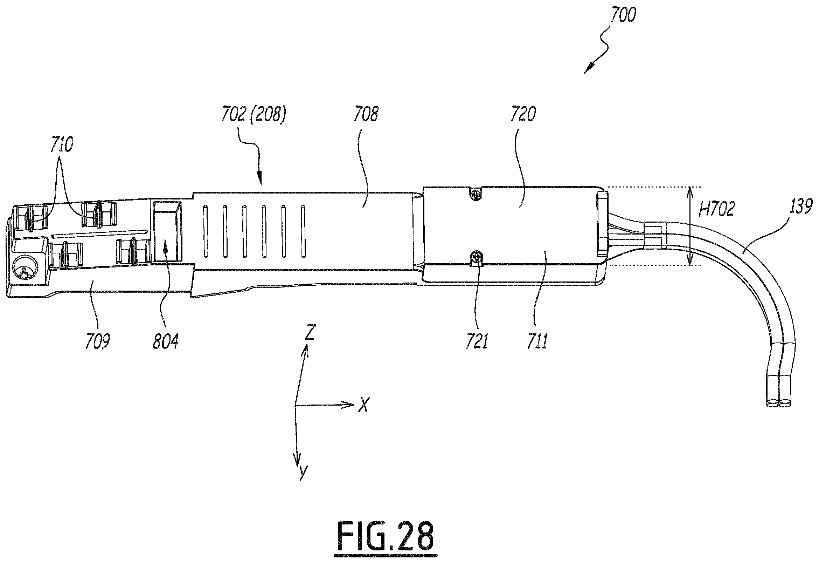

Trois types de modules de raccordement externe 208 sont représentés aux figures 28 à 33. Ces trois types de modules forment ensemble un jeu de modules de raccordement externe 700 qui est représenté partiellement sur chacune de ces figures.

Chaque module de raccordement du jeu de modules 700 est configuré pour permettre le raccordement d'un tiroir 138 à une charge électrique 104 consommant une puissance électrique comprise dans une plage de données donnée.

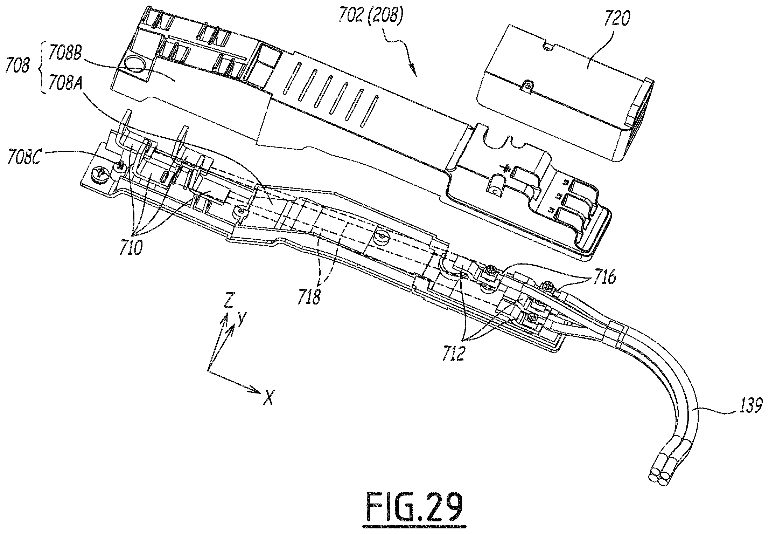

Un premier module de raccordement externe 702 est représenté aux figures 28 et 29. Ce premier module de raccordement est configuré pour raccorder un tiroir 138 à une charge électrique 104 de faible puissance, par exemple inférieure à 11 kW.

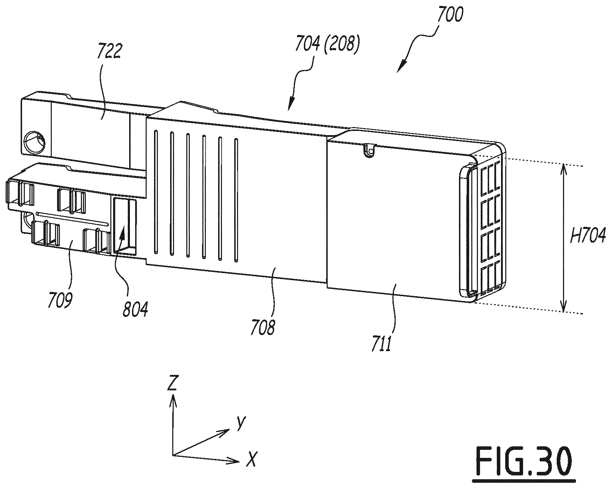

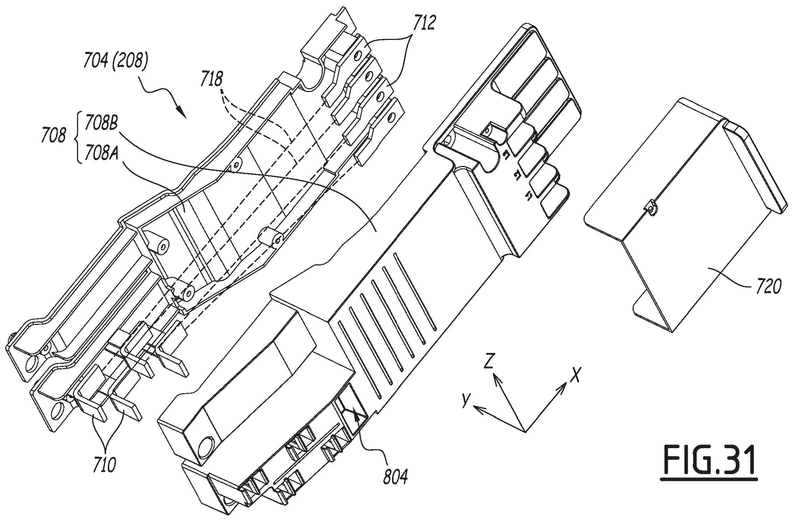

Un deuxième module de raccordement externe 704 est représenté aux figures 30 et 31. Ce deuxième module de raccordement est configuré pour raccorder un tiroir 138 à une charge électrique 104 de puissance moyenne, par exemple comprise entre 11 kW et 30 kW.

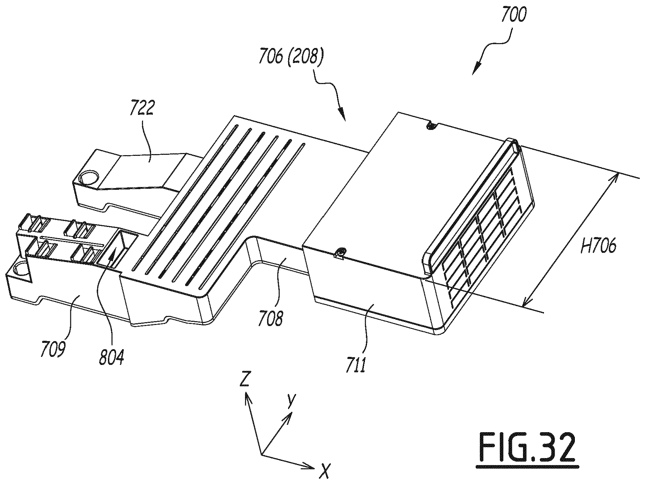

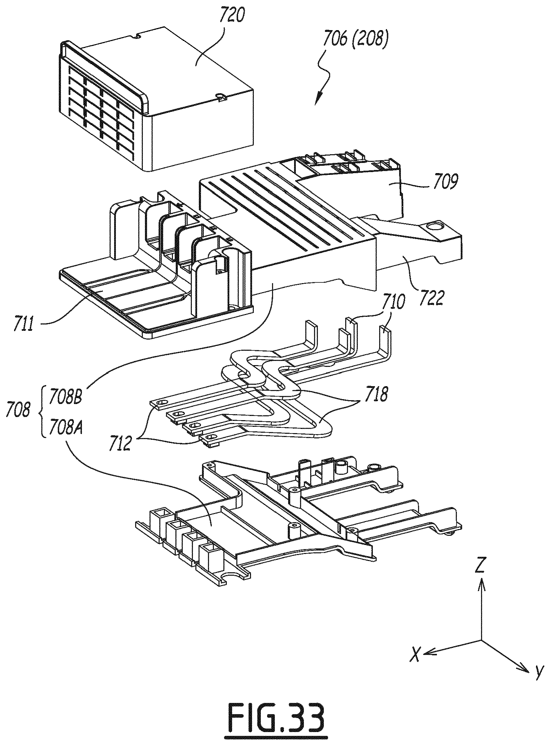

Un troisième module de raccordement externe 706 est représenté aux figures 32 et 33. Ce troisième module de raccordement est configuré pour raccorder un tiroir 138 à une charge électrique 104 de forte puissance, par exemple comprise entre 30 kW et 75 kW.

Ainsi, le choix d'un module de raccordement externe à installer sur un module de démarrage moteur dépendra de la puissance électrique requise par la charge électrique 104 raccordée à ce module.

Les modules de raccordement externe 702, 704 et 706 comprennent chacun un boîtier 708. Le boîtier 708 comprend en pratique deux demi-boîtiers formant respectivement une base 708A et un couvercle 708B, assemblés par des moyens de fixation, tels que des vis 708C visibles uniquement pour le module de raccordement externe 702 à la figure 29.

Le boîtier 708 du module de raccordement externe 702 a une hauteur H702 égale à 1U.

Le boîtier 708 du module de raccordement externe 704 a une hauteur H704 égale à 2U.

Le boîtier 708 du module de raccordement externe 706 a une hauteur H706 égale à 3U.

De préférence, le module de raccordement externe 702 est associé à un tiroir 138 de hauteur 1U ou 2U, le module de raccordement externe 704 est associé à un tiroir 138 de hauteur 2U, 3U, 4U, 5U ou 6U et le module de raccordement externe 706 est associé à un tiroir 138 de hauteur 5U ou 6U. Ainsi, la hauteur d'un module de raccordement externe est toujours inférieure ou égale à la hauteur du tiroir qui lui est associé.

Une première extrémité 709 du boîtier 708 de chaque module de raccordement externe porte des connecteurs d'entrée 710.

La hauteur de la première extrémité 709 est égale à 1U, indépendamment de la hauteur du boîtier 708.

Une deuxième extrémité 711 du boîtier 708 de chaque module de raccordement externe porte des connecteurs de sortie 712.

La hauteur de la deuxième extrémité 711 est égale à la hauteur H702, H704 ou H706 du boîtier 708.

En pratique, les connecteurs d'entrée 710 et de sortie 712 sont disposés sur une même face du boîtier 708, c'est-à-dire que, lorsque le boîtier est assemblé sur le module de démarrage moteur 200, les connecteurs d'entrée 710 et de sortie 712 font face à la même face de l'armoire 100, dans l'exemple la face avant F1.

Dans l'exemple, la première extrémité 709 comprend quatre connecteurs d'entrée et la deuxième extrémité comprend quatre connecteurs de sortie.

Les connecteurs d'entrée 710 sont configurés pour être connectés aux connecteurs aval 356 du tiroir 138 associé au module de raccordement. En d'autres termes, les connecteurs aval 356 d'un tiroir alimentent en énergie électrique le module de raccordement externe 702, 704 ou 706 associé à ce tiroir. Ainsi, le tiroir 138 est une source d'électricité pour le module de raccordement.

La hauteur constante de la première extrémité 709 est avantageuse car elle est égale à la hauteur de la base 328 du tiroir 138. Une première extrémité 709 permet alors le raccordement tous les tiroir 138, indépendamment de leur hauteur.

Les connecteurs de sortie 712 sont configurés pour être raccordés à la charge électrique 104 par l'intermédiaire des câbles de raccordement 139.

En pratique, les câbles électriques de raccordement 139 sont raccordés aux connecteurs de sortie 712 par des cosses 716, comme visible à la figure 29.

Dans le boîtier 708, les connecteurs d'entrée 710 et les connecteurs de sortie 712 sont électriquement reliés par des câbles ou des barres conductrices 718. Dans les premier et deuxième modules de raccordement externe 702 et 704, compte tenu de la puissance transmise, il est possible d'utiliser des câbles conducteurs entre les connecteurs 710 et 712, ces câbles étant représentés par leurs traits d'axe respectifs aux figures 29 et 31 Dans troisième module de raccordement externe 706, compte tenu de la puissance transmise, on utilise, entre les connecteurs 710 et 712, des barres de raccordement visibles à la figure 33. Dans ce dernier cas, les connecteurs 710 et 712 sont formés par les extrémités des barres 718.

En pratique, chaque module de raccordement externe comprend quatre câbles conducteurs ou barres conductrices 718, c'est-à-dire une barre par connecteur d'entrée et par connecteur de sortie.

Les câbles conducteurs ou barres conductrices 718 sont adaptés à la puissance consommée par la charge électrique 104 raccordée aux connecteurs de sortie 712.

Ainsi, pour une charge électrique de forte puissance, par exemple entre 30 kW et 75 kW, les barres conductrices 718 sont par exemple des barres de cuivre de section comprise entre 16 et 50 mm², par exemple égale à 50 mm² pour une charge électrique de 75 kW.

Dans le cas d'une charge électrique de faible puissance, par exemple inférieure à 11 kW, les câbles conducteurs 718 sont de section plus faible, par exemple comprise entre 1 et 6 mm², par exemple égale à 6 mm² pour une charge électrique de 11 kW.

En variante, les câbles conducteurs 718 des premier et deuxième modules de raccordement externe 702 et 704 peuvent être remplacés par des barres conductrices.

En pratique, plus la puissance délivrée à une charge électrique est importante, plus la section des câbles conducteurs et barres conductrices 718 est importante, ce qui nécessite que le module de raccordement externe comprenant de tels câbles conducteurs ou barres conductrices soit plus haut. C'est pourquoi le troisième module de raccordement externe 706 a une hauteur H706 plus importante que la hauteur H704 deuxième module 704, elle-même plus importante que la hauteur H702 du module 702.

La deuxième extrémité 711 de chaque module de raccordement externe comprend, en outre, un cache 720, qui recouvre les connecteurs de sortie 712. Lorsque le cache 720 est installé, les connecteurs 712 ne sont pas accessibles depuis l'extérieur du boîtier 708 et sont donc protégés, ce qui empêche tout contact avec les cosses 716. Lorsque le cache 720 est retiré, les connecteurs 712 sont accessibles, ce qui permet de raccorder les câbles 139 aux connecteurs.

De préférence, le cache 720 est transparent, ce qui permet de contrôler le bon raccordement des câbles 139 sans rendre ces câbles accessibles.

De préférence, le cache 720 est assemblés au boîtier 708 par des moyens de fixation, tels qu'une vis 721 visible uniquement pour le module de raccordement externe 702.

Comme visible à la figure 8, le boîtier 708 de chaque module de raccordement externe est fixé au support arrière 210 de la structure 202 du module de démarrage moteur 200, par exemple à l'aide de vis, au niveau de sa première extrémité 709, c'est-à-dire au niveau de l'extrémité qui comporte les connecteurs d'entrée 710.

Le boîtier 708 s'étend donc depuis le support arrière 210 en porte-à-faux, en s'éloignant du module de démarrage moteur 200.

En outre, le boîtier 708 de chaque module de raccordement externe 704 et 706, c'est-à-dire d'un module de hauteur 2U et 3U, comprend un renfort 722, qui s'étend depuis le boîtier 708 parallèlement à la première extrémité 709 et qui est également fixé au support arrière 210.

Le renfort 722 a une hauteur égale à 1U. Il est monobloc avec le couvercle 708B.

La première extrémité 709, et éventuellement le renfort 722, sont disposés dans le volume V1 et dans la zone fonctionnelle 156 de la colonne de raccordement 110.

Le reste du boîtier 708 et la deuxième extrémité 711 s'étendent dans la zone de câblage 160 de la colonne de raccordement 110.

En pratique, la zone fonctionnelle 156 et la zone de câblage 160 sont séparées par le support latéral 212 du module de démarrage moteur. Ainsi, la première extrémité 709 d'un module de raccordement externe 702, 704 et 706 s'étend au-travers du support latéral 212, et plus particulièrement au travers d'une ouvertures 220 ménagées dans le support latéral 212.

Le renfort 722 du boîtier 708 d'un module de raccordement externe 704 et 706 s'étend également au-travers d'une ouverture 220 du support latéral 212.

En variante, les modules de raccordement externe sont configurés pour que les connecteurs d'entrée 710 et de sortie 712 soient disposées deux faces opposées. Une telle configuration est avantageuse lorsque le raccordement des câbles 139 s'effectue par l'arrière de l'armoire électrique 100, comme dans la variante de la figure 5.

En outre, chaque tiroir 138 comprend deux organes de centrage 800, disposés sur la partie arrière 348 du tiroir et qui s'étendent selon l'axe Y en dehors du tiroir. Chaque organe de centrage 800 a une forme de biseau, c'est-à-dire que son extrémité libre est moins large que sa base rattachée à la partie arrière du tiroir, avec laquelle il est de préférence monobloc.

Ces organes de centrage 800 permettent de garantir un bon positionnement du tiroir 138 dans le module de démarrage moteur 200 lorsqu'il est déplacé jusqu'à sa position de fonctionnement.

Pour cela, l'unité de protection 140 comprend des cavités de centrage 802 et chaque module de raccordement externe 702, 704 et 706 comprend une cavité de centrage 804.

Les cavités de centrage 802 de l'unité de protection 140 sont disposées entre les groupes de connecteurs 246 et la face intérieure 238 de l'unité de protection 140, comme visible à la figure 11

Les cavités de centrage 804 de chaque module de raccordement externe 702, 704 et 706 sont disposées sur le couvercle 708B de chaque boîtier 708, à proximité de la première extrémité 709 et des connecteurs d'entrée 710.

Les cavités de centrage 802 de l'unité de protection et 804 de chaque module de raccordement externe sont dirigées vers le volume V1 du module de démarrage moteur 200.

Les cavités de centrage 802 et 804 sont de formes complémentaires à celle des organes de centrage 800 et sont positionnées de manière à ce qu'en position de fonctionnement du tiroir, un premier organe de centrage 800 d'un tiroir 138 soit reçu dans une cavité de centrage 802 et un deuxième organe de centrage d'un tiroir 138 soit reçu dans une cavité de centrage 804.

Lorsqu'un tiroir 138 est déplacé depuis sa position de test vers sa position de fonctionnement, les organes de centrage 800 du tiroir 138 s'insèrent progressivement dans les cavités de centrage 802 et 804 et, grâce à la forme en biseau des organes de centrage 800, cette insertion progressive permet de centrer le tiroir 138 par rapport aux cavités de centrage 802 et 804 et donc par rapport au module de démarrage moteur 200.

Grâce aux modules de raccordement externe 208 du jeu de modules 700, les raccordements des charges électriques 104 aux tiroirs 138 sont déportés depuis la zone fonctionnelle 156 vers la zone de câblage 160. Cela est avantageux, car la zone de câblage 160 est facilement accessible, ce qui simplifie le raccordement des câbles électriques 139 aux connecteurs de sortie 712.

En variante, le nombre de types de module de raccordement externe 208 au sein du jeu de modules de raccordement externe peut être différent de trois, notamment égal à 2, 4, 5 ou 6.

En résumé, l'alimentation électrique principale délivrée par le câble d'alimentation 102 est conduite dans l'armoire électrique 100 d'abord par la colonne d'alimentation 106, puis est redistribuée à chaque unité de protection 140 de chaque colonne de démarrage moteur 110 par les jeux de barres 114, 118 et 122, puis est redistribuée à chaque tiroir 138 par les connecteurs 248 et 354, puis est redistribuée à chaque module de raccordement externe 208 par les connecteurs 356, puis est redistribuée à chaque charge électrique 104 par chaque module de raccordement externe 208.

En résumé, de nombreux échanges de données sont effectués dans l'armoire électrique 100 :
- les données de fonctionnement provenant de capteurs situés sur chaque charge électrique 104 sont transmises par le module d'entrées-sorties 206 associé à cette charge d'une part au tiroir 138 et d'autre part au module de communication 134, par l'intermédiaire du bus informatique 142 ;
   o dans le tiroir 138, ces données sont, d'une part ,prises en compte par la carte électronique de contrôle 364 pour adapter le fonctionnement du tiroir 138,
   o dans le tiroir 138, ces données sont, d'autre part, si nécessaire, transmises à l'unité de protection 140, par exemple lorsque ces données proviennent de l'activation d'un bouton d'arrêt d'urgence situé à proximité de la charge électrique 104, avec pour objectif de couper l'alimentation électrique au niveau de l'unité de protection 140, et
   o dans le module de communication 134, ces données sont transmises à l'ordinateur industriel 130,
- chaque tiroir 138 transmet des données sur son propre fonctionnement au module de communication de la colonne de raccordement 110 comprenant ce tiroir ;
- le module de communication 134 de chaque colonne de raccordement 110 échange des données sur le fonctionnement de cette colonne de raccordement à l'ordinateur industriel 130 ainsi qu'aux modules de communication des autres colonnes de raccordement 110 de l'armoire 100, lorsque l'armoire comprend plusieurs colonnes de raccordement ; et
- l'ordinateur industriel 130 transmet des commandes au module de communication 134 de chaque colonne de raccordement 110, ces données sont ensuite réparties par le switch managé 135 et transmises aux tiroirs 138 par le bus informatique 142 et le module d'entrées-sorties 206.

L'installation d'une colonne de démarrage moteur 110, qui inclut un module de communication 134 et au moins un module de démarrage moteur 200 , comprend une phase d'assemblage et une phase de raccordement.

La phase d'assemblage comprend des étapes qui consistent à :
a) assembler le module de communication 134 à l'ossature 164 de la colonne de démarrage moteur ;
b) assembler chaque module de démarrage moteur 200, c'est-à-dire fixer l'unité de protection 140, le tronçon de bus informatique 204, chaque module d'entrées-sorties 206 et chaque module de raccordement externe 208 à la structure 202 du module de démarrage moteur ;
c) fixer chaque module de démarrage moteur sur l'ossature 164, en emboîtant les tronçons de bus informatique 204 entre eux et en emboîtant le tronçon de bus informatique d'un module de démarrage moteur sur le raccord de bus informatique 650 ;
d) fixer un cavalier d'entrées-sorties sur chaque connecteur linéaire 610 libre et un cavalier d'extrémité mâle ou femelle sur l'extrémité libre du bus informatique 142 ; et
e) installer les tiroirs 138 dans chaque module de démarrage moteur.

En pratique, l'ordre des étapes a) à e) peut être différent. Notamment, les étapes b), c) et d) peuvent être inversées et l'étape a) peut être réalisée à tout autre moment. Toutefois, l'étape e) est toujours postérieure aux étapes a) à c).

Notamment, en variante, la structure 202 d'un module de démarrage moteur est dans un premier temps fixée à l'ossature 164 de la colonne de démarrage moteur, puis l'étape b) d'assemblage du module de démarrage moteur 200 est réalisée.

La phase de raccordement permettant la mise en service de l'armoire électrique 100 est réalisée après la phase d'assemblage et comprend des étapes qui consistent à :
a) raccorder les connecteurs de façade 650 du raccord de bus informatique 650 au module de communication 134 ;
b) raccorder les borniers de connexion 510 de chaque module d'entrées-sorties 206 de chaque module de démarrage moteur 200 aux charge électriques 104, de manière à relier les capteurs de la charge électrique au module d'entrées-sorties et à alimenter la charge électrique en deuxième tension électrique auxiliaire ; et
c) raccorder les modules de raccordement externe 208 aux charges électriques 104 avec les câbles 139, de sorte à alimenter les charges électriques 104 avec l'alimentation électrique principale.

En pratique, le raccordement de l'alimentation électrique principale aux charges électriques 104 ne nécessite le raccordement que des câbles 139.

Ainsi, l'armoire électrique 100 décrite ici, et plus particulièrement la colonne de démarrage moteur 110, est avantageuse, car :
- l'ensemble des raccordements nécessaires pour la mise en service de l'armoire électrique 100 sont réalisés dans la zone de raccordement 158. Cela est avantageux, car cela simplifie les raccordements de l'armoire électrique. Notamment, aucun raccordement n'est requis dans la zone fonctionnelle 156.
- un grand nombre de connexions internes à l'armoire sont effectuées par emboîtement ou embrochement de connecteurs, ce qui est plus simple que la mise en place de câbles électriques de raccordement.
- les câbles électriques raccordés dans l'armoire électrique proviennent tous de la zone de raccordement 158. Ainsi, leur gestion est plus simple : lorsque l'armoire électrique 100 comprend une zone de câblage 160, comme à la figure 3, tous ces câbles peuvent être regroupés en un faisceau de câbles dans cette zone de câblage, et lorsque l'armoire électrique 100 ne comprend pas de zone de câblage 160, comme à la figure 5, tous ces câbles peuvent être regroupés en un faisceau de câbles qui sort de l'armoire 100 par sa face arrière F2.

L'orientation des éléments compris dans un module de démarrage moteur 200 décrits ci-avant concerne un module de démarrage moteur disposé dans une colonne de raccordement située à droite d'une colonne de distribution électrique, sur les figures 1 à 5.

En pratique, le module de démarrage moteur 200 décrit précédemment peut également être disposé dans une colonne de raccordement située à gauche d'une colonne de distribution électrique, sur les figures 1 à 5 Pour cela, le module de démarrage moteur 200 est simplement tourné de 180 degrés autour d'un axe parallèle à l'axe transversal Y.

Ainsi, un module de démarrage moteur 200 n'a pas d'orientation privilégiée : l'unité de protection 140, le tronçon de bus informatique 204, chaque tiroir 138, chaque module d'entrées-sorties 206 et chaque module de raccordement externe 208 sont configurés pour fonctionner indépendamment de leur orientation spatiale.

Par exemple, un tiroir 138 d'une colonne de raccordement située à gauche d'une colonne de distribution électrique sera disposé de manière à ce que sa base 328 soit disposée en haut et son capot en bas. Tous les éléments contenus dans un tiroir 138 étant fixés à la base 328, cette disposition n'impacte pas le fonctionnement du tiroir. Cette disposition n'impacte pas non plus le refroidissement du tiroir par le flux d'air FL1, puisque le flux d'air FL1 est horizontal, et n'est donc pas affecté par un changement d'orientation. Une telle disposition est visible à la figure 1.

Ce fonctionnement d'un module de démarrage moteur 200 indépendant de l'orientation de ce module est intéressant pour plusieurs raisons :
- il permet d'utiliser des pièces identiques pour une colonne de raccordement située à gauche ou à droite d'une colonne de distribution électrique, ce qui est économe et facilite la conception d'une armoire 100 ; et
- il permet de disposer deux colonnes de raccordement de chaque côté d'une colonne de distribution électrique 108 - de manière à former une colonne fonctionnelle 111 -, ce qui permet de mutualiser la colonne de distribution électrique entre deux colonnes de raccordement, ce qui est économe et ce qui permet de réduire l'encombrement de l'armoire 100.

De même, un module de communication 134 n'a pas d'orientation privilégiée et par rapport à l'orientation décrite dans cet exposé, un module installé dans une colonne de raccordement située à gauche d'une colonne de distribution électrique sera retourné de 180 degrés autour d'un axe parallèle à l'axe transversal Y, tout comme le raccord de bus informatique 650 qui y est fixé.

L'agencement intérieur de la colonne de raccordement de gauche et de droite des figures 1 à 5 est donc symétrique par rapport au plan P2 visible à la figure 2.

En outre, la carte électronique de contrôle 364 d'un tiroir 138 est configurée pour détecter l'orientation du tiroir 138, par exemple à l'aide d'un capteur intégré à la carte, et pour contrôler l'afficheur 302 de sorte que les informations qui y sont affichées soient orientées de manière à être facilement lisibles depuis l'extérieur de l'armoire 100. L'afficheur 302 est donc configuré pour adapter l'orientation des informations qui y sont affichées à l'orientation du tiroir 138.

En variante non-représentée de l'invention, l'armoire électrique 100 ne comprend pas de modules de démarrage moteur et l'unité de protection, le tronçon de bus informatique, les tiroirs de contrôle-commande, les modules d'entrées-sorties et les modules de raccordement externe sont directement disposés dans l'armoire électrique 100, fixés à l'ossature 164.

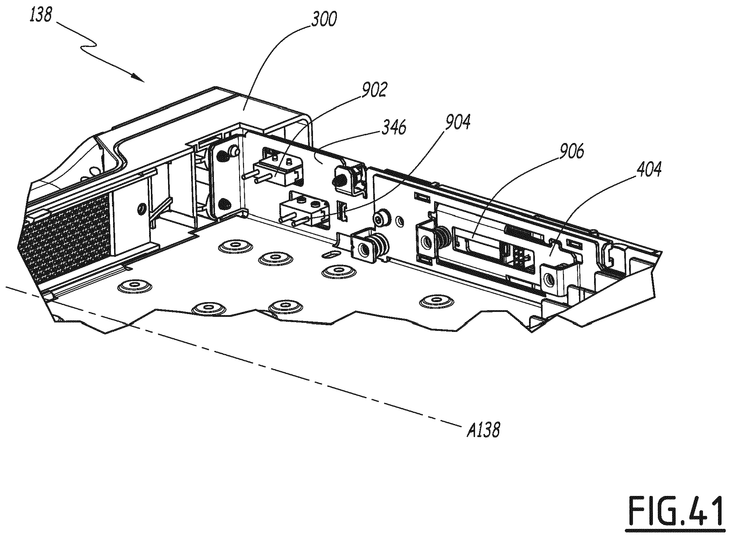

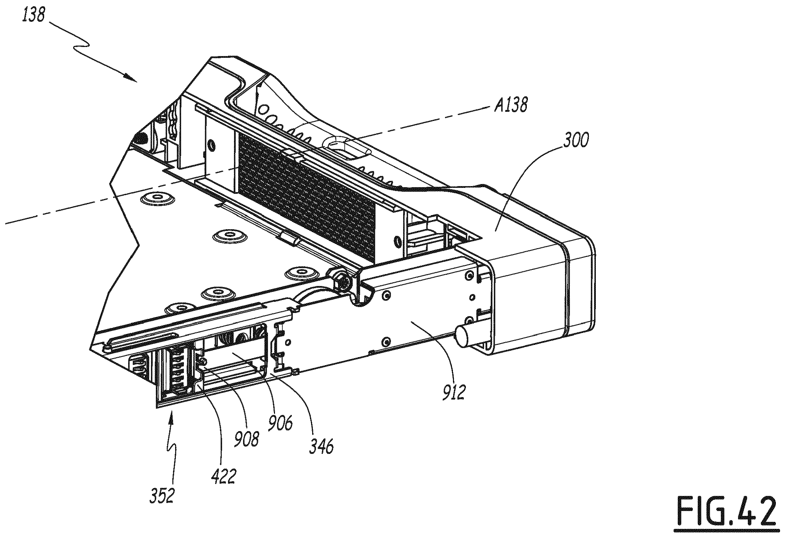

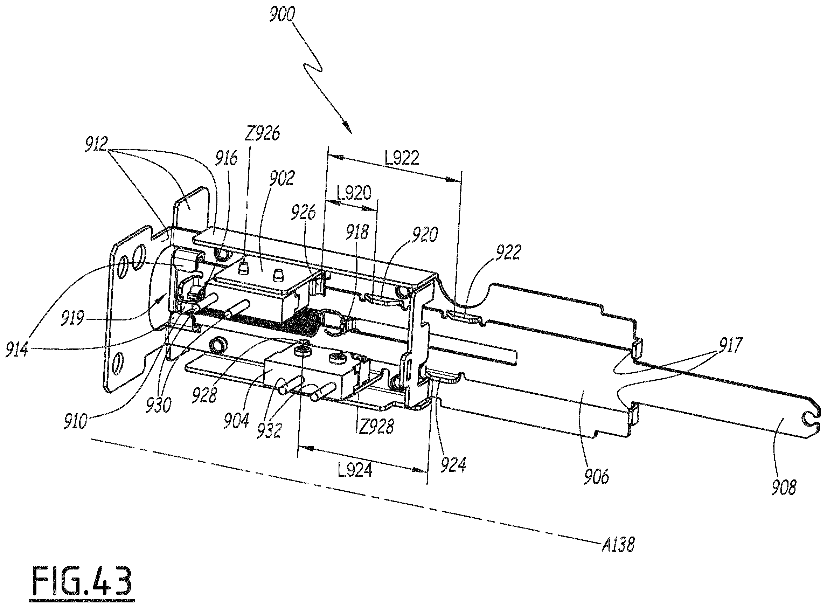

Sur les figures 41 et 42, un tiroir 138 de hauteur égale à 1U est représenté sans son capot 330. Ce tiroir est similaire au tiroir représenté aux figures 15 à 17, mais comprend, en outre, un module de détection de position 900 qui est représenté seul à la figure 43.

Dans ce qui suit, les éléments du tiroir 138 des figures 41 et 42 analogues à ceux du tiroir 138 représenté aux figures 15 à 17 portent les mêmes références et fonctionnent de la même façon. Dans ce qui suit, on décrit principalement les différences entre le tiroir des figures 15 à 17 et le tiroir des figures 41 et 42. En outre, si un composant est mentionné dans la description suivante du tiroir 138 sans être représenté les figures 41 et 42, il correspond au même élément représenté sur les figures 1 à 40.

Sur les figures 41 et 42, les éléments fonctionnels 362 et la carte électronique de contrôle 364 du tiroir 138 ne sont pas représentés.

Le module de détection de position 900 est fixé sur la base 328 du tiroir 138. Dans l'exemple, le module de détection de position 900 est fixé sur l'une des deux structures latérales 346, de préférence sur la structure latérale qui ne comprend pas le verrou mécanique 820. En variante, le module de détection de position 900 est fixé sur la même structure latérale que le verrou mécanique 820.

Le module de détection de position 900 comprend des détecteurs prévus pour détecter lorsque le tiroir 138 est en position de test et pour détecter lorsque le tiroir est en position de fonctionnement. Dans l'exemple, le module de détection de position comprend deux détecteurs 902 et 904. Les deux détecteurs 902 et 904 sont reliés à la carte électronique de contrôle 364, de sorte à transmettre à la carte électronique de contrôle des informations sur la position du tiroir 138.

Le module de détection de position 900 comprend également un actionneur 906, prévu pour actionner les détecteurs 902 et 904. L'actionneur 906 est dans l'exemple une tringle de commande. La tringle de commande 906 comprend une première extrémité 908 et une deuxième extrémité 910.

La première extrémité 908 est fixée au contact mobile 352 de la structure latérale 346 sur laquelle le module de détection de position 900 est fixé. Plus précisément, la première extrémité est fixée au cadre 422 du contact mobile 352. Ainsi, la première extrémité 908 est solidaire du cadre 422 de sorte qu'une translation du cadre 422 selon l'axe Y entraîne une translation de la tringle de commande 906 selon l'axe Y, c'est-à-dire selon l'axe longitudinal A138 du tiroir. En d'autres termes, la tringle de commande 906 est mobile en translation par rapport à la structure latérale 346 selon l'axe longitudinal A138 du tiroir.

La translation de la tringle de commande 906 par rapport à la structure latérale 346 est avantageusement guidée par une structure fixe 912 du module de détection de position 900, qui comprend notamment des guides 914 au niveau de la deuxième extrémité 910.

La structure fixe 912 est fixée à la structure latérale 346, par exemple par vissage. En outre, dans l'exemple, la structure fixe 912 comprend deux parties assemblées entre elles, par exemple par rivetage. À la figure 43, les différentes parties de la structure fixe sont repérées par la même référence 912.

Avantageusement, le module de détection de position 900 comprend un organe de rappel élastique 916. L'organe de rappel élastique 916 relie la structure fixe 912 à la tringle de commande 906 de sorte que, en l'absence d'autres forces s'appliquant sur la tringle de commande, la tringle de commande est rappelée dans une position qui correspond à la position représentée à la figure 43. En d'autres termes, la tringle de commande 906 a une position stable, ou position de repos, qui est celle représentée à la figure 43, et l'organe de rappel élastique 916 tend à ramener la tringle de commande vers cette position stable.

Ici, la tringle de commande 906 comprend une butée 917, qui est en appui contre la structure fixe 912 lorsque la tringle de commande est en position de repos, et qui empêche un mouvement de la tringle de commande au-delà de sa position de repos. Ici, la butée 917 est formée de deux languettes pliées à angle droit par rapport à la partie principale de la tringle de commande.

Dans l'exemple, l'organe de rappel élastique 916 est un ressort de traction dont une première extrémité est fixée à un crochet 918 de la structure fixe 912 et dont une deuxième extrémité est fixée à la deuxième extrémité 910 de la tringle de commande.

En pratique, la tringle de commande 906 est en position de repos lorsque le tiroir 138 est entre sa position déconnectée et sa position d'engagement, et la tringle de commande se déplace selon l'axe A138 par rapport à la structure latérale 346 lorsque le tiroir est entre sa position d'engagement et sa position de fonctionnement, tout comme le cadre 422.

Dans l'exemple, le module de détection de position 900 est orienté de sorte que la deuxième extrémité 910 de la tringle de commande 906 est située à proximité de la partie frontale 300 du tiroir 138 et de sorte que la première extrémité 908 est éloignée de la partie frontale du tiroir. Au cours du déplacement de la tringle de commande 906, la deuxième extrémité 910 s'éloigne des détecteurs 902 et 904 et se rapproche de la partie frontale 300, jusqu'à être située dans la partie frontale, en s'étendant au travers d'une fenêtre 919 ménagée dans la structure fixe 912. En pratique, un espace vide est prévu dans la partie frontale 300 pour accommoder la présente de la deuxième extrémité 910.

La tringle de commande 906 comprend deux cames hautes 920 et 922 et une came basse 924. Les deux cames hautes 920 et 922 sont situées dans un même plan parallèle à l'axe A138, c'est-à-dire qu'elles sont alignées selon l'axe Z, et sont décalées de la came basse 924 selon l'axe Z. Les cames hautes 920 et 922 sont prévues pour actionner le détecteur 902 et la came basse 924 est prévue pour actionner le détecteur 904.

On note L920 une longueur entre la came haute 920 et un élément d'actionnement 926 du détecteur 902, L922 une longueur entre la came haute 922 et l'élément d'actionnement 926, et L924 une longueur entre la came basse 924 et un élément d'actionnement 928 du détecteur 904, les longueurs L920, L922 et L924 étant mesurées selon l'axe A138. Avantageusement, la longueur L922 et égale à la longueur L924.

Les longueurs L920, L922 et L924 ont leurs valeurs respectives maximales lorsque la tringle de commande 906 est en position de repos, c'est-à-dire lorsque le tiroir 138 est entre sa position déconnectée et sa position d'engagement.

La longueur L920 est nulle lorsque le tiroir 138 est en position de test. Ainsi, lorsque le tiroir est en position de test, la came haute 920 est en contact avec l'élément d'actionnement 926 du détecteur 902, ce qui actionne le détecteur 902 et entraîne l'envoi d'un signal de détection depuis le détecteur 902 jusqu'à la carte électronique de contrôle 364, informant alors la carte électronique de contrôle que le tiroir est en position de test. En d'autres termes, la carte électronique de contrôle 364 détecte que le tiroir 138 est en position de test lorsqu'elle reçoit un signal du détecteur 902 actionné par la came haute 920.

Les longueurs L922 et L924 sont nulles lorsque le tiroir 138 est en position de fonctionnement. Ainsi, lorsque le tiroir est en position de fonctionnement, la came haute 922 est en contact avec l'élément d'actionnement 926 du détecteur 902 et la came basse 924 est en contact avec l'élément d'actionnement 928 du détecteur 904, ce qui actionne simultanément les détecteurs 902 et 904 et entraîne l'envoi de deux signaux de détection depuis les détecteurs 902 et 904 jusqu'à la carte électronique de contrôle 364, informant alors la carte électronique de contrôle que le tiroir est en position de fonctionnement. En d'autres termes, la carte électronique de contrôle 364 détecte que le tiroir 138 est en position de test lorsqu'elle reçoit simultanément un signal du détecteur 902 et du détecteur 904 actionnés par les cames haute 922 et basse 924.

Lorsque le tiroir 138 est dans une position intermédiaire entre la position de test et la position de fonctionnement, les cames hautes et la came basse ne sont pas en contact avec les éléments d'actionnement des détecteurs, et aucun signal de détection n'est envoyé à la carte électronique de contrôle 364.

Dans l'exemple, les détecteurs 902 et 904 sont des interrupteurs à contact sec et les éléments d'actionnement 926 et 928 sont des lames métalliques montées pivotantes autour d'axes respectifs Z926 et Z928, parallèles à l'axe Z.

Le détecteur 902 est relié à la carte électronique de contrôle 364 par deux fils 930, représentés de manière simplifiée sur les figures 41 à 43. Les deux fils 930 forment une boucle démarrant et se terminant au niveau de la carte électronique de contrôle, et passant par le détecteur 902 de sorte à ce que la lame métallique 926 du détecteur peut ouvrir ou fermer cette boucle. En pratique, la boucle formée par les deux fils 930 est fermée lorsque la lame métallique 926 est en contact avec la came haute 920 ou la came haute 922, car les cames hautes repoussent alors la lame métallique 926 en la faisant pivoter autour de l'axe Z926, et la boucle est ouverte lorsque la lame métallique n'est pas en contact avec une came haute. Lorsque la boucle formée par les fils 930 est fermée, alors la carte électronique de contrôle 364 reçoit un signal de détection en provenance du détecteur 902.

De la même manière, le détecteur 904 est relié à la carte électronique de contrôle 364 par deux fils 932, représentés de manière simplifiée sur les figures 41 à 43, qui forment une boucle qui est fermée lorsque la lame métallique 928 est en contact avec la came basse 924 et qui est ouverte lorsque la lame métallique n'est pas en contact avec la came basse. Lorsque la boucle formée par les fils 932 est fermée, alors la carte électronique de contrôle 364 reçoit un signal de détection en provenance du détecteur 904.

Dans l'exemple, la carte électronique de contrôle 364 est configurée pour détecter que le tiroir 138 est en position de test lorsqu'un signal de détection en provenance du détecteur 902 est reçu, et pour détecter que le tiroir 138 est en position de fonctionnement lorsque des signaux de détection en provenance des détecteurs 902 et 904 sont reçus simultanément.

Le module de détection de position 900 est particulièrement avantageux, car il permet de fiabiliser le fonctionnement du tiroir 138. En effet, grâce à la détection de la position du tiroir 138 fournie par le module de détection de position 900, la commande des éléments fonctionnels 362 par la carte électronique de contrôle 364 tient compte de la position réelle du tiroir. Le contrôle des éléments fonctionnels 362 est alors amélioré.

En outre, le fonctionnement du module de détection de position 900 est particulièrement fiable, car le module de détection de position est entièrement intégré dans le tiroir 138, et car la position du tiroir est détectée uniquement à partir de la position de l'un des contacts latéraux mobiles 352, en détectant la position de ce contact latéral par rapport à la base 328 du tiroir. En d'autres termes, la détection de la position du tiroir ne nécessite pas d'interaction avec une structure fixe du module de démarrage moteur 200 ou de l'armoire électrique 100 et le module de détection de position 900 est isolé dans le tiroir 138. Cela est particulièrement avantageux, puisque la détection de la position du tiroir 138 est alors insensible à d'éventuelles perturbations dans la position du tiroir 138 par rapport à l'armoire électrique 100 autour de ses positions de test et de fonctionnement, qui pourraient dans le cas contraire perturber les détecteurs 902 et 904. De telles perturbations sont, par exemple, causées par des vibrations ou par des chocs subis par le tiroir.

En variante, la position de fonctionnement est détectée lorsque la carte électronique de contrôle 364 reçoit uniquement un signal de détection en provenance du détecteur 904. Dans une telle variante, la tringle de commande 906 ne comprend pas de deuxième came haute 922, puisque l'actionnement du détecteur 902 en position de fonctionnement n'est pas requis.

En variante, l'orientation des détecteurs 902 et 904 est différente de l'orientation représentée sur les figures 41à 43, et la position des cames hautes 920 et 922 et basse 924 est adaptée en conséquent.

En variante, le module de détection de position 900 ne comprend pas d'organe de rappel élastique 916. Dans une telle variante, le rappel de la tringle de commande 906 vers sa position de repos est assuré par les ressorts de traction 446, qui tendent à ramener le cadre 422, et par conséquent la tringle de commande, en position de repos.

En variante, les détecteurs 902 et 904 sont des interrupteurs à induction, ou des interrupteurs à effet Hall détectant la position des cames hautes 920 et 922 et basse 924.

En variante, le module de détection de position 900 comprend un seul détecteur 902 ou 904 permettant de détecter les positions de test et de fonctionnement.

En variante, le tiroir 138 comprend des contacts mobiles 352 qui sont mobiles uniquement selon l'axe longitudinal A138 du tiroir. Dans une telle variante, les interfaces de communication 353 font par exemple saillie des modules d'entrées-sorties 206 et des unités de protection 140, de sorte à entrer en contact avec les contacts mobiles 352 lorsque le tiroir 138 est en position de test, et à entraîner le déplacement des contacts mobiles par rapport à la base 328 lorsque le tiroir est déplacé de sa position de test vers sa position de fonctionnement. Dans une telle variante, le fonctionnement du module de détection de position 900 est inchangé.

## Revendications

1. Armoire électrique de raccordement (100), l'armoire électrique étant alimentée en énergie électrique par des câbles d'alimentation (102) et étant configurée pour alimenter au moins une charge électrique (104), l'armoire électrique comprenant :
• une colonne d'alimentation (106) ; et
• au moins une colonne de raccordement (110),
les câbles d'alimentation (102) étant raccordés à l'armoire électrique (100) dans la colonne d'alimentation (106),
chaque colonne de raccordement (110) comprenant au moins une unité de contrôle-commande (138) configurée pour permettre le raccordement électrique à une charge électrique (104),
chaque unité de contrôle-commande (138) étant électriquement protégée par une unité de protection (140) appartenant à la colonne de raccordement de cette unité de contrôle-commande,
chaque unité de contrôle-commande (138) étant configurée pour permettre le raccordement et éventuellement le pilotage et/ou la surveillance d'une charge électrique (104),
l'armoire électrique étant configurée pour être commandée par un ordinateur industriel (130),
chaque colonne de raccordement (110) comprenant un module de communication (134) qui :
• centralise des informations de fonctionnement provenant des unités de contrôle-commande (138) de cette colonne de raccordement ;
• est configuré pour transmettre ces informations de fonctionnement à l'ordinateur industriel (130) ;
• est configuré pour recevoir des commandes provenant de l'ordinateur industriel ; et
• transmet ces commandes aux unités de contrôle-commande de cette colonne de raccordement,
**caractérisée en ce qu'**au moins un module de communication (134) comporte un bloc d'alimentation (150) délivrant au moins une tension électrique auxiliaire à chaque colonne de raccordement (110).

2. Armoire électrique (100) selon la revendication 1, **caractérisée en ce que** chaque colonne de raccordement (110) comprend un bus informatique (142) qui relie le module de communication (134) de cette colonne de raccordement à chaque unité de contrôle-commande (138) de cette colonne de raccordement et qui permet l'échange d'informations et de commandes entre le module de communication et chaque unité de contrôle-commande de cette colonne de raccordement.

3. Armoire électrique (100) selon la revendication 2, **caractérisée en ce que** l'échange d'informations et de commandes entre le module de communication (134) d'une colonne de raccordement (110) et chaque unité de contrôle-commande (138) de cette colonne transitent par des circuits électroniques (144) du bus informatique (142) et s'effectue de préférence selon le protocole Ethernet.

4. Armoire électrique (100) selon l'une des revendications 2 à 3, **caractérisée en ce que** le bus informatique (142) de chaque colonne de raccordement (110) comporte des pistes d'alimentation électrique (148, 154) configurées pour alimenter chaque unité de contrôle-commande (138) de cette colonne de raccordement et/ou au moins une charge électrique (104) raccordée à cette colonne de raccordement avec au moins une tension électrique auxiliaire.

5. Armoire électrique (100) selon l'une quelconque des revendications précédentes, **caractérisée en ce que** le bloc d'alimentation (150) délivre une première tension électrique auxiliaire à chaque unité de contrôle-commande (138) de chaque colonne de raccordement (110) et est configurée pour délivrer une deuxième tension électrique auxiliaire à au moins une charge électrique (104) raccordée à une unité de contrôle-commande (138).

6. Armoire électrique (100) selon la revendication 5, **caractérisée en ce que** la première tension électrique auxiliaire est une tension continue de 48V et la deuxième tension électrique auxiliaire est une tension alternative de 230V.

7. Armoire électrique (100) selon l'une quelconque des revendications précédentes, **caractérisée en ce que** :
• la colonne d'alimentation (106) comprend un commutateur central (137) ;
• le commutateur central (137) est raccordé entre l'ordinateur industriel (130) et le module de communication (134) de chaque colonne de raccordement (110), en ce sens que :
∘ le commutateur central (137) est configuré pour recevoir les commandes provenant de l'ordinateur industriel (130) et répartir ces commandes entre les modules de communication (134) de chaque colonne de raccordement ; et
∘ le commutateur central est configuré pour agréger les informations de fonctionnement provenant des modules de communication de chaque colonne de raccordement et transmettre ces informations à l'ordinateur industriel.

8. Armoire électrique (100) selon l'une quelconque des revendications précédentes comprenant au moins deux colonnes de raccordement (110), **caractérisée en ce que** :
• le module de communication (134) de chaque colonne de raccordement (110) comprend un switch managé (135) ;
• les switch managés (135) des modules de communication (134) sont reliés entre eux par des câbles de communication interne (136) ; et
• chaque switch managé est configuré pour être relié à l'ordinateur industriel (130) indépendamment des autres switch managés.

9. Armoire électrique (100) selon l'une quelconque des revendications précédentes, **caractérisée en ce que** l'ensemble des raccordements de câbles aux connecteurs (192, 196, 198, 510, 660, 712) de l'armoire électrique (100) nécessaires pour la mise en service de l'armoire électrique sont réalisés dans une unique zone de raccordement (158).

## Patentansprüche

1. Anschlussschaltschrank (100), wobei der Schaltschrank über Stromkabel (102) mit elektrischer Energie versorgt wird und konfiguriert ist, um mindestens eine elektrische Last (104) mit Strom zu versorgen, der Schaltschrank umfassend:
• eine Versorgungssäule (106); und
• - mindestens eine Anschlusssäule (110),
wobei die Stromkabel (102) in der Stromsäule (106) an den Schaltschrank (100) angeschlossen sind,
jede Anschlusssäule (110) umfassend mindestens eine Steuer- und Regeleinheit (138), die konfiguriert ist, um einen elektrischen Anschluss mit einer elektrischen Last (104) zu ermöglichen,
wobei jede Steuer- und Regeleinheit (138) elektrisch durch eine Schutzeinheit (140) geschützt ist, die zu der Anschlusssäule dieser Steuer- und Regeleinheit gehört,
wobei jede Steuer- und Regeleinheit (138) konfiguriert ist, um den Anschluss und gegebenenfalls die Steuerung und/oder Überwachung einer elektrischen Last (104) zu ermöglichen,
wobei der Schaltschrank konfiguriert ist, um von einem Industriecomputer (130) gesteuert zu werden,
jede Anschlusssäule (110) umfassend ein
Kommunikationsmodul (134), das:
• Betriebsinformationen von den Steuer- und Regeleinheiten (138) dieser Anschlusssäule zentralisiert;
• konfiguriert ist, um diese Betriebsinformationen an den Industriecomputer (130) zu übertragen;
• konfiguriert ist, um Befehle von dem Industriecomputer zu empfangen; und
• diese Befehle an die Steuer- und Regeleinheiten dieser Anschlusssäule zu übertragen,
**dadurch gekennzeichnet, dass** mindestens ein Kommunikationsmodul (134) einen Versorgungsblock
(150) umfasst, der jeder Anschlusssäule (110) mindestens eine elektrische Hilfsspannung zuführt.

2. Schaltschrank (100) nach Anspruch 1, **dadurch gekennzeichnet, dass** jede Anschlusssäule (110) einen Computerbus (142) umfasst, der das Kommunikationsmodul (134) dieser Anschlusssäule mit jeder Steuer- und Regeleinheit (138) dieser Anschlusssäule verbindet und der den Austausch von Informationen und Befehlen zwischen dem Kommunikationsmodul und jeder Steuer- und Regeleinheit dieser Anschlusssäule ermöglicht.

3. Schaltschrank (100) nach Anspruch 2, **dadurch gekennzeichnet, dass** der Austausch von Informationen und Befehlen zwischen dem Kommunikationsmodul (134) einer Anschlusssäule (110) und jeder Einheit der Steuer- und Regeleinheit (138) dieser Säule über elektronische Schaltungen (144) des Computerbusses (142) verläuft und vorzugsweise gemäß dem Ethernet-Protokoll erfolgt.

4. Schaltschrank (100) nach einem der Ansprüche 2 bis 3, **dadurch gekennzeichnet, dass** der Computerbus (142) jeder Anschlusssäule (110) Stromversorgungsbahnen (148, 154) umfasst, die konfiguriert sind, um jede Steuer- und Regeleinheit (138) dieser Anschlusssäule und/oder mindestens eine an diese Anschlusssäule angeschlossene elektrische Last (104) mit mindestens einer elektrischen Hilfsspannung zu versorgen.

5. Schaltschrank (100) nach einem der vorherigen Ansprüche, **dadurch gekennzeichnet, dass**
der Versorgungsblock (150) eine erste
elektrische Hilfsspannung an jede Steuer- und Regeleinheit (138) jeder Anschlusssäule (110) zuführt und konfiguriert ist, um eine zweite elektrische Hilfsspannung an mindestens eine elektrische Last (104) zuzuführen, die an eine Steuer- und Regeleinheit (138) angeschlossen ist.

6. Schaltschrank (100) nach Anspruch 5, **dadurch gekennzeichnet, dass** die erste elektrische Hilfsspannung eine Gleichspannung von 48 V ist und die zweite elektrische Hilfsspannung eine Wechselspannung von 230 V ist.

7. Schaltschrank (100) nach einem der vorhergehenden Ansprüche, **dadurch gekennzeichnet, dass**:
• die Versorgungssäule (106) einen zentralen Schalter (137) umfasst;
• der zentrale Schalter (137) zwischen dem Industriecomputer (130) und dem Kommunikationsmodul (134) jeder Anschlusssäule (110) angeschlossen ist, wobei:
∘ der Zentralschalter (137) konfiguriert ist, um Befehle von dem Industriecomputer (130) zu empfangen und diese Befehle auf die Kommunikationsmodule (134) jeder Anschlusssäule zu verteilen; und
∘ der Zentralschalter konfiguriert ist, um die Betriebsinformationen von den Kommunikationsmodulen jeder Anschlusssäule zu aggregieren und diese Informationen an den Industriecomputer zu übertragen.

8. Schaltschrank (100) nach einem der vorherigen Ansprüche, umfassend mindestens zwei Anschlusssäulen (110), **dadurch gekennzeichnet, dass**:
• das Kommunikationsmodul (134) jeder Anschlusssäule (110) einen gemanagten Switch (135) umfasst;
• die gemanagten Switches (135) der Kommunikationsmodule (134) durch interne Kommunikationskabel (136) miteinander verbunden sind; und
• jeder gemanagte Switch konfiguriert ist, um unabhängig von den anderen gemanagten Switches mit dem Industriecomputer (130) verbunden zu sein.

9. Schaltschrank (100) nach einem der vorhergehenden Ansprüche, **dadurch gekennzeichnet, dass** alle Kabelanschlüsse an die Verbinder (192, 196, 198, 510, 660, 712) des Schaltschranks (100), die für die Inbetriebnahme des Schaltschranks erforderlich sind, in einem einzigen Anschlussbereich (158) realisiert werden.

## Claims

1. Electrical connection enclosure (100), the electrical enclosure being supplied with electrical power by power supply cables (102) and being configured to supply at least one electrical load (104) with power, the electrical enclosure comprising:
• a power supply column (106); and
• at least one connection column (110),
the power supply cables (102) being connected to the electrical enclosure (100) in the power supply column (106),
each connection column (110) comprising at least one monitoring-and-control unit (138) configured to allow the electrical connection to an electrical load (104),
each monitoring-and-control unit (138) being electrically protected by a protection unit (140) belonging to the connection column of this monitoring-and-control unit,
each monitoring-and-control unit (138) being configured to allow the connection and potentially the driving and/or the surveillance of an electrical load (104),
the electrical enclosure being configured to be controlled by an industrial computer (130),
each connection column (110) comprising a communication module (134) which:
• centralizes operating information coming from the monitoring-and-control units (138) of this connection column;
• is configured to transmit this operating information to the industrial computer (130);
• is configured to receive commands coming from the industrial computer; and
• transmits these commands to the monitoring-and-control units of this connection column,
**characterized in that** at least one communication module (134) comprises a power supply block (150) delivering at least one auxiliary voltage to each connection column (110).

2. Electrical enclosure (100) according to Claim 1, **characterized in that** each connection column (110) comprises a computer bus (142) which connects the communication module (134) of this connection column to each monitoring-and-control unit (138) of this connection column and which allows the exchange of information and of commands between the communication module and each monitoring-and-control unit of this connection column.

3. Electrical enclosure (100) according to Claim 2, **characterized in that** the exchange of information and of commands between the communication module (134) of a connection column (110) and each monitoring-and-control unit (138) of this column travels through electronic circuits (144) of the computer bus (142) and preferably takes place using the Ethernet protocol.

4. Electrical enclosure (100) according to either one of Claims 2 and 3, **characterized in that** the computer bus (142) of each connection column (110) comprises electrical power supply tracks (148, 154) configured to supply each monitoring-and-control unit (138) of this connection column and/or at least one electrical load (104) connected to this connection column with at least one auxiliary voltage.

5. Electrical enclosure (100) according to any one of the preceding claims, **characterized in that** the power supply block (150) delivers a first auxiliary voltage to each monitoring-and-control unit (138) of each connection column (110) and is configured to deliver a second auxiliary voltage to at least one electrical load (104) connected to a monitoring-and-control unit (138).

6. Electrical enclosure (100) according to Claim 5, **characterized in that** the first auxiliary voltage is a DC voltage of 48 V and the second auxiliary voltage is an AC voltage of 230 V.

7. Electrical enclosure (100) according to any one of the preceding claims, **characterized in that**:
• the power supply column (106) comprises a central switch (137);
• the central switch (137) is connected between the industrial computer (130) and the communication module (134) of each connection column (110) **in that**:
∘ the central switch (137) is configured to receive the commands coming from the industrial computer (130) and to distribute these commands between the communication modules (134) of each connection column; and
∘ the central switch is configured to aggregate the operating information coming from the communication modules of each connection column and to transmit this information to the industrial computer.

8. Electrical enclosure (100) according to any one of the preceding claims comprising at least two connection columns (110), **characterized in that**:
• the communication module (134) of each connection column (110) comprises a managed switch (135);
• the managed switches (135) of the communication modules (134) are connected to one another by internal communication cables (136); and
• each managed switch is configured to be connected to the industrial computer (130) independently of the other managed switches.

9. Electrical enclosure (100) according to any one of the preceding claims, **characterized in that** all of the connections of cables to the connectors (192, 196, 198, 510, 660, 712) of the electrical enclosure (100) which are required for commissioning the electrical enclosure are made in a single connection region (158).
